(19) Europäisches Patentamt

European Patent Office

Office européen des brevets

(11) **EP 1 720 197 A1**

(12) **EUROPEAN PATENT APPLICATION**

(43) Date of publication:
**08.11.2006 Bulletin 2006/45**

(51) Int Cl.:
*H01J 37/32* (2006.01)     *C23C 16/509* (2006.01)
*C23C 16/52* (2006.01)

(21) Application number: **06016997.6**

(22) Date of filing: **10.07.2001**

(84) Designated Contracting States:
**DE FR GB IT**

(30) Priority: **11.08.2000 JP 2000245347**
**22.09.2000 JP 2000289488**

(62) Document number(s) of the earlier application(s) in
accordance with Art. 76 EPC:
**01305941.5 / 1 179 834**

(71) Applicants:
• **ALPS ELECTRIC CO., LTD.**
**Ota-ku**
**Tokyo 145 (JP)**
• **OHMI, Tadahiro**
**Aoba-ku,**
**Sendai-shi,**
**Miyagi 980 (JP)**

(72) Inventors:
• **Ohmi, Tadahiro**
**Sendai-shi**
**Miyagi-ken**
**Miyagi (JP)**
• **Nakano, Akira**
**Ota-ku**
**Tokyo 145-8501 (JP)**

(74) Representative: **Kensett, John Hinton**
**Saunders & Dolleymore,**
**9 Rickmansworth Road**
**Watford,**
**Hertfordshire WD18 0JU (GB)**

Remarks:
This application was filed on 16 - 08 - 2006 as a
divisional application to the application mentioned
under INID code 62.

(54) **Plasma processing apparatus and performance validation system therefore**

(57) A plasma processing apparatus includes a plasma processing chamber (CN) having a plasma excitation electrode (4) for exciting a plasma, a radiofrequency generator (1) for supplying a radiofrequency voltage to the electrode, a radiofrequency feeder (3) connected to the electrode, and a matching circuit (2A) having an input end (PR3) and an output end (PR). The input end is connected to the radiofrequency generator and the output end is connected to an end of the radiofrequency feeder so as to achieve impedance matching between the plasma processing chamber and the radiofrequency generator. A frequency which is three times a first series resonant frequency $f_0$ of the plasma processing chamber which is measured at the end of the radiofrequency feeder is larger than a power frequency $f_e$ of the radiofrequency waves.

FIG. 1

EP 1 720 197 A1

**Description**

BACKGROUND OF THE INVENTION

1. Field of the Invention

The present invention relates to a plasma processing apparatus and a performance validation system of the plasma processing apparatus, which use radiofrequency voltage to improve the power consumption efficiency and the coating characteristics.

2. Description of the Related Art

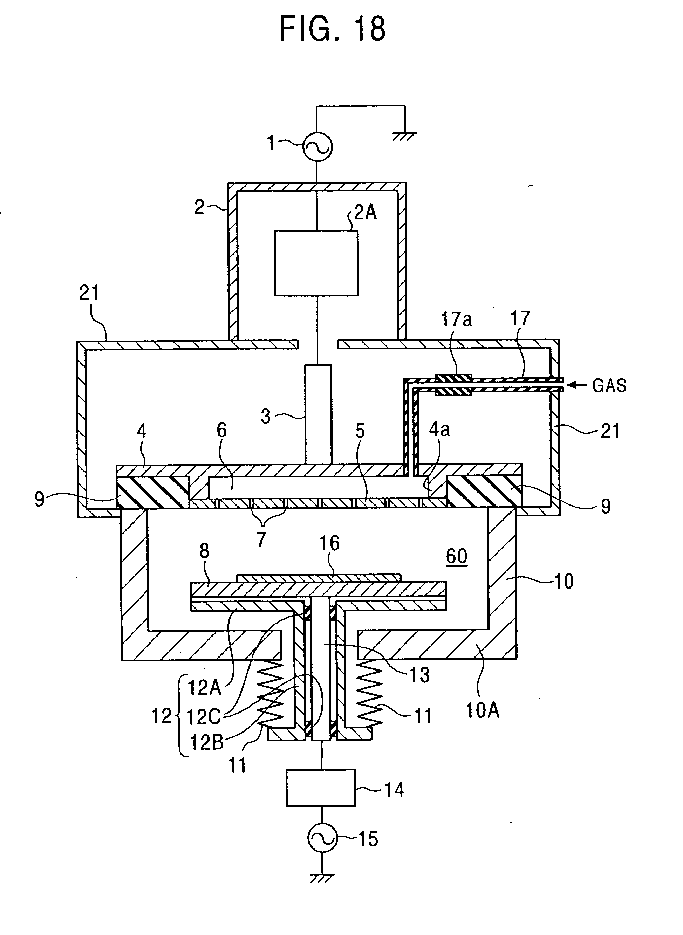

Fig. 18 illustrates an example of a conventional dual-frequency excitation plasma processing apparatus which performs a plasma process such as chemical vapor deposition (CVD), sputtering, dry etching, ashing, or the like.

In the plasma processing apparatus shown in Fig. 18, a matching circuit 2A is inserted between a radiofrequency generator 1 and a plasma excitation electrode 4. The matching circuit 2A serves as a circuit that matches the impedance between the radiofrequency generator 1 and the excitation electrode 4.

Radiofrequency voltage from the radiofrequency generator 1 is fed to the plasma excitation electrode 4 via the matching circuit 2A and a feed plate 3. The matching circuit 2A is accommodated in a matching box 2 which is a housing composed of a conductive material. The plasma excitation electrode 4 and the feed plate 3 are covered by a chassis 21 made of a conductor.

The plasma excitation electrode 4 is provided with a projection 4a at the lower side thereof. A shower plate 5 having a number of holes 7 provided under the plasma excitation electrode 4 is in contact with the projection 4a. The plasma excitation electrode 4 and the shower plate 5 define a space 6. A gas feeding tube 17 comprising a conductor is connected to the space 6. The gas feeding tube 17 is provided with an insulator 17a at the middle thereof so as to insulate the plasma excitation electrode 4 and the gas source.

Gas flowing from the gas feeding tube 17 is fed inside a chamber space 60 composed of a chamber wall 10, via the holes 7 in the shower plate 5. An insulator 9 is disposed between the chamber wall 10 and the plasma excitation electrode 4 (cathode) to provide insulation therebetween. The exhaust system is omitted from the drawing.

A wafer susceptor (susceptor electrode) 8 which receives a substrate 16 and also serves as a plasma excitation electrode is installed inside the chamber space 60. A susceptor shield 12 is disposed under the wafer susceptor 8.

The susceptor shield 12 comprises a shield supporting plate 12A for receiving the susceptor electrode 8 and a cylindrical supporting tube 12B extending downward from the center of the shield supporting plate 12A. The supporting tube 12B penetrates a chamber bottom 10A, and the lower portion of the supporting tube 12B and the chamber bottom 10A are hermetically sealed with bellows 11.

The shaft 13 and the susceptor electrode 8 are electrically isolated from the susceptor shield 12 by a gap between the susceptor shield 12 and the susceptor electrode 8 and by insulators 12C provided around the shaft 13. The insulators 12C also serve to maintain high vacuum in the chamber space 60. The susceptor electrode 8 and the susceptor shield 12 can be moved upward and downward by the bellows 11 in order to control the distance between plasma excitation electrodes 4 and 8.

The susceptor electrode 8 is connected to a second radiofrequency generator 15 via the shaft 13 and a matching circuit accommodated in a matching box 14. The chamber wall 10 and the susceptor shield 12 have equal DC potentials.

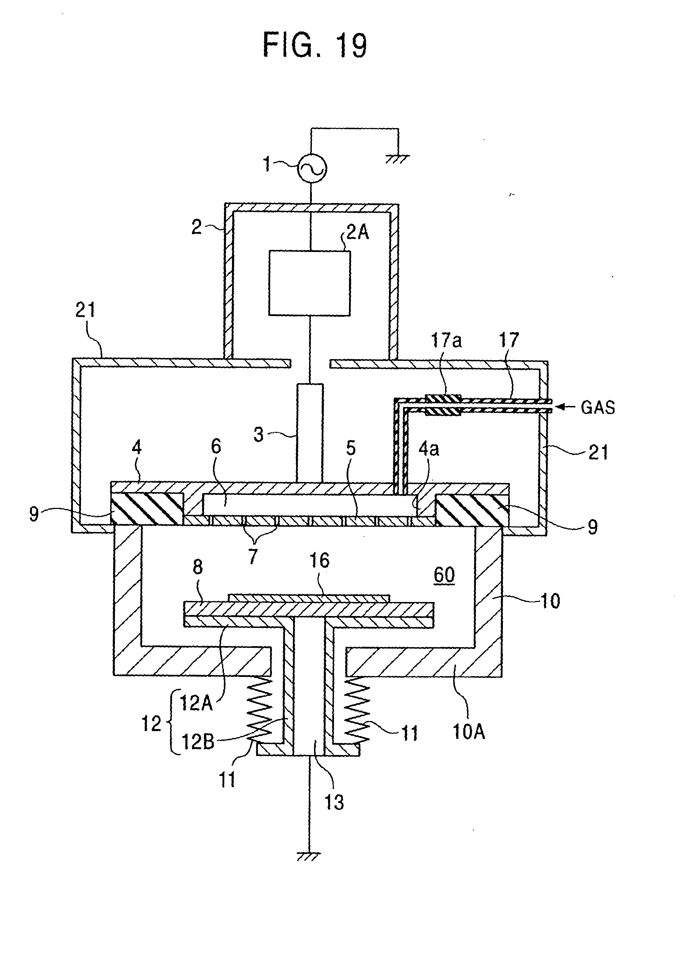

Fig. 19 illustrates another example of a conventional plasma processing apparatus. Unlike the plasma processing apparatus shown in Fig. 18, the plasma processing apparatus shown in Fig. 19 is of a single-frequency excitation type. In other words, a radiofrequency voltage is supplied only to the cathode electrode 4 and the susceptor electrode 8 is grounded. Moreover, the matching box 14 and the radiofrequency generator 15 shown in Fig. 18 are not provided. The susceptor electrode 8 and the chamber wall 10 have equal DC potentials.

In these plasma processing apparatuses, a voltage with a frequency of approximately 13.56 MHz is generally supplied in order to generate a plasma between the electrodes 4 and 8. A plasma process such as CVD, sputtering, dry etching, ashing, or the like is then performed using the plasma.

However, in the above-described plasma processing apparatuses, the power consumption efficiency, i.e., the ratio of the power fed into the plasma excitation electrode 4 from the radiofrequency generator 1 to the power consumed in the plasma, is not necessarily satisfactory. Moreover, the higher the frequency of the voltage fed from the radiofrequency generator, the more significant the decrease in the powder consumption efficiency of the plasma processing apparatus would be. The powder consumption efficiency is also decreased when the size of the substrate is increased.

As a consequence of low power consumption efficiency, the density of the generated plasma cannot be increased and the rate of deposition is low. Moreover, for example, in the case of depositing insulating layers, it is difficult to deposit a layer having a high isolation voltage.

The operation validation and the evaluation of the above-described plasma processing apparatuses have been conducted by actually performing the process such as deposition and then evaluating the deposition characteristics thereof as follows.

(1) Deposition rates and planar uniformity

The process of determining and evaluating deposition rates and planar uniformity includes the following.

Step 1: Depositing a desired layer on a substrate by a plasma-enhanced CVD process.
Step 2: Patterning a resist layer.
Step 3: Dry-etching the layer.
Step 4: Separating the resist layer by ashing.
Step 5: Measuring step differences in the layer thickness using a displacement meter.
Step 6: Calculating deposition rates from the deposition time and the layer thickness.
Step 7: Measuring the planar uniformity at 16 points on a 6-inch substrate surface.

(2) BHF etching rate

The process of determining etching rates includes the following.
A resist mask is patterned as in Steps 1 and 2 above.

Step 3: Immersing the substrate in a BHF solution for one minute.
Step 4: Rinsing the substrate with deionized water, drying the substrate, and separating the resist mask using a mixture of sulfuric acid and hydrogen peroxide ($H_2SO_4 + H_2O_2$).
Step 5: Measuring the step difference as in Step 5 above.
Step 6: Calculating the etching rate from the immersion time and the step differences.

(3) Isolation voltage

The process of determining and evaluating the isolation voltage includes the following.

Step 1: Depositing a conductive layer on a glass substrate by a sputtering method and patterning the conductive layer to form a lower electrode.
Step 2: Depositing an insulation layer by a plasma-enhanced CVD method.
Step 3: Forming an upper electrode as in Step 1.
Step 4: Forming a contact hole for the lower electrode.
Step 5: Measuring the current-voltage characteristics (I-V characteristics) of the upper and lower electrodes by using probes while applying a voltage of approximately 200 V or less.
Step 6: defining the isolation voltage as the voltage V at 100 pA corresponding 1 $\mu$A/cm$^2$ in a 100 $\mu$m square electrode.

The plasma processing apparatus has been required to achieve a higher plasma processing rate (the deposition rate or the processing speed), increased productivity, and uniformity of the plasma processing in the planar direction of the substrates to be treated (uniformity in the distribution of the layer thickness in the planar direction and uniformity in the distribution of the process variation in the planar direction). As the size of substrates has been increasing in recent years, the requirement for uniformity in the planar direction is becoming more severe.
Moreover, as the size of the substrate is increased, the power delivered is also increased to the order or kilowatts, thus increasing the power consumption. Accordingly, as the capacity of the power supply increases, both the cost for developing the power supply and the power consumption during the operation of the apparatus are increased. In this respect, it is desirable to reduce the operation costs.
Furthermore, an increase in power consumption leads to an increase in emission of carbon dioxide which places a burden on the environment. Since the power consumption is increased by the combination of increase in the size of substrates and a low power consumption efficiency, there is a growing demand to reduce the carbon dioxide emission.
The density of the plasma generated can be improved by increasing the plasma excitation frequency. For example, a frequency in the VHF band of 30 MHz or more can be used instead of the conventional 13.56 MHz. Thus, one possible way to improve the deposition rate of a deposition apparatus such as a plasma-enhanced CVD apparatus is to employ a high plasma excitation frequency.
Another type of plasma processing apparatus is one having a plurality of plasma chambers. Such a plasma processing apparatus is also required to achieve a higher plasma processing rate (the deposition rate or the processing speed), increased productivity, and uniformity of the plasma processing in the planar direction of the substrates (uniformity in the distribution of the layer thickness in the planar direction and uniformity in the distribution of the process variation in the planar direction), even when the substrates are treated in different plasma chambers. There is also a demand to eliminate operational differences among the plurality of the plasma chambers, thus avoiding processing variations.

Moreover, the respective plasma chambers of the plasma processing apparatus having plural plasma chambers are required to achieve substantially the same plasma processing results by using the same process recipe specifying external parameters such as the flow/pressure of the gas supplied, power supply, and treatment time.

At the time of initial installation or maintenance of the plasma processing apparatus, there is a demand to reduce the amount of time required for adjusting the apparatus to eliminate differences among the plural plasma chambers and processing variations, thereby achieving substantially the same process results using the same process recipe. Reduction of the cost required for such an adjustment is also required.

Furthermore, a plasma processing system equipped with a plurality of the above-described plasma processing apparatuses is also required to eliminate plasma processing variations among individual plasma chambers of the individual plasma processing apparatuses.

The conventional plasma processing apparatus described above is, however, designed to use a power having a frequency of approximately 13.56 MHz and is not suited for higher frequencies. To be more specific, the units to which the radiofrequency voltage is delivered, i.e., the chambers in which plasma processing is carried out, are designed without taking into an account radiofrequency characteristics such as impedance and resonance frequency characteristics and thus have the following problems.

First, when a power having a frequency exceeding 13.56 MHz is delivered, no improvement is achieved in the deposition rate during the deposition process, but rather the deposition rate is decreased in some cases.

Second, although the density of a generated plasma increases as the frequency increases, the density starts to decrease once its peak value is reached, eventually reaching a level at which glow-discharge is no longer possible, thus rendering further increases in frequency pointless.

In order to carry out the performance validation and performance diagnosis of this plasma processing apparatus employing processes (1) to (3) described above, the apparatus must actually be operated so as to confirm the validity of the operations. Furthermore, the treated substrates are required to undergo ex-situ inspection comprising a plurality of steps.

Since such an inspection requires several days to several weeks to yield evaluation results, it is desired that the time required for performance inspection of a plasma processing apparatus be reduced especially when the apparatus is in the development stage.

The radiofrequency electrical characteristics of each of the chambers of a plasma processing apparatus or a plasma processing system are defined by its shape, that is, by the mechanical dimensions. However, the dimensions of each of the components constituting each plasma chamber vary due to the mechanical tolerance during the manufacturing process. When such components are assembled to make a plasma chamber, the plasma chamber has variations due to both the mechanical tolerance and the assembly tolerance. No method for determining whether the overall plasma chamber has the designed radiofrequency electrical characteristics has been available since some portions are not measurable after assembly of the components. Thus, there has been no effective means for examining differences in radiofrequency electrical characteristics among the plasma chambers.

As a consequence, the following problems have arisen.

A plasma processing apparatus and a plasma processing system, both comprising a plurality of plasma chambers, are not designed to eliminate the differences in radiofrequency electrical characteristics such as impedance and resonant frequency characteristics among the plasma chambers. Thus, it is possible that the effective power consumed in each of plasma spaces and the density of the generated plasma differ between each of the plasma chambers.

Also, the same plasma processing results may not be obtained even when the same process recipe is applied to these plasma chambers.

Accordingly, in order to obtain the same plasma processing results, external parameters such as gas flow/pressure, power supply, process time, and the like must be compared with the process results according to evaluation methods (1) to (3) described above for each of the plasma chambers so as to determine the correlation between them. However, the amount of data is enormous and it is impossible to completely carry out the comparison.

When the inspection methods such as (1) to (3) described above are employed to validate and evaluate the operation of the plasma processing apparatus, it becomes necessary to actually operate the plasma processing apparatus and to examine the treated substrates using an ex-situ inspection method comprising a plurality of steps.

Such an examination takes several days to several weeks to yield evaluation results, and the characteristics of the substrates manufactured during that period, assuming that the manufacturing line is not stopped, remain unknown during that period. If the status of the plasma processing apparatus is not satisfactory, the resulting products will not meet predetermined standards. In this respect, a method that facilitates maintenance of the plasma processing apparatus has been demanded.

Moreover, when the inspection methods such as (1) to (3) described above are employed to inspect the plasma processing apparatus or system having a plurality of plasma chambers, plural plasma chambers must be adjusted so as to eliminate the differences between chambers and processing variations and to obtain the same processing result using the same process recipe at the time of initial installation or maintenance/inspection of the apparatus. The time required for such adjustment may be months. Thus, it has been demanded that the time required for such adjustment be reduced. Also, the cost of substrates for inspection, the cost of processing the substrates for inspection, the labor cost for workers involved with the adjustment, and so forth are significantly high.

SUMMARY OF THE INVENTION

Accordingly, the objects of the present invention are as follows.

A first object of the present invention is to improve the processing speed, e.g., deposition rate when the present invention is applied to a deposition apparatus, by increasing the frequency of the plasma-exciting frequency.

A second object of the present invention is to improve the uniformity of the plasma process in the planar direction of the treated substrate, e.g., improving the thickness distribution in the planar direction and processing distribution in the planar direction.

A third object of the present invention, when applied to a plasma-enhanced CVD apparatus or a sputtering apparatus, is to improve the layer characteristics of the deposited layer such as isolation voltage and the like.

A fourth object of the present invention is to reduce the electricity loss by improving the power consumption efficiency so that the same layer characteristics can be achieved with reduced power.

A fifth object of the present invention is to reduce the operating cost and improve the production efficiency.

A sixth object of the present invention is to provide a reference for determining the validity of the plasma chamber operation other than that determined by examining the treated substrate.

A seventh object of the present invention is to provide a plasma processing apparatus having a plurality of plasma chambers, the plasma chambers having a uniform radiofrequency electrical characteristics such as resonant frequency characteristics.

An eighth object of the present invention is to provide a plasma processing apparatus having a plurality of plasma chambers capable of achieving a uniform plasma processing result by using the same process recipe.

A ninth object of the present invention is to dispense with an examination of a vast amount of data regarding the plasma chambers and a comparison of the results of the inspections such as (1) to (3) described above with the external parameters.

A tenth object of the present invention is to reduce the time required to adjust the plasma chambers so that the plasma chambers achieve substantially the same process results by using the same process recipe.

An eleventh object of the present invention is to provide a plasma processing apparatus or system which can be easily maintained.

To accomplish the above-described objets, an aspect of the present invention provides a plasma processing apparatus having a plasma processing chamber having a plasma excitation electrode for exciting a plasma, a radio frequency generator for supplying a radiofrequency voltage to the electrode, a radiofrequency feeder connected to the electrode, and a matching circuit having an input end and an output end. The input end of the matching circuit is connected to the radiofrequency generator and the output end of the same is connected to an end of the radio frequency feeder to perform impedance matching between the plasma processing chamber and the radiofrequency generator. Herein, a first series resonant frequency $f_0$ measured at the end of the radio frequency feeder is so set that three times the first series resonant frequency $f_0$ is larger than a power frequency $f_e$ of the radiofrequency voltage.

By so setting the first series resonant frequency $f_0$ that three times the first series resonant frequency $f_0$ is larger than the power frequency $f_e$, power can be efficiently supplied to the plasma generating space even when the power having a frequency higher than approximately 13.56 MHz, the frequency conventionally used, is used. Moreover, when the same frequency as in the conventional process is supplied, the effective power consumed in the plasma space can be increased. As a result, the deposition rate, when the invention is applied to a deposition apparatus, can be improved.

Since the first series resonant frequency $f_0$ is mainly determined by the factors relating to the mechanical structure thereof, the first series resonant frequency $f_0$ differs according to specific apparatuses. By setting the first series resonant frequency $f_0$ to the above-described range, it becomes possible to provide each of the apparatuses with predetermined overall radiofrequency electrical characteristics and to achieve stable plasma generation. As a consequence, a plasma processing apparatus with an improved operational stability can be provided.

The first series resonant frequency $f_0$ is defined as follows.

First, the dependency of the impedance of the plasma processing chamber on the frequency is examined. More specifically, the region of the plasma chamber in which measurements are taken is defined as described below, and the vector quantity (Z, θ) of the impedance in the thus-defined measured region is measured while varying the measuring voltage in such a range that the power frequency $f_e$ is included. Considering that the power frequency $f_e$ is expected to be set to 13.56 MHz, 27.12 MHz, 40.68 MHz, or the like, the measuring frequency is varied over the range of 1 MHz to 100 MHz, for example. Next, an impedance characteristic curve and a phase curve are drawn by plotting the impedance Z and the phase $\theta$ versus the measuring frequency. Among the frequencies assigned to the minima of the impedance Z, the least significant frequency is defined as the first series resonant frequency $f_0$.

Next, the region of the plasma chamber in which the impedance measurement is taken will be described.

The plasma chamber is connected to the radiofrequency generator via the matching circuit. The measured region starts from the output end position of the matching circuit and extends toward the output side of the plasma chamber.

More particularly, since most of the matching circuits are provided with a plurality of passive elements so that the impedance adjustment can be carried out according to the change in the plasma state inside the plasma chamber, the matching circuit is disconnected from the plasma processing chamber at the output end position of the passive element disposed at the last output stage in the matching circuit during the measurement, and the measured region starts from that output end position.

Preferably, the first series resonant frequency $f_0$ is so set that 1.3 times the first series resonant frequency $f_0$ is larger than the power frequency $f_e$. In this manner, the density of the generated plasma can be further increased, and the processing rate can thus be further improved. The deposition rate can be improved when applied to a deposition apparatus. Because the density of the generated plasma is increased, it become possible to improve the characteristics of the deposited layer, for example, the isolation voltage of the deposited layer can be improved. The increase in plasma density also results in improvements in the uniformity of the deposited layer in the planar direction. Thus, variation in the layer planar characteristics such as layer thickness and isolation voltage can be avoided.

More preferably, the first series resonant frequency $f_0$ is set to be larger than three times the power frequency $f_e$. In this manner, it becomes possible to reduce the power required to achieve the same processing rate, the planar uniformity of the layer, and the layer characteristics as conventionally achieved can be reduced, saving energy and reducing operation costs. When applied to a deposition apparatus, the deposition rate, the uniformity in layer thickness, and the isolation voltage can be improved.

Yet more preferably, a series resonant frequency $f_0$' defined by the capacitance between the above-described plasma excitation electrode and a counter electrode which works in cooperation with the plasma excitation electrode to generate a plasma may also be used. In such a case, the series resonant frequency $f_0$' is set to be larger than three times the power frequency $f_e$. In this manner, the frequency characteristics of the capacitance between the above-described electrodes which generate a plasma can be directly defined, power can be more efficiently supplied to the plasma emission space, and further improvements in power consumption efficiency and in processing efficiency can be achieved.

The plasma excitation electrode and the counter electrode may be of a parallel plate type. Herein, the series resonant frequency $f_0$' and the power frequency $f_e$ may satisfy the relationship

$$f_0' > \sqrt{\frac{d}{\delta}}\, f_e \qquad (1)$$

wherein D represents the distance between the plasma excitation electrode and the counter electrode, and $\delta$ represents the sum of the distance between the plasma excitation electrode and the generated plasma and the distance between the counter electrode and the generated plasma.

A model capacitance between the electrodes during plasma emission can be obtained from the sum $\delta$ of the distances of the portions of the space between electrodes not emitting plasma. Then, the frequency characteristics defined from this model capacitance are set in relation to the frequency characteristics defined from the capacitance between electrodes not emitting plasma which is determined by the interelectrode distance d.

The distance between the parallel-plate-type electrodes can be considered as $\delta$ because the generated plasma between the electrodes can be considered as a conductor. As a result, the apparent capacitance between the electrodes is $d/\delta$ times the capacitance $C_0$ which is the capacitance when plasma is not emitted. Since the first series resonant frequency $f_0$ is proportional to the reciprocal of the square root of the capacitance $C_0$, the series resonant frequency during the plasma emission is proportional to the reciprocal of the square root of $d/\delta$. Thus, when the value of the first series resonant frequency $f_0$ times the reciprocal of the square root of $d/\delta$ is set to be larger than the power frequency $f_e$, the first series resonant frequency between the electrodes during plasma emission can be set in relation to the power frequency $f_e$, and the power consumption efficiency during plasma emission can be improved.

A resonant frequency measuring terminal for measuring the resonant frequency of the plasma processing chamber may be provided in the vicinity of the end of the radiofrequency feeder. It becomes possible to easily measure, using probes, the impedance characteristics and to define the resonant frequency characteristics of the plasma chamber without having have to mechanically detach the matching circuit from the conductor for power supply. Thus, the operation efficiency of the measurement of the first series resonant frequency $f_0$ can be improved.

The plasma processing apparatus further includes a switch provided between the radiofrequency feeder and the resonant frequency measuring terminal. The switch electrically disconnects the end of the radiofrequency feeder from the resonant frequency measuring terminal and connects the end of the radiofrequency feeder to the output end of the matching circuit during plasma excitation. Hereinafter, such a state of the plasma processing apparatus is referred to as being in "a plasma excitation mode". The switch electrically connects the end of the radiofrequency feeder to the resonant frequency measuring terminal and disconnects the end of the radiofrequency feeder from the resonant frequency measuring terminal during measurement of the resonant frequency. Hereinafter, such a state of the plasma processing apparatus is referred to as being in "a measuring mode". Because the matching circuit connected in parallel to the plasma chamber to be measured, as viewed from the impedance measuring terminal, can be detached using the switch, it becomes unnecessary to mechanically detach/attach the conductor for power supply from the matching circuit. Thus, the impedance characteristics of the plasma chamber can be measured with ease, and the measurement of the first series resonant frequency $f_0$ can be performed with an improved accuracy.

The plasma processing apparatus may include a measuring unit which is detachably connected to the resonant frequency measuring terminal. The impedance meter can escape electrical influence acting during plasma emission by detaching the impedance measuring terminal and the impedance meter from the plasma chamber or by operating the switch. When a plurality of plasma chambers are provided, one impedance meter may perform the measurement of these plasma chambers. Thus, the impedance characteristics, measurement of the resonant frequency characteristics, and measurement of the first series resonant frequency $f_0$ can be easily carried out simply by operating the switch, without having have to detach the matching circuit from the plasma chamber (plasma processing room) and detach the probes of the impedance meter from the impedance measuring terminal.

The resonant frequency characteristic in the plasma excitation mode and the resonant frequency characteristic in the measuring mode may be set to be equal to each other. In this manner, neither correction nor reduction is necessary to obtain the actual value of the first series resonant frequency $f_0$. Thus, the efficiency of operation can be improved.

In this invention, the plasma processing apparatus may be of dual-frequency excitation type having a first radiofrequency generator, a radiofrequency electrode coupled to the first radiofrequency generator, a radiofrequency-electrode-side matching box including a matching circuit for performing impedance matching between the first radiofrequency generator and the radiofrequency electrode, a second radiofrequency generator, a susceptor electrode, which is connected to the second radiofrequency generator and disposed to oppose the radiofrequency electrode, for supporting a substrate to be treated, and a susceptor-electrode-side matching box including a matching circuit for performing impedance matching between the second radiofrequency generator and the susceptor electrode. In such a case, the above-described settings can be applied to the power frequency of the second radiofrequency generator and the first series resonant frequency $f_0$ measured from the output end of the susceptor-electrode-side matching circuit.

An another aspect of the present invention provides a performance validation system for the above-described plasma processing apparatus. The system includes at least one client terminal and performance information providing means for providing performance information to the at least one client terminal. The performance information includes standard operation information regarding general information of the plasma processing apparatus and operation and maintenance information regarding specific information of the plasma processing apparatus. The client terminal has at least one function of requesting the display of performance information and uploading the operation and maintenance information to the performance information providing means. In this manner, it is possible to provide the customer who is considering purchasing of the new apparatus with reference information which would help the customer to make decisions. Also, it is possible to easily provide the customer who purchased the apparatus with information regarding the operating state and maintenance state of the purchased apparatus.

Preferably, the standard performance information and the operation and maintenance information include information regarding a first series resonant frequency $f_0$. When the above-described performance information includes the information regarding the first series resonant frequency $f_0$ which serves as one of parameters of the plasma processing apparatus, it is possible to provide the customer with the information which allows the customer to examine the performance of the purchased plasma processing apparatus and the information which allows the customer considering purchasing the apparatus with the reference information which would help the customer making the decisions.

The above-described standard performance information may be used as catalog or a specification statement when output through the client terminal.

According to another aspect of the present invention, a plasma processing apparatus comprises a plurality of plasma processing chamber units, each plasma processing chamber unit comprising a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator and the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is at the end of the corresponding radiofrequency feeder connected to the output terminal of the corresponding matching circuit.

According to another aspect of the present invention, a plasma processing apparatus comprises a plurality of plasma processing chamber units, each plasma processing chamber unit comprising a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is the radiofrequency-generator-side end of the radiofrequency feed line connected to the respective radiofrequency generator.

According to another aspect of the present invention, a plasma processing apparatus comprises a plurality of plasma processing chamber units, each plasma processing chamber unit comprising a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is the input terminal connected to the corresponding radiofrequency feed line.

In these aspects, the predetermined value is preferably less than 0.1 and more preferably less than 0.03.

Each radiofrequency characteristic A may be any one of a resonant frequency f, an impedance $Z_e$ at the frequency of the radiofrequency generator, a resistance $R_e$ at the frequency of the radiofrequency generator, and a reactance $X_e$ at the frequency of the radiofrequency generator. Alternatively, each radiofrequency characteristic A may be a first series resonant frequency $f_0$.

Preferably, three times the first series resonant frequency $f_0$ corresponding to each plasma processing chamber is larger than the frequency $f_e$ of the radiofrequency waves.

Preferably, each plasma processing chamber has a measuring terminal for measuring the radiofrequency characteristic A thereof at the corresponding measuring point.

Each plasma processing chamber may have a switch in the vicinity of the corresponding measuring point in which the switch electrically disconnects the measuring point from the measuring terminal and connects the radiofrequency feeder to the radiofrequency generator in a plasma excitation mode in which the plasma is excited, whereas the switch electrically connects the measuring point to the measuring terminal and disconnects the radiofrequency generator from the measuring point in a measuring mode in which the radiofrequency characteristic A of the corresponding plasma processing chamber is measured.

The radiofrequency characteristic A measured at the output end of the matching circuit in the excitation mode in which the switch electrically disconnects the radiofrequency feeder terminal from the measuring terminal and connects the radiofrequency feeder terminal to the output end of the matching circuit can be equalized to the radiofrequency characteristic A measured at the measuring terminal in the measuring mode in which the switch electrically connects the radiofrequency feeder terminal to the measuring terminal and disconnects the radiofrequency feeder terminal from the output end of the matching circuit.

According to another aspect of the present invention, a plasma processing system comprises a plurality of plasma processing apparatuses, each plasma processing apparatus comprising a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output end, wherein the input terminal is connected to the radiofrequency generator via the radiofrequency feeder, whereas the output end is connected to the radiofrequency feeder so as to achieve impedance matching between the plasma processing chamber and the radiofrequency generator, wherein a variation,

defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristic A thereof is measured at a measuring point which is the radiofrequency-generator-side end of the radiofrequency feed line connected to the respective radiofrequency generator.

According to another aspect of the present invention, a plasma processing system comprises a plurality of plasma processing apparatuses, each plasma processing apparatus comprising a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristic A thereof is measured at a measuring point which is the radiofrequency-generator-side end of the radiofrequency feed line connected to the respective radiofrequency generator.

According to another aspect of the present invention, a plasma processing system comprises a plurality of plasma processing apparatuses, each plasma processing apparatus comprising a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristic A thereof is measured at a measuring point which is the input terminal connected to the corresponding radiofrequency feed line.

As described above, a resonant frequency measuring unit can be connected to the measuring terminal of each plasma processing chamber by a switching operation.

In the present invention, the radiofrequency characteristic A between the measuring point and the resonant frequency measuring unit connected to the measuring terminal can be equalized among these plasma processing chambers.

The radiofrequency characteristic A measured at the output end of the matching circuit in the excitation mode in which the switch electrically disconnects the radiofrequency feeder terminal from the measuring terminal and connects the radiofrequency feeder terminal to the output end of the matching circuit can be equalized to the radiofrequency characteristic A measured at the measuring terminal in the measuring mode in which the switch electrically connects the radiofrequency feeder terminal to the measuring terminal and disconnects the radiofrequency feeder terminal from the output end of the matching circuit.

According to another aspect of the present invention, in a performance validation system for a plasma processing apparatus or system, the system comprises at least one client terminal, and performance information providing means for providing performance information to the client terminal. The performance information comprises standard operation information regarding general information of the plasma processing apparatus and operation and maintenance information regarding specific information of the plasma processing apparatus. The client terminal has at least one function of requesting the display of performance information and uploading the operation and maintenance information to the performance information providing means.

The standard performance information and the operation and maintenance information may comprise information regarding a first series resonant frequency $f_0$.

Moreover, the standard performance information may be used as a catalog or a specification document.

According to another aspect of the present invention, in an inspection method of a plasma processing apparatus comprising a plurality of plasma processing chamber units, each plasma processing chamber unit comprises a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator and the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is at the end of the corresponding radiofrequency feeder connected to the output terminal of the corresponding matching circuit.

According to another aspect of the present invention, in an inspection method of a plasma processing apparatus comprising a plurality of plasma processing chamber units, each plasma processing chamber unit comprises a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is the radiofrequency-generator-side end of the radiofrequency feed line connected to the respective radiofrequency generator.

According to another aspect of the present invention, in an inspection method of a plasma processing apparatus comprising a plurality of plasma processing chamber units, each plasma processing chamber unit comprises a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is the input terminal connected to the corresponding radiofrequency feed line.

According to another aspect of the present invention, in an inspection method of a plasma processing system comprising a plurality of plasma processing apparatuses, each plasma processing apparatus comprises a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator and the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristic A thereof is measured at a measuring point which is at the end of the corresponding radiofrequency feeder connected to the output terminal of the corresponding matching circuit.

According to another aspect of the present invention, in an inspection method of a plasma processing system comprising a plurality of plasma processing apparatuses, each plasma processing apparatus comprises a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristic A thereof is measured at a measuring point which is the radiofrequency-generator-side end of the radiofrequency feed line connected to the respective radiofrequency generator.

According to another aspect of the present invention, in an inspection method of a plasma processing system comprising a plurality of plasma processing apparatuses, each plasma processing apparatus comprises a plasma processing chamber having a plasma excitation electrode for exciting a plasma, a radiofrequency generator for supplying a radiofrequency voltage to the plasma excitation electrode, a radiofrequency feeder connected to the plasma excitation electrode, and a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator, wherein a variation, defined by $(A_{max} - A_{min})/(A_{max} + A_{min})$, between the maximum frequency $A_{max}$ and the

minimum frequency $A_{min}$ among radiofrequency characteristics A of the plurality of plasma processing chambers has a predetermined value, wherein, in each plasma processing chamber, the radiofrequency characteristic A thereof is measured at a measuring point which is the input terminal connected to the corresponding radiofrequency feed line.

In the present invention, the variation between the maximum frequency $A_{max}$ and the minimum frequency $A_{min}$ among radiofrequency characteristics A of the plurality of plasma processing chambers is defined by relationship (10A):

$$(A_{max} - A_{min})/(A_{max} + A_{min}) \qquad (10A)$$

wherein, in each plasma processing chamber, the radiofrequency characteristic A thereof is measured at the measuring point which is at the end of the corresponding radiofrequency feeder connected to the output terminal of the corresponding matching circuit. Since this variation has a predetermined value, there is no variation in radiofrequency electrical characteristics, such as impedance and resonant frequency characteristics, between the plasma chambers (plasma processing chamber units). Thus, the impedance characteristic etc., of the plasma chambers can be controlled to be a predetermined range. Accordingly, these individual plasma chambers consume substantially the same electrical energy in the corresponding plasma spaces.

Accordingly, substantially the same result is achieved from a single process recipe for these different plasma chambers. When films are formed in these plasma chambers, these films can have substantially the same characteristics, e.g., the thickness, the isolation voltage, and the etching rate.

Instead of the above measuring point, the radiofrequency characteristic A of each plasma processing chamber may be measured at a measuring point which is the radiofrequency-generator-side end of the radiofrequency feed line connected to the respective radiofrequency generator. These plasma chambers including plasma processing chambers and matching circuits have substantially the same radiofrequency electrical characteristics. Thus, these individual plasma chambers consume substantially the same electrical energy in the corresponding plasma spaces. Accordingly, substantially the same result is more effectively achieved from a single process recipe for these different plasma chambers compared to a method not including a matching circuit in the range to be measured.

Instead of the above measuring point, the radiofrequency characteristic A thereof may be measured at a measuring point which is the input terminal connected to the corresponding radiofrequency feeder. These plasma chambers including matching circuits and radiofrequency feeders have substantially the same radiofrequency electrical characteristics. Thus, these individual plasma chambers consume substantially the same electrical energy in the corresponding plasma spaces. Accordingly, substantially the same result is further effectively achieved from a single process recipe for these different plasma chambers compared to a method not including a matching circuit and a radiofrequency feeder in the range to be measured.

When the predetermined value is less than 0.1, the variation in thicknesses of films which are deposited under substantially the same conditions in different chambers can be controlled to be within $\pm 5\%$, resulting in uniform plasma processing.

When the predetermined value is less than 0.03, these plasma chambers have substantially the same radiofrequency electrical characteristics, such as impedance and resonant frequency characteristics. Thus, the impedance characteristics of these plasma chambers can be controlled to be in a predetermined range so that these plasma chambers substantially the same electrical energy in the plasma spaces.

Accordingly, substantially the same result is achieved from a single process recipe for these different plasma chambers. When films are formed in these plasma chambers, these films can have substantially the same characteristics, e.g., the thickness, the isolation voltage, and the etching rate. When the predetermined value is less than 0.03, the variation in thicknesses of films which are deposited under substantially the same conditions in different chambers can be controlled to be within $\pm 2\%$.

In the present invention, one of the resonant frequency f, and the impedance $Z_e$, the resistance $R_e$, and the reactance $X_e$ at the frequency of the radiofrequency waves is employed as the radiofrequency characteristic A, so that the different plasma chambers have substantially the same radiofrequency electrical characteristics. Since these plasma chambers can be operated under conditions within the predetermined ranges using impedance characteristics etc. as references, these plasma chambers consume substantially the same electrical energy in the plasma spaces thereof.

The resonant frequency f is determined by measuring the dependence of the impedance Z on frequency. In contrast, the impedance $Z_e$ at the frequency for exciting the plasma can be readily determined without determining the dependence of the radiofrequency characteristics of the plasma chamber on the frequency. Moreover, the impedance $Z_e$ more directly reflects the radiofrequency electrical characteristics of the plasma chamber at the plasma excitation frequency.

When the resistance $R_e$ or the reactance $X_e$ is employed, this can more directly reflect the radiofrequency electrical characteristic at the plasma excitation frequency of the plasma chamber compared with the impedance $Z_e$

which corresponds to the vector defined by the resistance $R_e$ and the reactance $X_e$.

The radiofrequency characteristic A may be the first series resonant frequency $f_0$.

The first series resonant frequency $f_0$ is a radiofrequency electrical characteristic which is determined by various factors, such as the mechanical structure. Thus, it is believed that apparatuses in use have different first series resonant frequencies $f_0$. In the present invention, the first series resonant frequency $f_0$ is set to be within the above-mentioned predetermined range. Consequently, overall radiofrequency electrical characteristics of the individual chamber can be controlled, resulting in generation of a highly stable plasma in each plasma chamber. In other words, the operations of the individual plasma chambers of the plasma processing apparatus or system are uniform and stable.

This process does not require a determination of the process conditions based on the relationships between enormous amounts of data for the individual plasma chambers and the results obtained by evaluation of actually processed substrates. Thus, in installation of new systems and inspection of installed systems, the time required for obtaining substantially the same results using the same process recipe in these plasma chambers can be significantly reduced compared with an inspection process by actual deposition onto the substrates to be processed. Thus, the production line reduces the cost of substrates used in the inspection, processing of these substrates, and labor during the inspection operations.

Preferably, three times the first series resonant frequency $f_0$ corresponding to each plasma processing chamber is larger than the frequency $f_e$ of the radiofrequency waves. Thus, electrical power can be effectively introduced into the plasma space when the radiofrequency is higher than 13.56 MHz which is used in conventional methods. As a result, the deposition rate of the film is improved.

In the plasma processing apparatus of the present invention, preferably, each plasma processing chamber has a measuring terminal for measuring the radiofrequency characteristic A thereof at the corresponding measuring point. In addition, each plasma processing chamber preferably has a switch in the vicinity of the corresponding measuring point in which the switch electrically disconnects the measuring point from the measuring terminal and connects the plasma excitation electrode to the radiofrequency generator in a plasma excitation mode in which the plasma is excited, whereas the switch electrically connects the measuring point to the measuring terminal and disconnects the radiofrequency generator from the measuring point in a measuring mode in which the radiofrequency characteristic A of the corresponding plasma processing chamber is measured. In the measuring mode, the switch disconnects the measuring terminal from the radiofrequency generator, the radiofrequency feed line, the matching circuit, the radiofrequency feeder, or the plasma excitation electrode. Thus, a probe can be readily connected to the impedance measuring terminal when the impedance characteristics of each plasma chamber are measured. Moreover, the switch does not require mechanical detachment of the obstacle components, such as the radiofrequency generator, the radiofrequency feed line, the matching circuit, and the radiofrequency feeder when the impedance characteristics of each plasma chamber are measured. Thus, the radiofrequency characteristic A can be more precisely measured in each plasma chamber. Moreover, the radiofrequency characteristics A of a plurality of plasma chambers can be readily measured. Thus, in installation of new systems and inspection of installed systems, the time required for obtaining substantially the same results using the same process recipe in these plasma chambers can be significantly reduced compared with conventional inspection process which requires a monthly period.

More specifically, each plasma processing chamber has the measuring terminal for measuring the radiofrequency characteristic A thereof in the vicinity of an end of the radiofrequency feeder. In addition, each plasma processing chamber has the switch between the end of the radiofrequency feeder and the measuring point in which the switch electrically disconnects the radiofrequency feeder from the measuring terminal and connects the end of the radiofrequency feeder to the output terminal of the matching circuit in a plasma excitation mode in which the plasma is excited, whereas the switch electrically connects the end of the radiofrequency feeder to the measuring terminal and disconnects the end of the radiofrequency feeder from the output terminal of the matching circuit in a measuring mode in which the radiofrequency characteristic A of the plasma processing chamber is measured. In the measuring mode, the switch disconnects the conductor for supplying electrical powder from the matching circuit. Thus, a probe can be readily connected to the impedance measuring terminal when the impedance characteristics of each plasma chamber is measured. Since the matching circuit is disconnected by the switch, the impedance characteristics of the plasma chamber can be more exactly measured via the switch. Thus, the first series resonant frequencies $f_0$ of a plurality of plasma chambers can be readily measured. In installation of new systems and inspection of installed systems, the time required for obtaining substantially the same results using the same process recipe in these plasma chambers can be significantly reduced compared with conventional inspection process which requires a monthly period.

Since the impedance meter is detachable in the present invention, the impedance meter is detached from the measuring terminal or disconnected from the measuring terminal by a switch in the plasma excitation mode. Thus, the impedance meter is not electrically affected in the plasma excitation mode. The radiofrequency characteristics A and particularly first series resonant frequencies $f_0$ of these plasma chambers can be readily measured by measuring the impedance or the like by operating the switch without disconnecting the impedance meter from the plasma chambers.

The connection may be sequentially switched to the measuring terminals of these plasma chambers to measure the radiofrequency characteristics of these plasma chambers using a single impedance meter.

Using the above switch, the radiofrequency characteristic A measured at the radiofrequency generator side when the measuring point is electrically disconnected from the measuring terminal while the radiofrequency feeder is electrically connected to the radiofrequency generator is preferably equalized to the radiofrequency characteristic A measured at the measuring terminal side when the measuring point is electrically connected to the measuring terminal while the radiofrequency generator is electrically disconnected from the measuring point. More specifically, using the above switch, the radiofrequency characteristic A at the output end of the matching circuit when an end of the radiofrequency feeder is electrically disconnected from the measuring terminal while the end of the radiofrequency feeder is electrically connected to the output end of the matching circuit may be equalized to the radiofrequency characteristic A at the measuring terminal when the end of the radiofrequency feeder is electrically connected to the measuring terminal while the end of the radiofrequency feeder is electrically disconnected from the output end of the matching circuit. More specifically, the radiofrequency characteristic A at the output terminal of the matching circuit when an end of the radiofrequency feeder is electrically disconnected from the measuring terminal while the end of the radiofrequency feeder is electrically connected to the output terminal of the matching circuit may be equalized to the radiofrequency characteristic A at the measuring terminal when the end of the radiofrequency feeder is electrically connected to the measuring terminal while the end of the radiofrequency feeder is electrically disconnected from the output terminal of the matching circuit. Thus, the values such as impedance measured with the impedance meter, which is connected to the measuring terminals of the plasma chambers, include the same correction factor from the measuring points. Thus, the observed radiofrequency characteristics A such as the first series resonant frequency can be used without correction, resulting in improved operation efficiency.

The above-mentioned means may be performed as follows. The radiofrequency characteristic A between the measuring point and the impedance meter connected to the measuring terminal is set to be identical to each other in plasma processing chamber units (plasma chambers). More specifically, the length of the coaxial cable from the output position of the final stage at the output side of the matching circuit to the impedance meter is set to be equal in these units.

The number of the plasma chambers provided in each plasma processing apparatus, the number of the plasma processing apparatuses in each plasma processing system, and the number of the plasma chambers may be appropriately determined in the present invention.

If these plasma processing apparatuses are used by different process recipes, the radiofrequency characteristics A such as first series resonant frequency $f_0$ may be determined for each plasma processing apparatus in the same plasma processing system.

In the present invention, the plasma enhanced CVD unit may be of a dual-frequency excitation type which has a first radiofrequency generator, a radiofrequency electrode connected to the first radiofrequency generator, a radiofrequency electrode side matching box having a matching circuit for impedance matching between the first radiofrequency generator and the radiofrequency electrode, a second radiofrequency generator, a susceptor electrode which opposes the radiofrequency electrode, is connected to the second radiofrequency generator, and supports a substrate to be treated, and a susceptor side matching box having a matching circuit for impedance matching between the second radiofrequency generator and the susceptor electrode. The frequency of the radiofrequency waves and the radiofrequency characteristics A such as first series resonant frequency $f_0$ which are measured at the output terminal of the matching circuit at the susceptor side may be determined as in the cathode electrode side.

In the performance validation system for the plasma processing apparatus or the plasma processing system of the present invention, a maintenance engineer uploads performance information which shows the status of the operational performance of each plasma processing apparatus purchased by a customer. The customer can obtain the standard performance information which is useful for determining the purchase of the apparatus or system and the operation and maintenance information, including radiofrequency characteristics A such as first series resonant frequency $f_0$, of the apparatus or system in use with his terminal via a public line. The performance information can also be used as a catalog and a specification documents.

In the inspection method of the plasma processing apparatus or system, a variation between the maximum frequency $A_{max}$ and the minimum frequency $A_{min}$ among radiofrequency characteristics A of the plurality of plasma processing chambers of the apparatus of system is defined by relationship (10A):

$$(A_{max} - A_{min})/(A_{max} + A_{min}) \qquad (10A)$$

By checking whether the variation lies within a predetermined value, it can be confirmed that whether these plasma chambers are set to have substantially the same radiofrequency electrical characteristics, such as impedance and resonant frequency characteristics. Since the impedance characteristics and the like of these plasma chambers can be controlled within a predetermined range, these plasma chambers consume substantially the same electrical power in the plasma space and generate substantially the same plasma density.

Accordingly, substantially the same result is achieved from a single process recipe for these different plasma chambers. When films are formed in these plasma chambers, these films can have substantially the same characteristics, e.g., the thickness, the isolation voltage, and the etching rate.

The radiofrequency electrical characteristics of each plasma chamber are determined by the size and the shape thereof. Since each component constituting the plasma chamber has a variation in size due to machining tolerance which is inevitable in mechanical processing for the chamber production. In addition, each plasma chamber has assembling tolerance. Moreover, the plasma chamber includes portions in which sizes thereof are not measured after assembling. This inspection method, however, quantitatively determine the performance of plasma chambers regardless of the unmeasurable portions and differences in radiofrequency electrical characteristics between these chambers.

Alternatively, in each plasma processing chamber unit, the radiofrequency characteristic A thereof is measured at a measuring point which is the radiofrequency-generator-side end of the radiofrequency feed line connected to the respective radiofrequency generator. In this case, differences in radiofrequency electrical characteristics between a plurality of plasma chambers including matching circuits are set to be substantially zero. Thus, these plasma chambers consume substantially the same electrical power in the plasma spaces. Accordingly, substantially the same result is more readily achieved from a single process recipe for these different plasma chambers compared with a case in which the matching circuit is not included in the measuring range.

Alternatively, in each plasma processing chamber unit, the radiofrequency characteristic A thereof is measured at a measuring point which is the input terminal connected to the corresponding radiofrequency feed line. In this case, differences in radiofrequency electrical characteristics between a plurality of plasma chambers including matching circuits and radiofrequency feed lines are set to be substantially zero. Thus, the electrical power consumption in the plasma spaces of these plasma chambers becomes further uniform. Accordingly, substantially the same result is more readily achieved from a single process recipe for these different plasma chambers compared with a case in which the matching circuit and the radiofrequency feed line is included in the measuring range.

By confirming that the variation is set to be less than 0.1 in this inspection method, it can be confirmed whether the plasma processing is uniform, for example, whether the thickness of the film which is deposited in each plasma chamber under substantially the same conditions is controlled to be within $\pm 5\%$.

By confirming that the variation is set to be less than 0.03 in this inspection method, a plurality of plasma chambers are set to have substantially the same radiofrequency electrical characteristics, such as impedance and resonant frequency characteristics. Since it can be confirmed that the impedance characteristics are controlled to be within a predetermined range. Thus, the density of the plasma generated in each plasma chamber becomes uniform.

Accordingly, the plasma chambers can be controlled as follows. Substantially the same result is achieved from a single process recipe for these different plasma chambers. When films are formed in these plasma chambers, these films can have substantially the same characteristics, e.g., the thickness, the isolation voltage, and the etching rate. When the variation is controlled to be less than 0.03 under the same deposition conditions in the plasma chambers, the variation in film thickness can be controlled to be less than $\pm 2\%$.

In the inspection method of the plasma processing apparatus or system, as described above, each radiofrequency characteristic A may be any one of a resonant frequency f, an impedance $Z_e$ at the frequency of the radiofrequency generator, a resistance $R_e$ at the frequency of the radiofrequency generator, and a reactance $X_e$ at the frequency of the radiofrequency generator. Thus, the impedance characteristics such as impedance of a plurality of plasma chambers are controlled to be within a predetermined range, and the effective electric energies consumed in the plasma spaces are set to be substantially equal.

When the impedance $Z_e$ at the frequency of the radiofrequency generator is employed as the radiofrequency characteristic A, it is not necessary to find the dependence of the radiofrequency characteristic on the frequency in the plasma chambers. Thus, the impedance $Z_e$ at the frequency of the radiofrequency generator can be readily determined compared with the resonant frequency f which must be determined by the dependence of the impedance Z on the frequency. Moreover, the impedance $Z_e$ can directly reflect the radiofrequency electrical characteristic at the plasma excitation frequency of the plasma chambers.

When the resistance $R_e$ or the reactance $X_e$ is employed, this can more directly reflect the radiofrequency electrical characteristic at the plasma excitation frequency of the plasma chamber compared with the impedance $Z_e$ which corresponds to the vector defined by the resistance $R_e$ and the reactance $X_e$.

The connection can be sequentially switched to the measuring terminals of these plasma chambers to measure the radiofrequency characteristics of these plasma chambers using a single impedance meter.

Using the above switch, the radiofrequency characteristic A measured at the radiofrequency generator side when the measuring point is electrically disconnected from the measuring terminal while the radiofrequency feeder is electrically connected to the radiofrequency generator is equalized to the radiofrequency characteristic A measured at the measuring terminal side when the measuring point is electrically connected to the measuring terminal while the radiofrequency generator is electrically disconnected from the measuring point. Thus, the values such as impedance measured with the impedance meter, which is connected to the measuring terminals of the plasma chambers, include the same correction factor from the measuring points. Thus, the observed radiofrequency characteristics A such as the first series resonant frequency can be used without correction, resulting in improved operation efficiency.

BRIEF DESCRIPTION OF THE DRAWINGS

Fig. 1 is an outline schematic view of a plasma processing apparatus in accordance with a first embodiment of the present invention;

Fig. 2 is a schematic view of a matching circuit of the plasma processing apparatus shown in Fig. 1;

Fig. 3 is a schematic view for illustrating impedance characteristics of the plasma processing apparatus of the first embodiment;

Fig. 4 is an equivalent circuit diagram of the plasma processing apparatus shown in Fig. 3;

Fig. 5 is a graph illustrating the dependence of the impedance Z and the phase $\theta$ on the frequency for defining a first series resonant frequency $f_0$;

Fig. 6 is a graph illustrating the dependence of the impedance Z and the phase $\theta$ on the frequency for defining a first series resonant frequency $f_0$ in the first embodiment of the plasma processing apparatus;

Fig. 7 is an outline schematic view of a plasma processing apparatus in accordance with a second embodiment of the present invention;

Fig. 8 is a schematic view for illustrating impedance characteristics of the plasma processing apparatus of the second embodiment;

Fig. 9 is an equivalent circuit diagram of the plasma processing apparatus shown in Fig. 8;

Fig. 10 is a graph illustrating the dependence of the impedance Z and the phase $\theta$ on the frequency for defining a first series resonant frequency $f_0$ in the second embodiment of the plasma processing apparatus;

Fig. 11 is an outline schematic view of a plasma processing apparatus in accordance with a third embodiment of the present invention;

Fig. 12 is an equivalent circuit diagram of the plasma processing apparatus shown in Fig. 11;

Fig. 13 is a graph illustrating the dependence of the impedance Z and the phase $\theta$ on the frequency for defining a first series resonant frequency $f_0$ in the third embodiment of the plasma processing apparatus;

Fig. 14 is a schematic view of a plasma emission state between electrodes;

Fig. 15 is an equivalent circuit diagram of an embodiment of the plasma processing apparatus in accordance with the present invention;

Fig. 16 is an isometric view of a probe for an impedance meter;

Fig. 17 is a schematic view illustrating connection of the probe for the impedance meter shown in Fig. 16;

Fig. 18 is a schematic view of an exemplary conventional plasma processing apparatus;

Fig. 19 is a schematic view of another conventional plasma processing apparatus;

Fig. 20 is a schematic view illustrating a performance validation system of the plasma processing apparatus in accordance with the present invention;

Fig. 21 is a flow chart illustrating processing for providing performance information from a server S in the performance validation system of the plasma processing apparatus of the present invention;

Fig. 22 shows an output form of a main page CP in accordance with the performance validation system of the plasma processing apparatus of the present invention;

Fig. 23 shows an output form of a subpage CP1 in accordance with the performance validation system of the plasma processing apparatus of the present invention;

Fig. 24 shows an output form of a main page CP2 in accordance with the performance validation system of the plasma processing apparatus of the present invention;

Fig. 25 shows an output form of a subpage CP3 in accordance with the performance validation system of the plasma processing apparatus of the present invention;

Fig. 26 is an outline schematic view of a plasma processing apparatus in accordance with a fourth embodiment of the present invention;

Fig. 27 is a cross-sectional view of the laser annealing chamber shown in Fig. 26;

Fig. 28 is a cross-sectional view of the annealing chamber shown in Fig. 26;

Fig. 29 is an outline schematic view of a plasma processing apparatus in accordance with a fifth embodiment of the present invention;

Fig. 30 is an equivalent circuit diagram of the plasma processing apparatus shown in Fig. 11;

Fig. 31 is an outline schematic view of a plasma processing system in accordance with a sixth embodiment of the present invention;

Fig. 32 is an outline schematic view of another embodiment of the plasma processing apparatus in accordance with the present invention;

Fig. 33 is an outline schematic view of another embodiment of the plasma processing apparatus in accordance with the present invention;

Fig. 34 is an outline schematic view of another embodiment of the plasma processing apparatus in accordance with the present invention;

Fig. 35 is an outline schematic view of a plasma processing unit (plasma chamber) of a plasma processing system in accordance with a seventh embodiment of the present invention;

Fig. 36 is a schematic view for illustrating impedance characteristics of the plasma chamber shown in Fig. 35;

Fig. 37 is an equivalent circuit diagram for measuring impedance characteristics of the plasma chamber shown in Fig. 36;

Fig. 38 shows an output form of a subpage CP3 in accordance with the performance validation system of the plasma processing apparatus of the present invention;

Fig. 39 shows an output form of a subpage CP4 in accordance with the performance validation system of the plasma processing apparatus of the present invention; and

Fig. 40 is an outline schematic view of another plasma processing apparatus in accordance with a seventh embodiment of the present invention; and

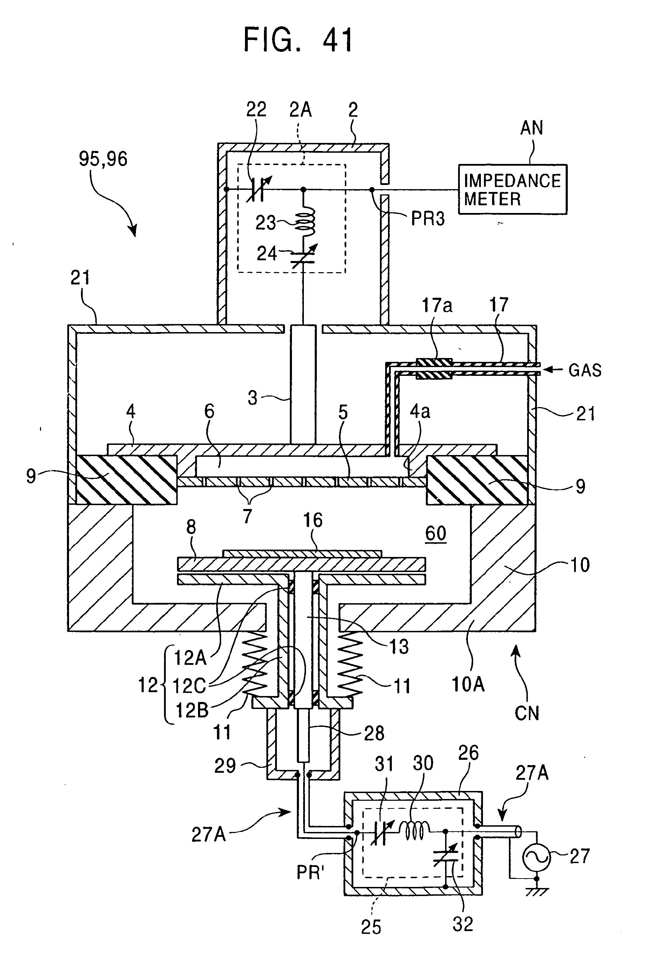

Fig. 41 is an outline schematic view of another plasma processing apparatus in accordance with a seventh embodiment of the present invention.

DESCRIPTION OF THE PREFERRED EMBODIMENTS

First Embodiment

A plasma processing apparatus according to a first embodiment of the present invention will now be described with reference to the drawings.

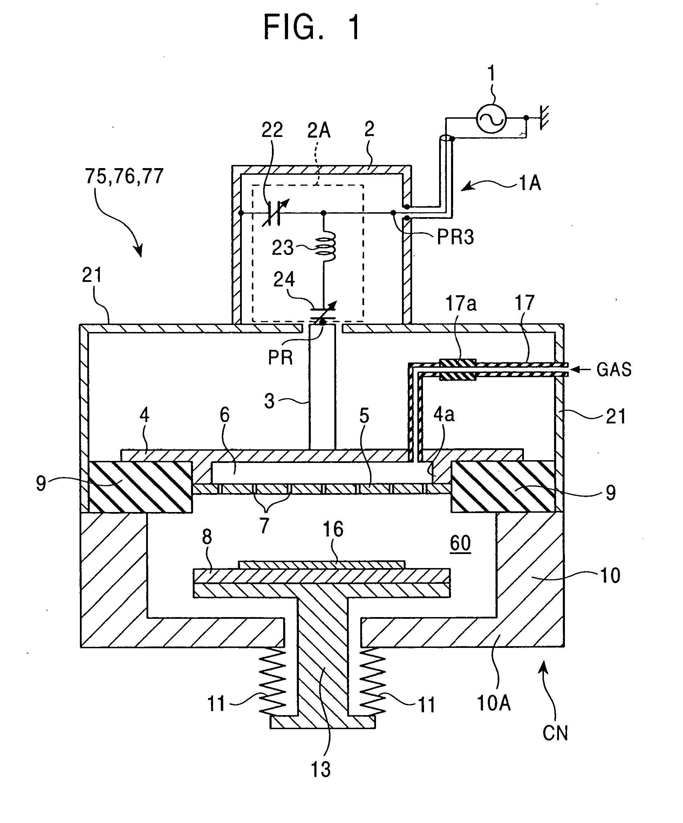

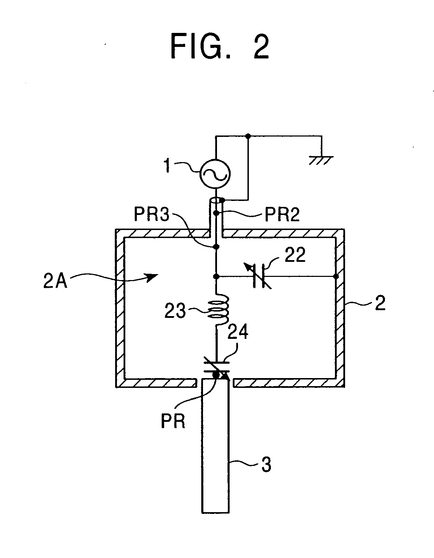

Fig. 1 is a cross-sectional view schematically illustrating the structure of a plasma processing apparatus of the first embodiment. Fig. 2 illustrates a matching circuit of the plasma processing apparatus shown in Fig. 1.

The plasma processing apparatus of this embodiment is of a single-frequency excitation type and performs plasma processing such as chemical vapor deposition (CVD), sputtering, dry etching, ashing, or the like. Referring to Fig. 1, the plasma processing apparatus comprises a plasma chamber (plasma processing chamber) CN having parallel plate type electrodes 4 and 8 for exciting a plasma, a radiofrequency generator 1 connected to the electrode 4, and a matching circuit 2A for matching the impedance between the plasma chamber CN and the radiofrequency generator 1.

In the plasma processing apparatus of this embodiment, it is arranged that three times the first series resonant frequency $f_0$ of the plasma chamber CN measured at an output position PR of the matching circuit 2A is larger than the power frequency $f_e$ fed from the radiofrequency generator 1 to the plasma chamber CN, as described below.

To be more specific, as shown in Figs. 1 and 2, in the plasma processing apparatus of this embodiment, the plasma excitation electrode 4, which is connected to the radiofrequency generator 1, and a shower plate 5 are disposed in the upper portion of the plasma chamber CN. The electrode 8 serving as a susceptor electrode for receiving a substrate 16 is provided facing the shower plate 5 in the lower portion of the plasma chamber CN. The plasma excitation electrode 4 is connected to the radiofrequency generator 1 via a feed plate (radiofrequency feeder) 3 and the matching circuit 2A. The plasma excitation electrode 4 and the feed plate 3 are covered by a chassis 21. The matching circuit 2A is accommodated inside a matching box 2 composed of a conductor.

A silver-plated copper plate 50 to 100 mm in width, 0.5 mm in thickness, and 100 to 300 mm in length is used as the feed plate 3. The feed plate 3 is screwed to an output end of a tuning capacitor 24 of the matching circuit 2A described below and the plasma excitation electrode 4.

At the lower side of the plasma excitation electrode 4 functioning as the cathode, a projection 4a is provided. The projection 4a is in contact with the shower plate 5 provided below the plasma excitation electrode 4. The plasma excitation electrode 4 and the shower plate 5 define a space 6. A gas feeding tube 17 is connected to the space 6, and an insulator 17a is inserted midway in the gas feeding tube 17 so as to insulate the plasma excitation electrode 4 and the gas supply.

The gas from the gas feeding tube 17 is fed to a chamber space 60 formed by a chamber wall 10 through a number of holes 7 in the shower plate 5. The chamber wall 10 and the plasma excitation electrode 4 are isolated from each other by an insulator 9. The exhaust system is omitted from the drawing.

In the chamber space 60, the susceptor electrode 8 (wafer susceptor) which receives the substrate 16 and also serves as a plasma excitation electrode is provided.

A shaft 13 is joined to the susceptor electrode 8 at the bottom center of the susceptor electrode 8 and penetrates a chamber bottom 10A. The lower portion of the shaft 13 and the center portion of the chamber bottom 10A are hermetically connected by a bellows 11. The bellows 11 allows the susceptor electrode 8 and the shaft 13 to move upward and downward so as to control the distance between the electrodes 4 and 8.

Because the susceptor electrode 8, the shaft 13, and a supporting tube 12B are connected, the susceptor electrode 8, the shaft 13, the bellows 11, the chamber bottom 10A, and the chamber wall have the same DC potential. Moreover, because the chamber wall 10 and the chassis 21 are connected, the chamber wall 10, the chassis 21, and the matching box 2 also have the same DC potential.

The matching circuit 2A is generally constituted from a plurality of passive devices in order to adjust the impedance in response to changes in the state of the plasma inside the plasma chamber.

Referring to Figs. 1 and 2, in the matching circuit 2A, a coil 23 and the tuning capacitor 24, as the passive devices, are provided in series between the radiofrequency generator 1 and the feed plate 3. A load capacitor 22 is connected in parallel to the coil 23 and the tuning capacitor 24. One end of the load capacitor 22 is connected to the matching box 2. The tuning capacitor 24 is connected to the plasma excitation electrode 4 via the feed plate 3.

The matching box 2 is connected to a shielding line of a feed line 1A which is a coaxial cable, and this shielding line is DC grounded. In this manner, the susceptor electrode 8, the shaft 13, the bellows 11, the chamber bottom 10A, the chamber wall 10, the chassis 21, and the matching box 2 are set to a ground voltage while one end of the load capacitor 22 is DC-grounded.

In this embodiment, power with a frequency of 13.56 MHz or more, more specifically, power with a frequency of 13.56 MHz, 27.12 MHz, or 40.68 MHz is used to generate a plasma between the electrodes 4 and 8. Using this plasma, the substrate 16 placed on the susceptor electrode 8 is subjected to a plasma process such as CVD, dry etching, ashing, or the like.

At this stage, the radiofrequency voltage is supplied from the radiofrequency generator 1 to the coaxial cable of the feed line 1A, the matching circuit 2A, the feed plate 3, and the plasma excitation electrode 4 (cathode electrode). As for the path of the radiofrequency current, the current flows into the plasma space (chamber space 60) via the above-described components, then to the susceptor electrode 8, the shaft 13, the bellows 11, the chamber bottom 10A and the chamber wall 10, and finally into the chassis 21, the matching box 2, and the shielding line of the feed line 1A, back to the earth of the radiofrequency generator 1.

Now, the first series resonant frequency $f_0$ of the plasma processing apparatus of this embodiment will be described.

The first series resonant frequency $f_0$ is the least significant frequency among the frequencies assigned to the minima of the impedance Z when the dependency between the impedance and the frequency in the plasma chamber CN is measured. The first series resonant frequency $f_0$ is set larger than the power frequency $f_e$ described above.

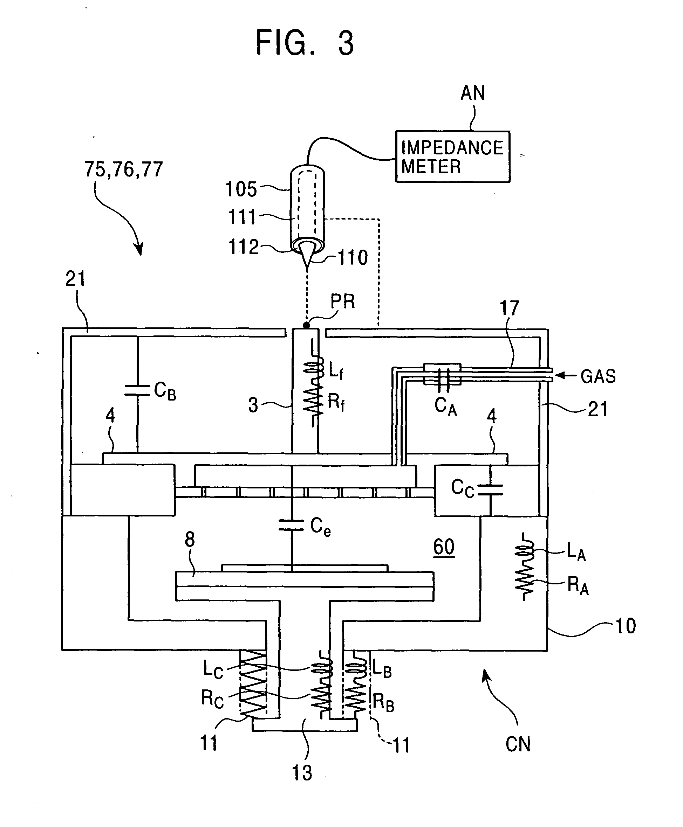

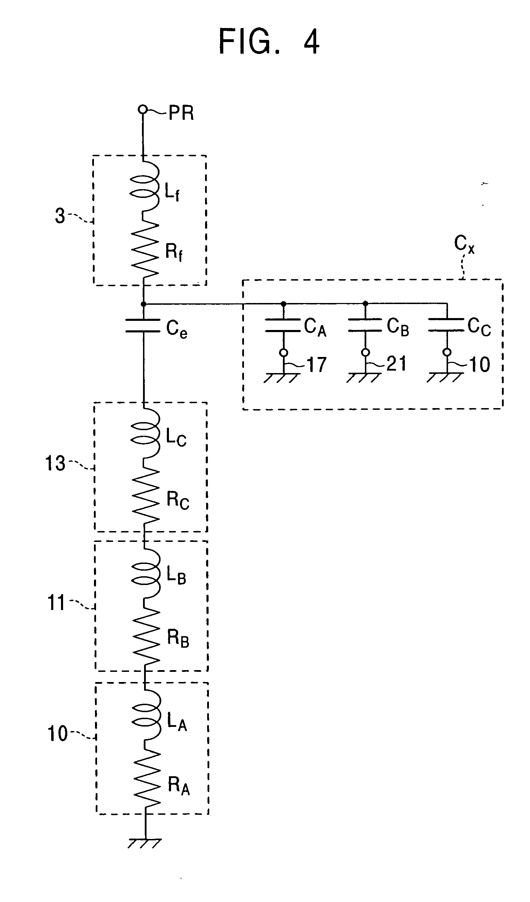

The first series resonant frequency is an electrical radiofrequency property mainly determined by the mechanical structure and is measured as shown in Figs. 3 and 4.

Fig. 3 is an illustration for explaining the impedance property of the plasma processing apparatus, and Fig. 4 is an equivalent circuit diagram of the circuit shown in Fig. 3.

The region of the plasma chamber CN to be measured is the region of the plasma chamber CN without the matching circuit 2A, the matching circuit 2A being detached from the plasma chamber CN at an output end position of a passive device which is the final output stage among the passive devices of the matching circuit 2A. More particularly, the matching circuit is removed from the plasma chamber CN by removing the screws clamping the feed plate 3 and the matching circuit 2A at the output end position PR of the tuning capacitor 24 connected to the feed plate 3 as shown in Fig. 3, and the remaining part of the plasma chamber CN is the measured region.

As shown by broken lines in Fig. 3, a probe 105 of an impedance meter AN is connected to the output end position PR at which separation was carried out and to an earth position such as the chassis 21 of the plasma chamber CN. In this state, a measuring frequency oscillated by the impedance meter AN is varied over the range of 1 MHz to 100 MHz so as to determine the vector quantity (Z, θ) of the impedance of the above-described measured region of the plasma chamber CN.

As shown in Fig. 3, the probe 105 comprises a conductive line 110, an insulation coating 112 provided on the conductive line 110, and a peripheral conductor 111 covering the insulation coating 112. The probe 105 is connected to the impedance meter (resonant frequency meter) AN via a coaxial cable.

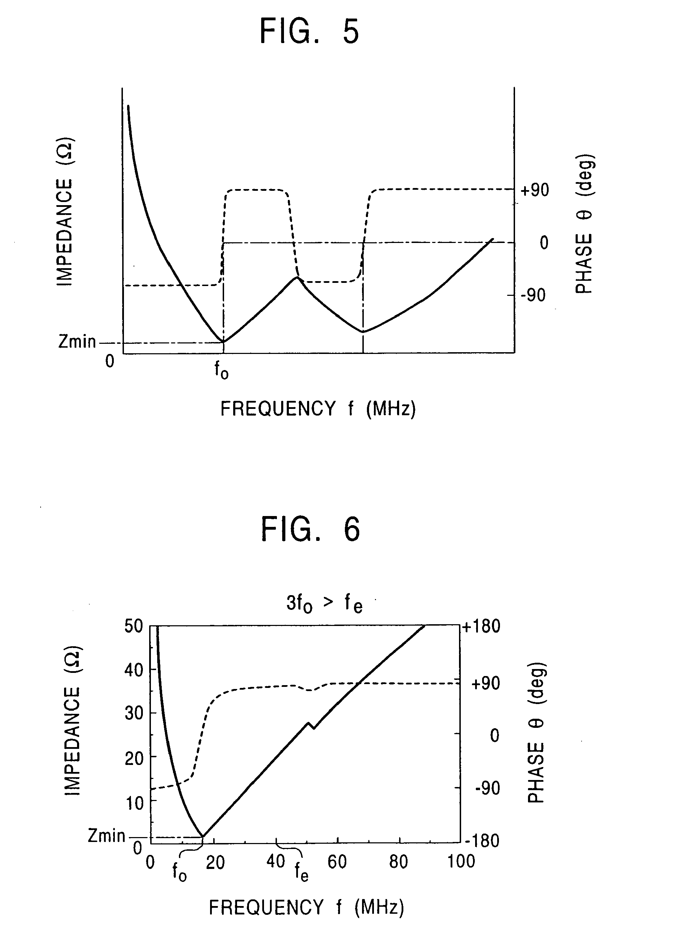

Next, as shown in Fig. 5, the impedance Z and phase θ (deg) are plotted along the ordinates of the graph having the abscissa indicating measuring frequency f (MHz). In the graph, the ordinate at the left side corresponds to impedance Z (Ω) and the ordinate at the right side corresponds to phase θ (degree). Referring to the impedance characteristic curve (shown by a solid line) and the phase curve (shown by a broken line) in Fig. 5, the first series resonant frequency $f_0$ is defined as the frequency corresponding to the minimum value $Z_{min}$ of the impedance, i.e., the frequency assigned to a phase θ of zero when the phase θ first goes from positive to negative while the measuring frequency f is increased.

In the thus determined first series resonant frequency $f_0$, the following electrical radiofrequency factors within the above-described measured region are taken into a consideration, as shown in Fig. 3:

Inductance $L_f$ and resistance $R_f$ of the feed plate 3;
Plasma electrode capacitance $C_e$ between the plasma excitation electrode 4 and the susceptor electrode 8;
Inductance $L_C$ and resistance $R_C$ of the shaft 13;
Inductance $L_B$ and resistance $R_B$ of the bellows 11;
Inductance $L_A$ and resistance $R_A$ of the chamber wall 10;
Capacitance $C_A$ between the gas feeding tube 17 and the plasma excitation electrode 4 via the insulator 17a;
Capacitance $C_B$ between the plasma excitation electrode 4 and the chassis 21; and
Capacitance $C_C$ between the plasma excitation electrode 4 and the chamber wall 10.

These electrical radiofrequency factors are arranged in the same manner as in the circuit for generating plasma using radiofrequency current so as to form an equivalent circuit shown in Fig. 4. More specifically, the inductance $L_f$ and resistance $R_f$ of the feed plate 3, the plasma electrode capacitance $C_e$ between the plasma excitation electrode 4 and the susceptor electrode 8, the inductance $L_C$ and resistance $R_C$ of the shaft 13, the inductance $L_B$ and resistance $R_B$ of the bellows 11, and the inductance $L_A$ and resistance $R_A$ of the chamber wall 10 are connected in series in that order while having the resistance $R_A$ grounded. Between the resistance $R_f$ and the plasma electrode capacitance $C_e$, the capacitance $C_A$, the capacitance $C_B$, and the capacitance $C_C$ are connected in parallel, one end of each being grounded. By determining the impedance characteristics of this equivalent circuit, the first series resonant frequency $f_0$ of this embodiment can be defined.

The first series resonant frequency $f_0$ is adjusted so that three times $f_0$ is larger than the power frequency $f_e$ supplied from the radiofrequency generator 1.

Examples of the methods for adjusting the first series resonant frequency $f_0$ are as follows:

(1) Adjusting the shape (length) of the feed plate 3;
(2) Adjusting the overlapping area of the plasma excitation electrode 4 and the chamber wall 10;
(3) Adjusting the insulating material between the plasma excitation electrode 4 and the chamber wall 10; and
(4) Connecting the susceptor electrode 8 and the chamber wall 10 with a conductor.

For example, in the plasma processing apparatus of this embodiment, the power frequency $f_e$ is set to 40.68 MHz and the impedance Z ($\Omega$) and the phase $\theta$ (deg) relative to the measurement frequency f (MHz) ranging from 0 to 100 MHz are measured to form an impedance characteristic curve and a phase curve, as shown in Fig. 6. The first series resonant frequency $f_0$ is then set to 16.5 MHz so that relationship (2) below is satisfied.

$$3f_0 > f_e \qquad (2)$$

In the plasma processing apparatus of this embodiment, the first series resonant frequency $f_0$ is adjusted so that three times $f_0$ is larger than the power frequency $f_e$ supplied from the radiofrequency generator 1, as described above. In this manner, the overall radiofrequency electrical characteristics of the plasma chamber CN, which are not considered in the conventional process, can be optimized. Also, the operational stability is improved thereby, and it becomes possible to efficiently deliver power from the radiofrequency generator 1 to the plasma generation space between the plasma excitation electrode 4 and the susceptor electrode 8 even when a radiofrequency voltage exceeding the conventionally used frequency, i.e., 13.56 MHz, is used. Moreover, when the same frequency as in the conventional process is supplied, the effective power consumed in the plasma space can be increased and the density of the generated plasma can be improved compared to the conventional plasma processing apparatuses. As a result, the processing rate can be improved by increasing the plasma excitation frequency. In other words, the deposition rate can be improved in the plasma-enhanced CVD process or the like.

Because the power can be efficiently supplied to the plasma space, undesirable spreading of the plasma can be inhibited, and the uniformity in plasma processing in the planar direction of the substrate 16 can be improved, thereby improving the planar-direction distribution of the layer thickness during the layer deposition.

When the radiofrequency power is supplied, the potential of the plasma can be reduced and damage due to ions can be prevented. As a consequence, the state of deposition, i.e., the layer characteristics such as isolation voltage, etching resistance, density of the deposited layer (hardness of the layer), or the like, can be improved during the deposition processes such as plasma-enhanced CVD processes, sputtering processes, and the like.

Note that the density of the deposited layer can be expressed as the etching resistance which indicates the resistance against etching using a BHF solution.

Furthermore, even when power having the same frequency as the conventional apparatus is supplied, the power can be supplied to the plasma space with an improved efficiency compared to the conventional apparatus. Because of such an improvement in the power consumption efficiency, the power required for obtaining the same processing rate and the same layer characteristics as the conventional process can be reduced. Since the power consumption is reduced, the operating costs can also be reduced. If the power is supplied for the same period of time, then the production can be increased due to a reduced processing time. In all of these cases, power can be saved and the total emission of carbon dioxide due to power consumption can be reduced.

The first series resonant frequency $f_0$ can be measured in situ using an impedance meter AN; accordingly, the performance validation and evaluation of the plasma processing apparatus can be completed in a shorter period of time. There is no need to stop the manufacturing line for several days or several weeks to wait for the results of the performance validation and evaluation carried out by inspecting the deposited substrate. Thus, the productivity of the manufacturing line can be improved.

Since the first series resonant frequency $f_0$ is mainly determined by the factors relating to the mechanical structure thereof, the first series resonant frequency $f_0$ differs according to specific apparatuses. By setting the first series resonant frequency $f_0$ of each apparatus to the above-described range, it becomes possible to provide each of the apparatuses with predetermined overall radiofrequency electrical characteristics and to achieve stable plasma generation. As a consequence, a plasma processing apparatus with an improved operational stability can be provided.

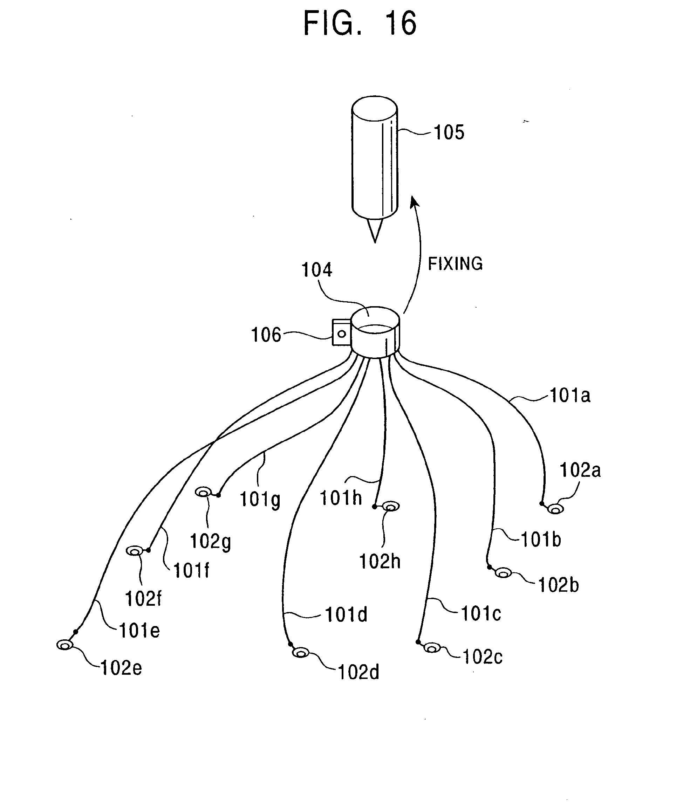

Alternatively, as shown in Fig. 16, a fixture comprising a plurality of conductive wires 101a to 101h, each having a matching impedance, and a probe attachment 104, to which one end of each of the plurality of conductive wires 101a to 101h is attached, may be used to measure the impedance characteristics of the plasma chamber CN.

The probe attachment 104 is formed, for example, by shaping a 50 mm $\times$ 10 mm $\times$ 0.5 mm copper plate to have a clamping portion 106 and a ring portion. The diameter of the ring portion is determined so that the ring portion is attachable to the circumference of the probe 105. The conductive wires 101a to 101h are soldered to the probe attachment 104 to be electrically connected thereto.

Terminals (attachments) 102a to 102h which are attachable to and detachable from a measuring object are installed at the other ends of the conductive wires 101a to 101h.

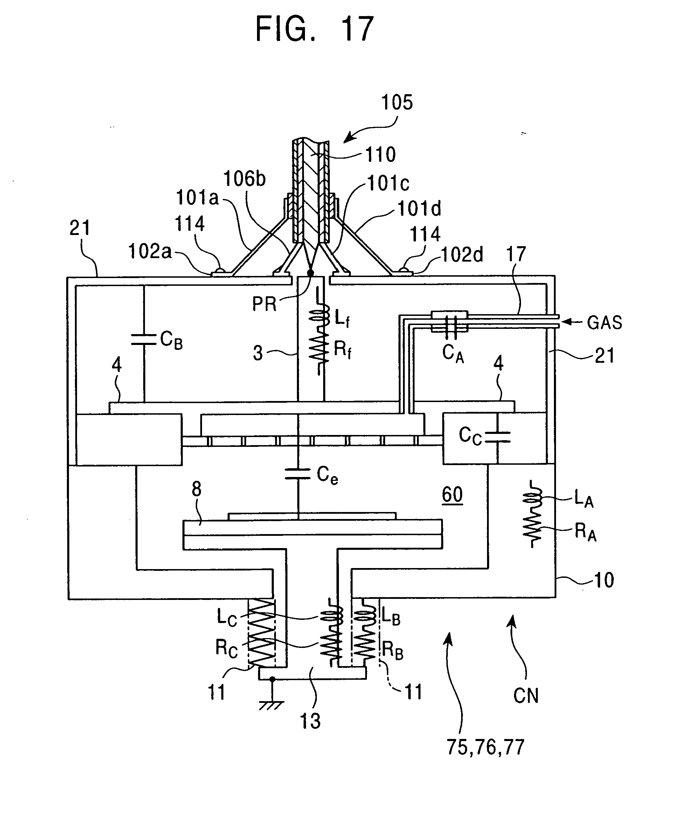

When this fixture is used, the probe 105 is inserted into the ring portion of the probe attachment 104, and the probe 105 and the probe attachment 104 are clamped by the clamping portion 106. The conductive wires 101a to 101h are detachably screwed to the measuring object in a substantially symmetrical manner about a point through the terminals 102a to 102h, as shown in Fig. 17.

The conductive wires 101a to 101h may be made of, for example, aluminum, copper, silver, or gold, or may be plated by silver or gold having a thickness of 50 $\mu$m or more.

The method for measuring impedance using this fixture is now explained with reference to Fig. 17.

First, the radiofrequency generator 1 and the matching box 2 are removed from the plasma processing apparatus. The conductive line 110 of the probe 105 of an impedance meter is then connected to the feed plate 3. The terminals 102a to 102h connected to the conductive wires 101a to 101h of the fixture of the impedance meter are screwed to the chassis 21 of the plasma processing apparatus in a symmetrical manner about the feed plate 3 using screws 114. After the impedance meter is set as above, a measuring signal is fed to the conductive line 110 of the impedance meter so as to measure the impedance of the path from the feed plate 3 of the plasma processing apparatus to the chassis 21 via the plasma space 60.

In this manner, a uniform current flows to the measuring object regardless of the size of the measuring object or the distance between two points to be measured. Also, by setting a residual impedance which does not affect the measurement of the impedance of the measuring object, the impedance measurement can be performed with precision.

In this embodiment, the substrate 16 is placed on the susceptor electrode 8, and the first series resonant frequency $f_0$ and the power frequency $f_e$ are set in relation to the plasma excitation electrode 4. However, it is possible to place the substrate 16 on the plasma excitation electrode 4 serving as a cathode.

Second Embodiment

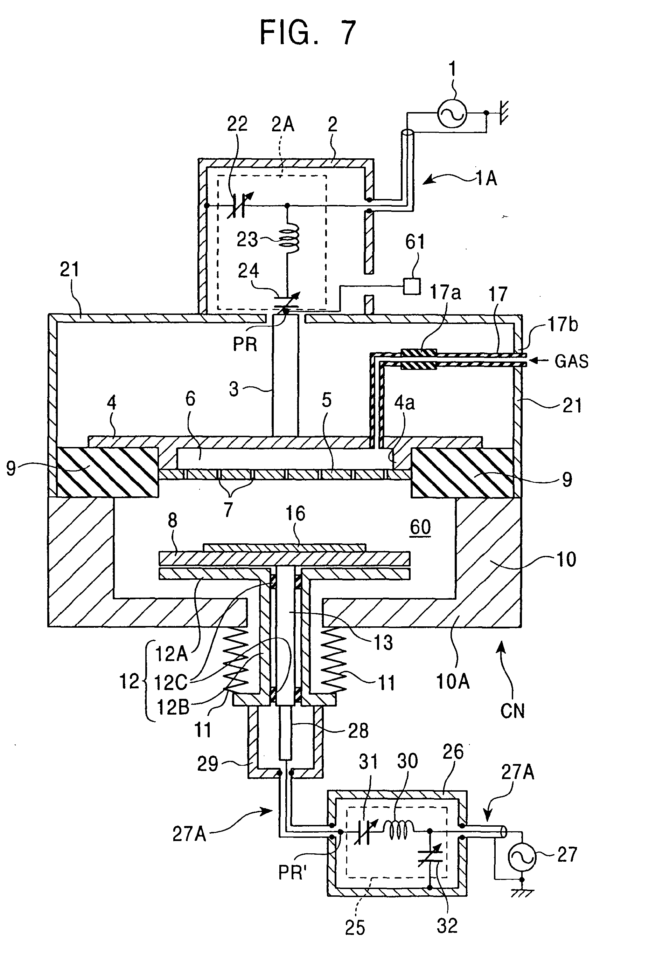

A plasma processing apparatus of a second embodiment will now be described with reference to Fig. 7.

Fig. 7 is a cross-sectional view showing the outline of the structure of a plasma processing apparatus of a second embodiment.

The plasma processing apparatus of the second embodiment is of a dual-frequency excitation type. The second embodiment differs from the first embodiment shown in Figs. 1 to 4 in that the power is supplied to a susceptor electrode 8 side and that there is a measuring terminal 61. A difference also lies in the setting of the first series resonant frequency $f_0$. The corresponding components are given the same reference numerals and symbols and the description thereof is omitted to avoid duplication.

In the plasma processing apparatus of this embodiment, the first series resonant frequency $f_0$ is so set that 1.3 times the first series resonant frequency $f_0$ of the plasma chamber (plasma processing room) CN is larger than the power frequency $f_e$ fed from the radiofrequency generator 1 to the plasma chamber CN.

As shown in Fig. 7, in the plasma processing apparatus of this embodiment, a susceptor shield 12 is disposed under the susceptor electrode 8, and the shaft 13 and the susceptor electrode 8 are electrically isolated from the susceptor shield 12 by a gap between the susceptor shield 12 and the susceptor electrode 8 and by insulators 12C provided around the shaft 13. The insulators 12C also serve to maintain high vacuum in the chamber space 60. The susceptor electrode 8 and the susceptor shield 12 are allowed to move upward and downward by a bellows 11, thereby allowing adjustment of the distance between a plasma excitation electrode 4 and the susceptor electrode 8. The susceptor electrode 8 is connected to a second radiofrequency generator 27 via a feed plate 28 connected to the lower end of the shaft 13 and a matching circuit 25 housed inside a susceptor-electrode-side matching box 26.

The feed plate 28 is covered by a chassis 29 connected to the lower end of a supporting tube 12B of the susceptor shield 12. The chassis 29 is connected to the matching box 26 via a shielding line of a feed line 27A which is a coaxial cable so that the chassis 29 and the matching box 26 are grounded. In this manner, the susceptor shield 12, the chassis 29, and the matching box 26 have the same DC potential.

Herein, the matching circuit 25 for matching the impedance between the second radiofrequency generator 27 and the susceptor electrode 8 comprises a tuning coil 30 and a tuning capacitor 31 connected in series between the second radiofrequency generator 27 and the feed plate 28, and a load capacitor 32 connected in parallel to the tuning coil 30 and the tuning capacitor 31. One end of the load capacitor 32 is connected to the matching box 26 so as to make a circuit having substantially the same structure as that of the matching circuit 2A. The matching box 26 is set to a ground potential via the shielding line of the feed line 27A, thereby grounding one end of the load capacitor 32. As alternative configurations, a tuning coil may be connected to the tuning coil 30 in series so as to form a circuit serving as a tuning coil or a load capacitor may be connected to the load capacitor in parallel so as to form a circuit serving as a load capacitor.

The feed plate 28 is identical to the feed plate 3. The feed plate 28 is screwed to the terminal of the matching circuit 25 and to the shaft 13.

An impedance measuring terminal (resonant frequency measuring terminal) 61 of the plasma chamber CN is provided at the output end position PR of the tuning capacitor 24 which is a passive device at the final output stage among the passive devices of the matching circuit 2A. Note that the output end position PR is within the region of the plasma chamber CN of this embodiment in which the measurements are taken. The impedance measuring terminal 61 extends from the output end position PR, which defines the measured region, as in the first embodiment, by a conductor and lies outside the chassis 21.

In the plasma processing apparatus of this embodiment, a substrate 16 is placed on the susceptor electrode 8, radiofrequency voltage is applied to the plasma excitation electrode 4 and the susceptor electrode 8 from a first radiofrequency generator 1 and the second radiofrequency generator 27, respectively, while a reaction gas is fed into a chamber space 60 through a gas feeding tube 17 and shower holes 7 to generate a plasma, and plasma processing such as deposition or the like is performed on the substrate 16. During the process, a radiofrequency voltage of approximately 13.56 MHz or more, and more specifically, a radiofrequency voltage of 13.56 MHz, 27.12 MHz, 40.68 MHz, or the like, is supplied from the first radiofrequency generator 1. Either the same radiofrequency voltage as in the first radiofrequency generator 1 or a radiofrequency voltage of a different frequency, e.g., 1.6 MHz, may be supplied from the second radiofrequency generator 27.

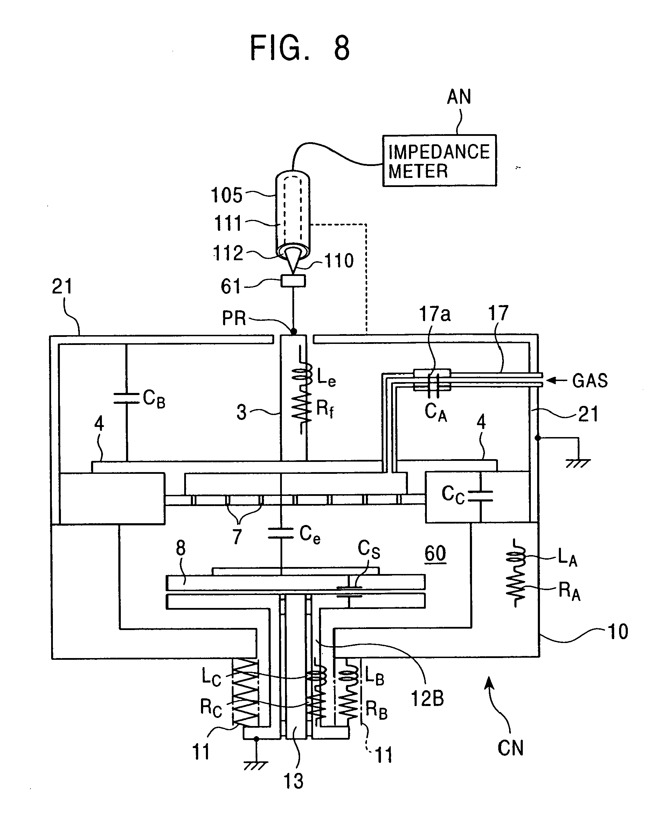

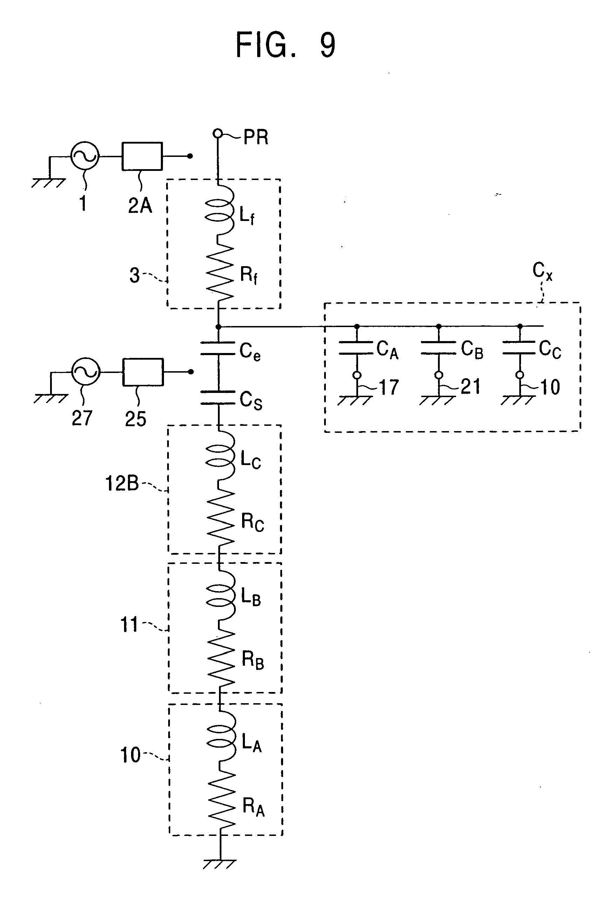

The first series resonant frequency $f_0$ of the plasma processing apparatus according to this embodiment is defined by measurement, as in the first embodiment. Specifically, the first series resonant frequency $f_0$ of this embodiment is defined by measurement, as shown in Figs. 8 and 9.

Fig. 8 is an illustration for explaining the impedance characteristics of the plasma processing apparatus of this embodiment. Fig. 9 is an equivalent circuit of Fig. 8.

The state of the plasma chamber as viewed from the impedance measuring terminal 61 is the object of the measurement in this embodiment. In other words, as shown in Fig. 9, the measured region starts from the impedance measuring terminal 61 and ends at the position at which the matching circuit 25 is separated. When measuring the impedance characteristic (radiofrequency characteristic), the matching circuit 2A connected to the feed plate 3 in parallel at the output end position PR during plasma emission is removed from the plasma chamber CN, and the matching circuit 25 connected to the susceptor electrode 8 during the plasma emission is removed from the plasma chamber CN.

The reason for depicting the radiofrequency generators 1 and 27 in the drawing is not to show that power is being supplied but to show how the matching circuits 2A and 25 are grounded. The impedance characteristics cannot be measured while the power is being supplied.

As shown by a broken line in Fig. 8, a probe 105 of an impedance meter AN is connected to the impedance measuring terminal 61 and to the earth position of the plasma chamber CN, a chassis 21, for example. At this stage, the measuring frequency oscillated by the impedance meter AN is varied over the range of 1 to 100 MHz so as to measure the vector quantity $(Z, \theta)$ of the impedance of the above-described measured region of the plasma chamber CN.

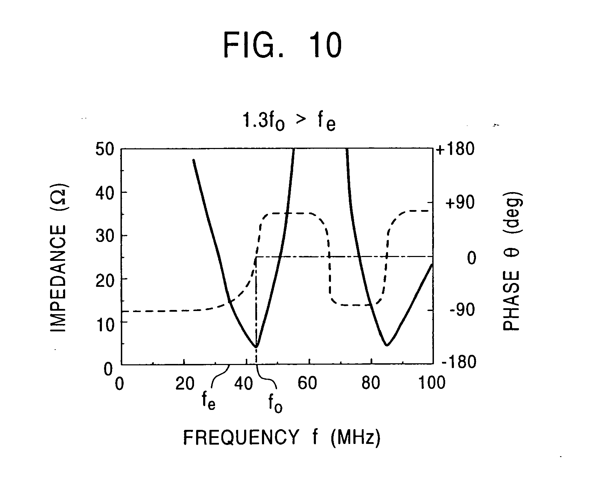

Next, as shown in Fig. 10, both impedance Z ($\Omega$) and phase $\theta$ (degree) are plotted on the ordinates of the graph having the measuring frequency f (MHz) as the abscissa. In the graph, the ordinate at the left side corresponds to impedance Z ($\Omega$) and the ordinate at the right side corresponds to phase $\theta$ (degree). Referring to the impedance characteristic curve (shown by a solid line) and the phase curve (shown by a broken line) in Fig. 5, the first series resonant frequency $f_0$ is defined as the lowest frequency among the frequencies assigned to the minima $Z_{min}$ of the impedance, i.e., the frequency assigned to a phase $\theta$ of zero when the phase $\theta$ first goes from positive to negative while the measuring frequency f is increased.

In the thus determined first series resonant frequency $f_0$, the following electrical radiofrequency factors within the above-described measured region are taken into account, as shown in Fig. 8:

Inductance $L_f$ and resistance $R_f$ of the feed plate 3;
Plasma electrode capacitance $C_e$ between the plasma excitation electrode 4 and the susceptor electrode 8;
Inductance $L_C$ and resistance $R_C$ of the supporting tube 12B of the susceptor shield 12;
Inductance $L_B$ and resistance $R_B$ of the bellows 11;
Inductance $L_A$ and resistance $R_A$ of the chamber wall 10;
Capacitance $C_A$ between the gas feeding tube 17 and the plasma excitation electrode 4 via the insulator 17a;
Capacitance $C_B$ between the plasma excitation electrode 4 and the chassis 21; and
Capacitance $C_C$ between the plasma excitation electrode 4 and the chamber wall 10.

These electrical radiofrequency factors are arranged in the same manner as in the circuit for generating plasma using radiofrequency current so as to form an equivalent circuit shown in Fig. 9. In this equivalent circuit, the inductance $L_f$ and resistance $R_f$ of the feed plate 3, the plasma electrode capacitance $C_e$ between the plasma excitation electrode 4 and the susceptor electrode 8, the inductance $L_C$ and resistance $R_C$ of the supporting tube 12B of the susceptor shield 12, the inductance $L_B$ and resistance $R_B$ of the bellows 11, and the inductance $L_A$ and resistance $R_A$ of the chamber wall 10 are connected in series in that order. The resistance $R_A$ is grounded. The equivalent circuit further includes the capacitance $C_A$, the capacitance $C_B$, and the capacitance $C_C$, connected in parallel between the resistance $R_f$ and the plasma electrode capacitance $C_e$ and each grounded at one end thereof. By determining the impedance characteristics of this equivalent circuit, the first series resonant frequency $f_0$ of this embodiment can be defined.

It is arranged that the first series resonant frequency $f_0$ is so set that 1.3 times the first series resonant frequency $f_0$ is larger than the power frequency $f_e$ supplied from the radio frequency generator 1.

Examples of methods for adjusting and setting the first series resonant frequency $f_0$ are as follows:

(1) Adjusting the shape and the length of the feed plate 3;
(2) Adjusting the overlapping area of the plasma excitation electrode 4 and the chamber wall 10;
(3) Increasing the thickness of the insulating material disposed between the plasma excitation electrode 4 and the chamber wall 10; and
(4) Adjusting the susceptor electrode 8 and the chamber wall 10, such as connecting them with a conductor.

For example, in the plasma processing apparatus of this embodiment, the power frequency $f_e$ is set to 40.68 MHz and the impedance Z ($\Omega$) and the phase $\theta$ (deg) relative to the measuring frequency f (MHz) ranging from 1 to 100 MHz are measured to give an impedance characteristic curve and a phase curve, as shown in Fig. 10. The first series resonant frequency $f_0$ is then adjusted to 42.5 MHz so that relationship (3) below is satisfied.

$$1.3f_0 > f_e \qquad (3)$$

The plasma processing apparatus of this embodiment has the same advantages as the first embodiment. Furthermore, in this embodiment, the impedance measuring terminal 61 for the plasma chamber CN is connected to the output end position PR of the matching circuit 2A of the plasma chamber CN, thereby facilitating attaching a probe when the impedance characteristic of the plasma chamber CN is measured. In this manner, the operation efficiency during the measurement of the first series resonant frequency $f_0$ can be improved.

As shown in Fig. 7, the impedance measuring terminal 61 of this embodiment penetrates through the matching box 2. Alternatively, the radiofrequency generator 1 and the matching box 2 may be configured to be removable from the plasma processing apparatus during the impedance measuring, without having the impedance measuring terminal 61 penetrating the matching box 2.

Third Embodiment

A plasma processing apparatus according to a third embodiment will now be described with reference to the drawings.

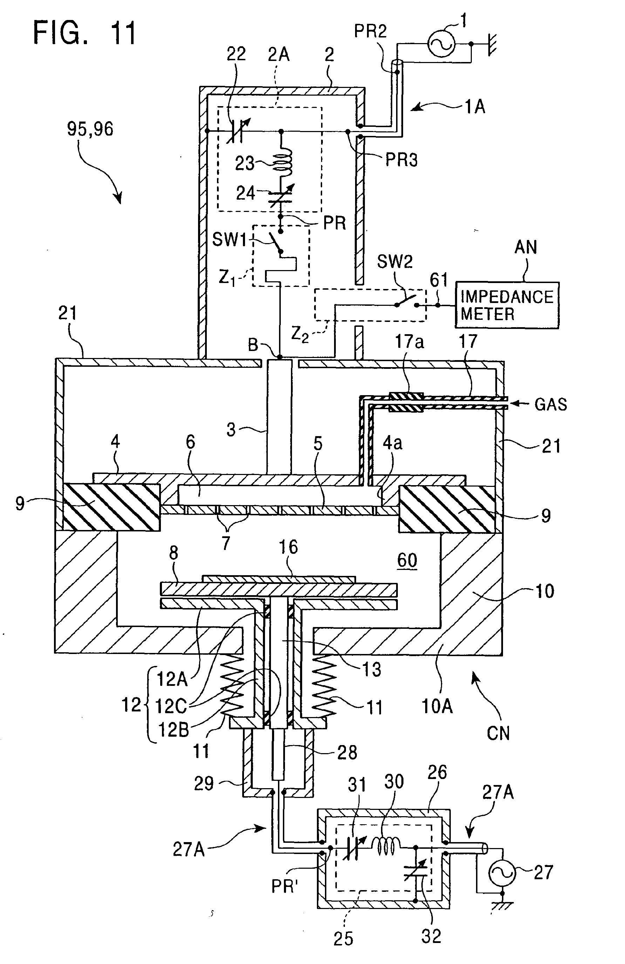

Fig. 11 is a cross-sectional view illustrating the outline structure of the plasma processing apparatus of a third embodiment.

The plasma processing apparatus of this embodiment is of a dual-frequency excitation type. The third embodiment differs from the second embodiment in the structure around the impedance measuring terminal 61 and setting of the first series resonant frequency $f_0$ and a series resonance frequency $f_0$'. The same components in the embodiments are given the same reference numerals and the explanation thereof is omitted.

In the plasma processing apparatus of the third embodiment, the first series resonant frequency $f_0$ of a plasma chamber (plasma processing chamber) CN is set larger than three times the power frequency $f_e$ supplied from a radiofrequency generator 1 to the plasma chamber CN. Meanwhile, the series resonant frequency $f_0$' defined by the capacitance $C_e$ between electrodes 4 and 8 is set larger than the product of the power frequency $f_e$ and the square root of (distance d between the electrodes/total distance $\delta$ of portions not emitting plasma).

As shown in Fig. 11, the plasma processing apparatus of this embodiment comprises switches for switching a matching circuit 2A to/from an impedance measuring terminal (resonant frequency measuring terminal) 61, the switches being disposed in the vicinity of an output end position PR of the matching circuit 2A. More specifically, a switch SW1 disposed between the matching circuit 2A and the feed plate 3 and a switch SW2 disposed between an impedance meter AN and the feed plate 3 are provided.

The switches SW1 and SW2 serve to electrically disconnect a terminal of the feed plate 3 from the impedance measuring terminal 61 while securing the electrical connection between the terminal of the feed plate 3 and the output end PR of the matching circuit 2A during plasma excitation. In contrast, during measurement of the resonant frequency of the plasma chamber CN, the switches SW1 and SW2 serve to secure the electrical connection between the terminal of the feed plate 3 and the impedance measuring terminal 61 while electrically disconnecting the feed plate 3 from the output end PR of the matching circuit 2A.

The impedance characteristics (resonant frequency characteristics) when the switches SW1 and SW2 connect the feed plate 3 and the matching circuit 2A and the impedance characteristics (resonant frequency characteristics) when the switches SW1 and SW2 connect the impedance measuring terminal 61 and the feed plate 3 are set to be equal. In other words, the impedance $Z_1$ in the vicinity of the switch SW1 and the impedance $Z_2$ in the vicinity of the switch SW2 are set to be equal, as will be described below with reference to Fig. 11.

To be more specific, the resonant frequency characteristics measured at the position of the output end PR of the matching circuit 2A when the switches 1 and 2 electrically disconnect the terminal of the feed plate 3 from the impedance measuring terminal 61 while securing the electrical connection between the terminal of the feed plate 3 and the output end PR of the matching circuit 2A, and the resonant frequency characteristics measured at the impedance measuring terminal (resonant frequency measuring terminal) 61 when the switches SW1 and SW2 secure the electrical connection between the terminal of the feed plate 3 and the impedance measuring terminal 61 while electrically disconnecting the feed plate 3 from the output end PR of the matching circuit 2A are set to be equal to each other.

In other words, referring to Fig. 11, the impedance $Z_1$ at the output end position PR side of the matching circuit 2A, i.e., the impedance between the output end position PR and a branch point B which branches to the switch SW2, when the switch SW1 is closed to connect the matching circuit 2A while opening the switch SW2, and the impedance $Z_2$ at the impedance measuring terminal 61 side, i.e., the impedance between the impedance measuring terminal 61 and the branch point B which branches to the switch SW1, when the switch SW2 is closed to connect the impedance measuring terminal 61 while opening the switch SW1, are set to be equal to each other.

As in the second embodiment shown in Fig. 8, a detachable probe of the impedance meter AN is connected to the impedance measuring terminal 61. The detachable probe is connected to a grounded part of the plasma chamber CN, for example, a chassis 21.

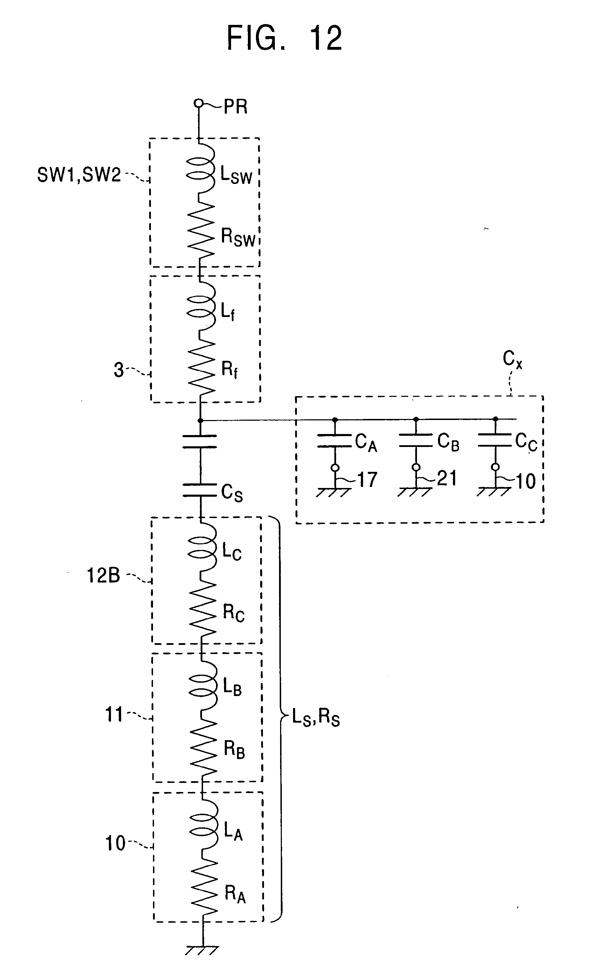

The first series resonant frequency $f_0$ of the plasma processing apparatus according to this embodiment is determined by measuring impedance characteristics as in the second embodiment, and more specifically, as shown in Figs. 11 and 12.

Fig. 12 is a circuit configuration of an equivalent circuit for measuring the impedance characteristics of the plasma processing apparatus of this embodiment shown in Fig. 11.

Having the switch SW1 closed and the switch SW2 opened, a substrate 16 is placed on a susceptor electrode 8, and radiofrequency voltage is applied to a plasma excitation electrode 4 and a susceptor electrode 8 from a first radiofrequency generator 1 and a second radiofrequency generator 27, respectively, at the same time while supplying a reaction gas to a chamber space 60 through a gas feeding tube 17 and shower holes 7 so as to generate plasma. The substrate is plasma-treated, for example, is subjected to deposition, using this plasma. At this time, a frequency power of approximately 13.56 MHz or more, more precisely, 13.56 MHz, 27.12 MHz, 40.68 MHz, or the like, is fed to the plasma excitation electrode 4 from the first radiofrequency generator 1. The second radiofrequency generator 27 may supply either power having the same frequency as the first radiofrequency generator 1 or power of a different frequency, for example, approximately 1.6 MHz.

As for the measured region of the plasma chamber CN of this embodiment, the plasma chamber CN as viewed from the impedance measuring terminal 61 is to be measured. Referring to Fig. 11, since the impedance $Z_1$ in the vicinity of the switch SW1 and the impedance $Z_2$ in the vicinity of the switch SW2 are set to be equal to each other, the thus determined measured region is the same as that viewed from the output end position PR.

In this manner, the matching circuit 2A can be separated from the measured region simply using the switch SW1, as shown in Fig. 11, in contrast to the first and second embodiments which required the circuits to be mechanically detached in order to electrically disconnect the matching circuit 2A and exclude the same from the measured region during measurement of the impedance. Thus, this embodiment simplifies measurement of the impedance characteristics of the plasma chamber CN.

The measured region of the third embodiment includes the switch SW2 which is not included in the second embodiment. Such an arrangement is made because of the contribution of the switch SW1 to the impedance characteristics, i.e., because the switch SW1 is closed during the plasma generation. When the vicinity of the switch SW2 having impedance $Z_2$ which is equal to impedance $Z_1$ in the vicinity of the switch SW1 is included in the above-described measured region, the measured region of the plasma chamber CN viewed from the impedance measuring terminal 61 can be made identical to the configuration of the circuit during the actual plasma generation, thereby improving the accuracy of the impedance measurement.

The vector quantity $(Z, \theta)$ of the impedance in relation to the above-described measured region of the plasma chamber CN is determined using a measuring frequency oscillated by the impedance meter, the measuring frequency being varied over the range of 1 MHz to 150 MHz, as in the second embodiment shown in Figs. 7 to 9, while opening the switch SW1 and closing the switch SW2. It becomes possible to measure the impedance characteristics and to define the first series resonant frequency $f_0$ simply by switching the switches SW1 and SW2 without having have to remove the matching circuit 2A from the plasma chamber CN or attach/detach the impedance-measuring probe 105 of the second embodiment shown in Fig. 8.

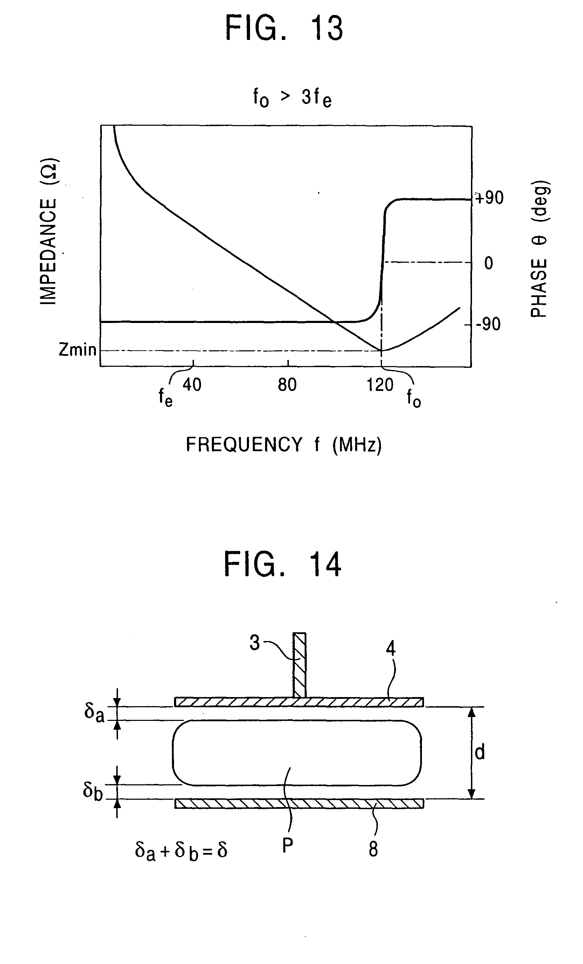

Next, as shown in Fig. 13, the impedance $Z$ $(\Omega)$ and the phase $\theta$ (deg) are plotted on the ordinates of a graph having the abscissa assigned to the measuring frequency f (MHz). In the graph, the ordinate at the left is assigned to the impedance $Z$ $(\Omega)$ and the ordinate at the right is assigned to the phase $\theta$ (deg). The first series resonant frequency $f_0$ is defined as the lowest frequency among the frequencies assigned to the minima $Z_{min}$ of the impedance in the impedance characteristics curve and the phase curve, i.e., the frequency at a phase $\theta$ of zero when the phase $\theta$ first goes from negative to positive as the measuring frequency f is increased.

In the thus determined first series resonant frequency $f_0$, the following electrical radiofrequency factors within the above-described measured region are taken into account, as shown in Fig. 12:

Inductance $L_{SW}$ and resistance $R_{SW}$ of the switch SW2;
Inductance $L_f$ and resistance $R_f$ of the feed plate 3;
Plasma electrode capacitance $C_e$ between the plasma excitation electrode 4 and the susceptor electrode 8;
Capacitance $C_s$ between the susceptor electrode 8 and a susceptor shield 12;
Inductance $L_C$ and resistance $R_C$ of a supporting tube 12B of the susceptor shield 12;
Inductance $L_B$ and resistance $R_B$ of a bellows 11;
Inductance $L_A$ and resistance $R_A$ of a chamber wall 10;
Capacitance $C_A$ between a gas feeding tube 17 and the plasma excitation electrode 4 via an insulator 17a;
Capacitance $C_B$ between the plasma excitation electrode 4 and the chassis 21; and
Capacitance $C_C$ between the plasma excitation electrode 4 and the chamber wall 10.

These electrical radiofrequency factors are arranged in the same manner as in the circuit for generating plasma using radiofrequency current so as to form an equivalent circuit shown in Fig. 12. In this equivalent circuit, the inductance $L_{SW}$ and resistance $R_{SW}$ of the switch SW2, the inductance $L_f$ and resistance $R_f$ of the feed plate 3, the plasma electrode capacitance $C_e$ between the plasma excitation electrode 4 and the susceptor electrode 8, the capacitance $C_s$ between the susceptor electrode 8 and a susceptor shield 12, the inductance $L_C$ and resistance $R_C$ of a supporting tube 12B of the susceptor shield 12, the inductance $L_B$ and resistance $R_B$ of the bellows 11, and the inductance $L_A$ and resistance $R_A$ of a chamber wall 10, are connected in series in that order, having the resistance $R_A$ grounded. The equivalent circuit further comprises capacitance $C_A$, capacitance $C_B$, and capacitance $C_C$ connected in parallel between the resistance $R_f$ and the plasma electrode capacitance $C_e$, each having one end thereof grounded. By measuring the impedance characteristics of this equivalent circuit, the first series resonant frequency $f_0$ of this embodiment can be defined.

The thus defined first series resonant frequency $f_0$ is set larger than three times the power frequency $f_e$ supplied from the radiofrequency generator 1.

Examples of methods for setting the first series resonant frequency $f_0$ are as follows:

(1) Adjusting the length (shape) of the feed plate 3;
(2) Reducing the overlapping area of the plasma excitation electrode 4 and the chamber wall 10;

(3) Increasing the thickness of the insulating material provided between the plasma excitation electrode 4 and the chamber wall 10; and

(4) Short-circuiting the susceptor shield 12 and the chamber wall 10 using a conductor.

For example, in the plasma processing apparatus of this embodiment, the power frequency $f_e$ is set to 40.68 MHz and the impedance Z ($\Omega$) and the phase $\theta$ (deg) relative to the measurement frequency f (MHz) ranging from 0 to 150 MHz are measured to give an impedance characteristic curve and a phase curve, as shown in Fig. 6. The first series resonant frequency $f_0$ is then set to 123.78 MHz so that relationship (4) below is satisfied.

$$f_0 > 3f_e \qquad (4)$$

In this embodiment, a series resonant frequency $f_0'$ defined by the plasma electrode capacitance $C_e$ between the plasma excitation electrode 4 and the susceptor electrode 8 is set larger than three times the power frequency $f_e$ described above.

$$f_0' > 3f_e \qquad (5)$$

The series resonant frequency $f_0'$ is defined from the impedance characteristic between the plasma excitation electrode 4 and the susceptor electrode 8. The impedance characteristic thereof is measured as in determining the first series resonant frequency $f_0$ described above.

To be more specific, the impedance characteristic is measured at one end of the susceptor electrode 8 having the other end grounded, and the least significant frequency among the frequencies assigned to the minima Z is defined as the series resonant frequency $f_0'$.

The series resonant frequency $f_0'$ is an radiofrequency electrical characteristic dependent on the mechanical shape of the plasma excitation electrode 4 and the susceptor electrode 8 and is in proportion to the reciprocal of the square root of the plasma electrode capacitance $C_e$ between the plasma excitation electrode 4 and the susceptor electrode 8.

By using the series resonant frequency $f_0'$, the frequency characteristic of the plasma excitation electrode 4 and the susceptor electrode 8, which directly generate a plasma, can be controlled. Consequently, power can be efficiently fed to the plasma emission space, thereby improving the power consumption efficiency and the process efficiency.

Furthermore, in this embodiment, the series resonant frequency $f_0'$ defined by plasma electrode capacitance $C_e$ between the plasma excitation electrode 4 and the susceptor

$$f_0' > \sqrt{\frac{d}{\delta}} \; f_e \qquad (1)$$

electrode 8 is set so that relationship (1) below is satisfied relative to the power frequency $f_e$.

wherein d represents the distance between the plasma excitation electrode (plasma excitation electrode) 4 and the susceptor electrode (counter electrode) 8 and $\delta$ represents the total of the distance between the plasma excitation electrode 4 and the generated plasma and the distance between the susceptor electrode 8 and the generated plasma, as will be described in detail below.

Fig. 14 is a diagram showing a state of the space between two electrodes when a plasma is being generated.

As shown in Fig. 14, the plasma excitation electrode 4 and the susceptor electrode 8 are of a parallel plate type and the distance therebetween is represented by d. The total of the distance between the plasma excitation electrode 4 and the generated plasma and the distance between the susceptor electrode 8 and the generated plasma is represented by $\delta$. In other words, distance $\delta_a$ of the plasma non-emitting portion between the plasma excitation electrode 4 and a plasma emitting region P, which can be visually recognized during plasma emission, and distance $\delta_b$ of the plasma non-emitting portion between the plasma emitting region P and the susceptor electrode 8 satisfy relationship (6) below.

$$\delta_a + \delta_b = \delta \qquad (6)$$

Herein, a model capacitance $C_0''$ between the electrodes 4 and 8 during plasma emission can be obtained from the distance d between the electrodes 4 and 8 and the total $\delta$ of the distances of the portions not emitting plasma between the electrodes 4 and 8.

The plasma emitting region P between the parallel plate electrodes 4 and 8 can be regarded as a conductor during plasma emission. Thus, the distance between the electrodes 4 and 8 can be regarded as $\delta$. Consequently, since capacitance $C_0''$ between the parallel plate electrodes 4 and 8 during plasma emission is inversely proportional to the distance between the electrodes 4 and 8, the apparent capacitance $C_0''$ during plasma emission is $d/\delta$ times the capacitance $C_0$ wherein $C_0$ is the capacitance when the plasma is not emitted.

$$C_0 \propto 1/d$$

$$C_0'' \propto 1/\delta$$

$$\therefore C_0'' \propto d/\delta \cdot C_0 \qquad (7)$$

Since the series resonant frequency $f_0'$ is proportional to the reciprocal of the square root of the capacitance $C_0$, the series resonant frequency $f_0''$ between the electrodes 4 and 8 during plasma emission is proportional to the reciprocal of the square root of the capacitance $C_0''$, i.e., proportional to the reciprocal of the square root of $d/\delta$.

$$f_0' \propto 1 / \sqrt{C_0}$$

$$f_0'' \propto 1 / \sqrt{C_0''}$$

$$\therefore f_0'' \propto \left(d / \delta\right)^{-1/2} \cdot f_0' \qquad (8)$$

The relationship between the series resonant frequency $f_0''$ between the electrodes 4 and 8 during plasma emission and the power frequency $f_e$ is set the same as the relationship between first series resonant frequency $f_0$ and power frequency $f_e$.

$$f_0'' > f_e \qquad (9)$$

Using relationship (8), relationship (9) can be rewritten as relationship (1) described above.

When the series resonant frequency $f_0'$ and the power frequency $f_e$ satisfy relationship (1), the relationship between the value of series resonant frequency $f_0''$ defined from the model capacitance $C_0''$ during plasma emission and the value of the series resonant frequency $f_0'$ defined from the capacitance between the electrodes 4 and 8 when no plasma is emitted can be optimized. By setting the value of the product of series resonant frequency $f_0'$ and the reciprocal of the square root of $d/\delta$ to be larger than the power frequency $f_e$, it becomes possible to adjust the series resonant frequency $f_0'$ between the electrodes 4 and 8 during plasma emission relative to power frequency $f_e$, thereby improving the power consumption efficiency during plasma emission.

The plasma processing apparatus of this embodiment has the following advantages in addition to the advantages similar to the first embodiment. Because the switches SW1 and SW2 are provided while an impedance meter is detachably attached to the impedance measuring terminal 61 and the impedances $Z_1$ and $Z_2$ thereof are set equal to each other, the measurement of the impedance characteristic and determining the first series resonant frequency $f_0$ can be readily performed by simply switching the switches SW1 and SW2 without having have to separate the matching circuit 2A from the plasma chamber CN. Moreover, because the impedance determined at the impedance meter AN connected to the impedance measuring terminal 61 can be considered equal to the impedance measured at the output position PR of the final output stage of the matching circuit 2A, neither correction nor reduction is necessary to yield the first series resonant frequency $f_0$. Thus, the efficiency of operation can be improved, and the measurement of the first series resonant frequency $f_0$ can be accurately carried out.

Moreover, by setting the series resonant frequency $f_0'$ and the power frequency $f_e$, the frequency characteristic of the above-described electrodes 4 and 8 for plasma emission can be controlled, voltage can be effectively applied to the plasma emission space, and the power consumption efficiency and the process efficiency can be further improved.

In this embodiment, two switches, namely, the switches SW1 and SW2, are provided. Alternatively, a single switch may be used to switch the connections as long as the impedance between the branching point to the output end position PR and the impedance between the branching point to the probe are set to be equal to each other.

Furthermore, in each of the above-described first to third embodiments, the power frequency $f_e$ and the first series resonant frequency $f_0$ are set in relation to the plasma excitation electrode 4. Alternatively, they may be set in relation to the susceptor electrode 8. In such a case, an output end position PR' of the matching circuit 25 may be set to define the region in which the impedance is measured, as shown in Figs. 7 and 11. When the impedance characteristic of the plasma chamber CN is measured from the susceptor electrode 8 side, the matching circuit 25 is removed from the plasma chamber CN at the output end position PR' which serves as a measuring point.

Moreover, in addition to the plasma processing apparatus using the parallel plate type electrodes 4 and 8, the present invention can be applied to an inductive coupled plasma (ICP) excitation type plasma processing apparatus, a radial line slot antenna (RLSA) type plasma processing apparatus, and a reactive ion etching (RIE) process apparatus.

Furthermore, the structure in which the feed panel 3 and the plasma excitation electrode 4 are combined or the structure in which the matching circuit 2A is directly connected to the electrode may also be employed. In such a case, the above-described measured region starts from the output end PR of the matching circuit 2A

Also, target materials may be provided instead of the electrodes 4 and 8 so as to perform a plasma process such as sputtering.

Next, an embodiment of a performance validation system of the plasma processing apparatus according to the present invention will be described with reference to the drawings. Hereinafter, the person who distributes and maintains the plasma processing apparatus is referred to as "maintenance engineer".

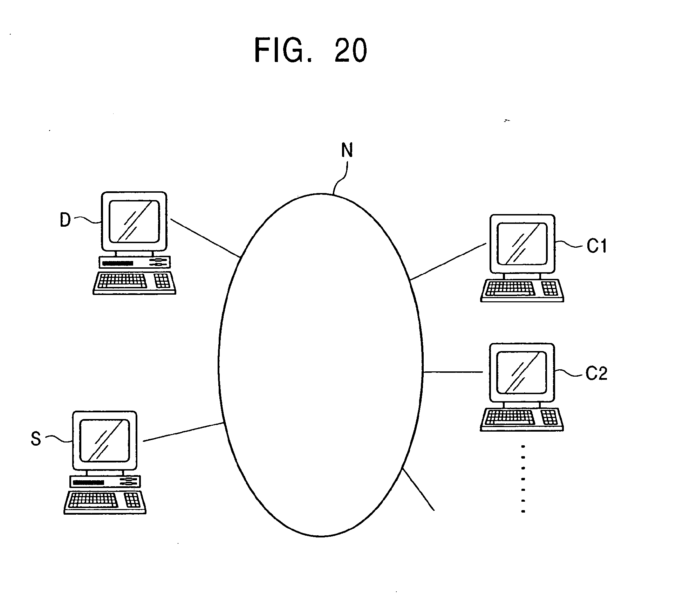

Fig. 20 is a diagram illustrating the configuration of a performance validation system of the plasma processing apparatus according to the present invention.

Referring to Fig. 20, the performance validation system comprises a customer's terminal (client terminal) C1, an engineer's terminal (client terminal) C2, a server computer (hereinafter simply referred to as "server") S which functions as operational performance information providing means, a database computer (hereinafter simply referred to as "database") D which stores information, and a public line N. The customer's terminal C1 and the engineer's terminal C2, the server S, and the database D are linked to one another via the public line N.

The terminals C1 and C2 have a function to communicate with the server S using a commonly-used internet communication protocol, such as TCP/IP or the like. The customer's terminal C1 serves as a customer-side information terminal for validating, via the public line N, the state of the performance of the plasma chamber CN which the customer purchased from the maintenance engineer. The customer's terminal C1 also has a function to access an information web page which is a "plasma chamber CN performance information page" stored in the server S. The engineer's terminal C2 which allows the maintenance engineer to upload "first series resonant frequency $f_0$ information" which partially constitutes the "performance information" and to receive e-mails sent from the customer through the customer's terminal C1.

Communication with the server S is achieved through a modem when the public line N is an analog line or through a dedicated terminal adapter or the like when the public line N is a digital line such as an integrated services digital network (ISDN).

The server S is a computer that provides performance information. The server S transmits the performance information to the customer's terminal C1 using an internet communication protocol upon request from the customer's terminal C1 requesting the display of the information. Herein, each of the customers who purchased the plasma chambers receives an "access password" for accessing the performance information when the plasma processing apparatus is delivered to the customer from the maintenance engineer. The password is required when the customer wishes to access operation and maintenance information which is part of the performance information, and the server S sends the operation and maintenance information to the customer's terminal C1 only when a registered access password is provided.

The above-described "performance information", details of which will be described in a later section, comprises information regarding models of the plasma processing apparatus available from the maintenance engineer, information regarding quality/performance of each model in the form of specifications, information regarding parameters indicative of quality/performance of specific apparatuses delivered to customers, and information regarding parameters and maintenance history.

The latter two types of information among the information described above, i.e., the information regarding quality/performance of specific apparatuses and the information regarding parameters and maintenance history, are accessible only from the customers provided with access passwords.

The performance information described above is provided in the form of "operation and maintenance information" and "standard performance information". The operation and maintenance information is a type of information provided from the maintenance engineer or the customer to the server S to indicate the actual state of operation and maintenance. The standard performance information is a type of information stored in the database D and serves as a catalog accessible from potential customers. The "standard performance information" is an objective description regarding the performance of the plasma processing carried out in the plasma chamber CN and allows prediction of the deposition state when deposition processes such as plasma-enhanced CVD and sputtering processes are concerned.

In this embodiment, all the information included in the standard performance information is stored in the database D.

Upon the request from the customer's terminal C1 requesting display of "performance information", the server S retrieves the necessary "standard performance information" from the database D and sends the information to the customer's terminal C1 of the customer in the form of a performance information page. When a customer sends a request to access the "performance information" along with the access password of the customer, the server S retrieves the necessary standard performance information from the database D as described above, constructs the performance information by combining the thus retrieved information and the operation and maintenance information provided from the maintenance engineer through the engineer's terminal C2, and sends the performance information page containing this information to the customer's terminal C1 of the customer.

The database D stores the "standard performance information", which is part of the "performance information", according to the models of the plasma chambers CN, reads out the "standard performance information" in response to a search request sent from the server S, and transfers the retrieved information to the server S. Although only one server S is illustrated in Fig. 20, a plurality of servers are provided in this embodiment. In this respect, it is useful to store general purpose "standard performance information" in the database D instead of these servers in order for the information to be shared among the plurality of servers managed by maintenance engineers from a plurality of locations.

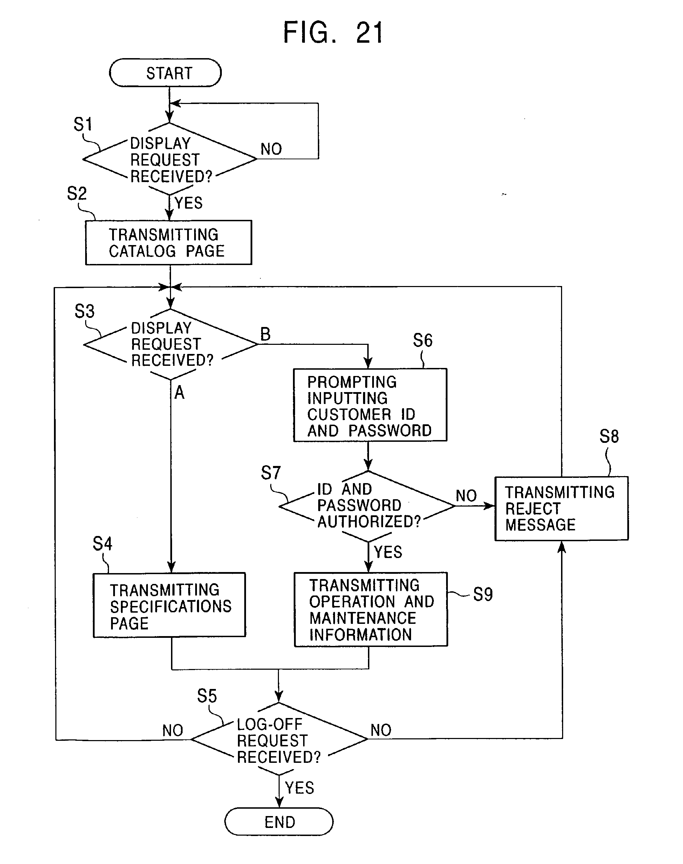

Next, an operation of the thus-configured performance validation system of the plasma chamber CN will be explained in detail with reference to the flowchart shown in Fig. 21. The flowchart illustrates the process of providing the "performance information" at the server S.

Generally, the maintenance engineer presents, as a reference for purchase, the "standard performance information" among the "performance information" of a model of plasma chamber CN which the maintenance engineer is attempting to sell to the customer. The customer is able to understand the performance of the plasma chamber CN and possible plasma processes using the plasma chamber CN through this "standard performance information".

Also, the maintenance engineer presents, to the customer who purchased and received the plasma chamber CN, the "operation and maintenance information" of the purchased apparatus among the "performance information" as operating parameters as well as the "standard performance information" which serves as the reference during the operation. The customer, i.e., the user of the plasma chamber CN, may validate the operation of his/her plasma chamber CN by comparing the "standard performance information" and the "operation and maintenance information" so as to determine whether it is necessary to perform maintenance and to be informed of the state of the plasma processing.

For example, the customer who is considering purchasing a new plasma chamber CN from the maintenance engineer may access the server S to easily check the "standard performance information" of the plasma chamber CN the customer is intending to purchase as follows.

When the customer accesses the server S, a request for access is first sent from the customer's terminal C1 to the server S based on an IP address of the server S set in advance.

Upon receiving the request for access (Step S1), the server S transfers a catalog page CP to the customer's terminal C1 (Step S2).

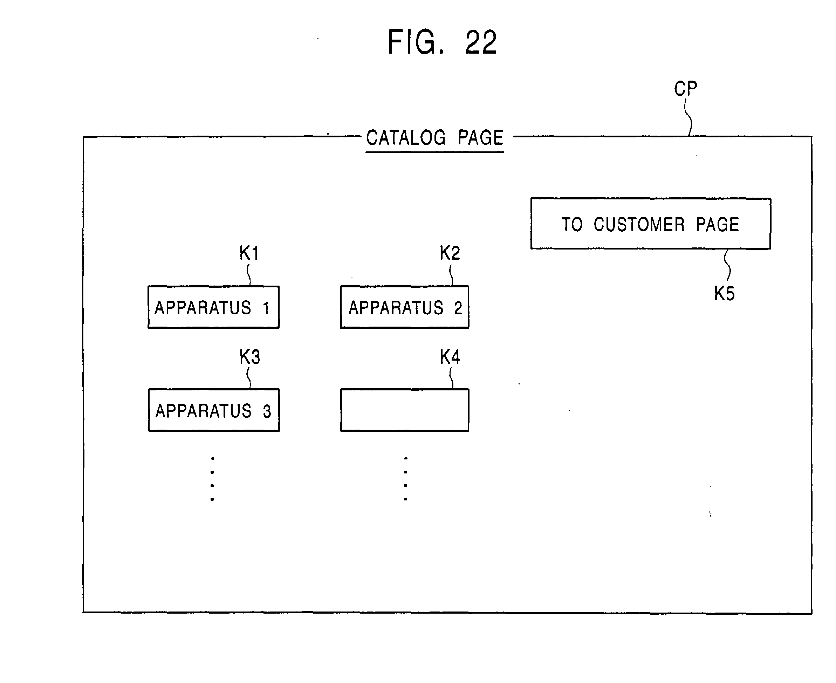

Fig. 22 shows an example of the catalog page (main page) CP sent from the server S to the customer's terminal C1 through the steps described above. The catalog page CP comprises model selection buttons K1 to K4 for displaying the "standard performance information" among the "performance information" according to models available from the maintenance engineer and a user button K5 for requesting the display of a customer page exclusive to the customer to whom the maintenance engineer delivered the plasma chamber CN.

For example, a customer may select one of the model selection buttons K1 to K4 by a pointing device (for example, a mouse) of the customer's terminal C1 so as to specify which model of the plasma chamber CN the customer desires to obtain the information about. Such a selection is regarded as the request for accessing the "standard performance information" among the "performance information", and a request to that effect is sent to the server S.

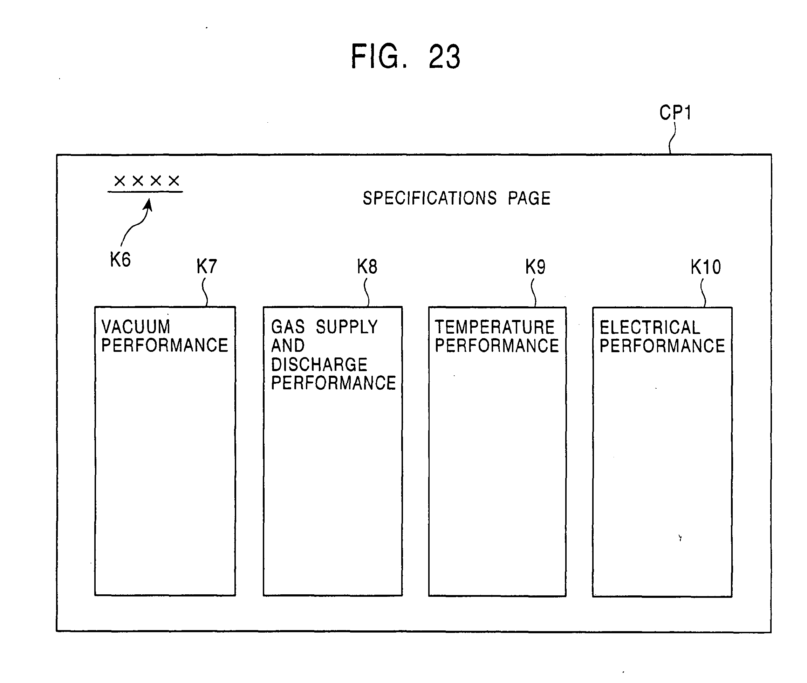

Upon receipt of the request (Step S3), the server S sends the customer's terminal C1 a subpage containing the requested information regarding the selected model. That is, when display of "standard performance information" is requested specifying a model (A), the server S retrieves data such as "vacuum performance", "gas supply/discharge property", "temperature performance", "electrical performance of the plasma processing chamber", and the like from the database D and sends the customer's terminal C1 a specifications page CP1 shown in Fig. 23 containing these data.

As shown in Fig. 23, the specifications page CP1 comprises an apparatus model section K6 indicating the selected model of the apparatus, a vacuum performance section K7, a gas supply/discharge performance section K8, a temperature performance section K9, and an electrical performance section K10 indicating the electrical performance of the plasma processing chamber. These constitute the "standard performance information" of the selected model and each contains the following descriptions.

The vacuum performance section K7 contains
ultimate degree of vacuum: $1 \times 10^{-4}$ Pa or less; and
operational pressure: 30 to 300 Pa.
The a gas supply/discharge performance section K8 contains
maximum gas flow rates:

$$SiH_4 \quad\quad 100\ \text{SCCM},$$
$$NH_3 \quad\quad 500\ \text{SCCM},$$
$$N_2 \quad\quad 2{,}000\ \text{SCCM; and}$$

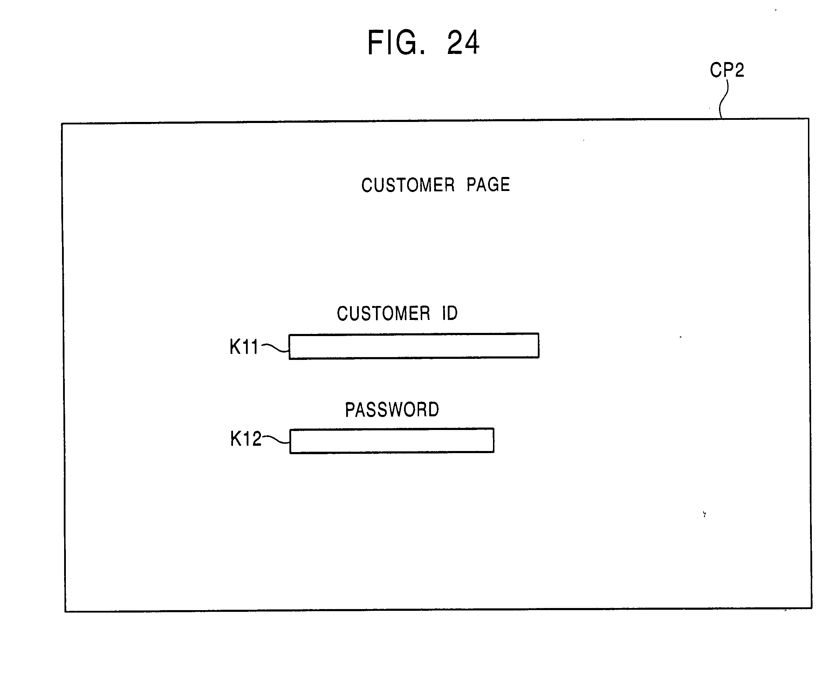

discharge property: 20 Pa or less in a flow of 500 SCCM.
The temperature performance section K9 contains
heater temperature: 200 to 350 $\pm$10°C; and
chamber temperature: 60 to 80 $\pm$2.0°C.
Herein, the SCCM (standard cubic centimeters per minute) values represent the corrected gas flow rate at standard conditions (0°C and 1,013 hPa) and the unit thereof is $cm^3$/min.
In the electrical performance section K10, a value of the first series resonant frequency $f_0$ described in the first to third embodiment above and the relationship between the setting range of the first series resonant frequency $f_0$ and the power frequency $f_e$ are described. In addition to these, values such as resistance $R_e$ and reactance $X_e$ of the plasma chamber CN at the power frequency $f_e$, plasma capacitance $C_0$ between the plasma excitation electrode 4 and the susceptor electrode 8, loss capacitance $C_x$ between the plasma excitation electrode 4 and each of the components which serve as ground potential of the plasma chamber, and the like are included in the description. Furthermore, in the specification page CP1, a performance guarantee statement such as "we guarantee that each of the parameters is within the range of settings described in this page at the time of delivery of the plasma chamber" is included.
In this manner, the overall radiofrequency electrical characteristics of the plasma chamber CN can be presented to a potential purchaser as a novel reference which has never been considered before. The performance information can be printed out at the customer's terminal C1 or the engineer's terminal C2 to make a hard copy thereof so that the information can be presented in the form of a catalog or specifications describing the performance information containing the above-described detailed information. When settings of the first series resonant frequency $f_0$, resistance $R_e$, reactance $X_e$, capacitances $C_0$, $C_x$ and the like, and the performance guarantee statement are presented to a potential purchaser through a terminal such as customer's terminal C1, through a catalog, or through a specification, the potential purchaser may judge the performance of the plasma chamber just as if he/she is examining electrical components and may then purchase the plasma chamber CN from the maintenance engineer based on that judgement.
After the server S completes the transmission of the above-described subpage to the customer's terminal C1, the server S waits for the request for the display of another subpage if a log-off request from the customer's terminal C1 is not received (Step S5). If a log-off request from the customer's terminal C1 is received by the server S, the server S terminates the interaction with the customer's terminal C1.
The customer who purchased and obtained the plasma chamber CN from the maintenance engineer can easily check the "performance information" of the specific plasma chamber that the customer purchased by accessing the server as below.
When the customer and the maintenance engineer exchange a sales contract, a customer ID, which is assigned to the individual customer and corresponds to a model number of the purchased plasma chamber CN, and a "customer password (access password)" for accessing the "operation and maintenance information" of that plasma chamber CN are given to the individual customer by the maintenance engineer. The server S sends the "operation and maintenance information" to the customer's terminal C1 only when the registered access password is provided.
A customer who wishes to access the information selects the user button K5 in the above-described catalog page CP and sends the request for the display of a customer page to the server S.
Upon receiving the request for the display (Step S3-B), the server S sends a subpage prompting the customer to input his/her "access password" (Step S6). Fig. 24 is an illustration of a customer page CP2. The customer page CP2 comprises a customer ID input field K11 and a password input field K12.
The customer page CP2 prompting the customer to input is displayed at the customer's terminal C1. In response to the prompt, the customer enters the "access password" and the "customer ID", which are provided from the maintenance engineer, through the customer's terminal C1 so as to allow the server S to identify the specific plasma chamber CN.
At this stage, the customer enters the customer ID into the customer ID input field K11 and the access password into the password input field K12. The server S sends the "operation and maintenance information" subpage previously associated to that "access password" to the customer's terminal C1 (Step S9), only when the server S receives the registered "customer ID" and the "access password" from the customer's terminal C1 (Step S7).

In other words, the "operation and maintenance information" is accessible only by the specific customer who exchanged the sales contract for the above-described plasma chamber CN, i.e., who is in possession of the registered "access password". A third party using the server S cannot access the "operation and maintenance information". Although the maintenance engineer often exchanges sales contracts with a plurality of customers simultaneously and delivers a plurality of plasma chambers CN for these customers simultaneously, each of the customers is provided with an "access password" unique to the customer and the plasma chamber CN and is capable of individually accessing the "operation and maintenance information" associated to the "access password" assigned to that customer.

Thus, it becomes possible to securely prevent confidential information regarding the purchase of the plasma chamber from being made available to other customers. Furthermore, each of the plasma chambers can be individually identified even when a plurality of plasma chambers CN are delivered at the same time. If the server S does not receive a registered "access password" (Step S7), a message refusing the access and prompting the customer to re-enter the "access password" is sent to the customer's terminal C1 (Step S8). If the customer erroneously entered the "access password", the customer may take this opportunity to re-enter a legitimate password to access the "operation and maintenance information".

When the ID and the password are verified (Step S7), the server S retrieves data corresponding to the information requested from the database D and sends it to the customer's terminal C1 in the form of a subpage. That is, when the server S receives a request from the customer's terminal C1 requesting display of the "standard performance information" and the "operation and maintenance information" of the specific plasma chamber CN identified by the customer ID, data such as "vacuum performance", "gas supply/discharge performance", "electric performance of the plasma processing chamber", and the like are retrieved from the database D by specifying the apparatus model, and a specification page (subpage) CP3 containing these data is sent to the customer's terminal C1 (Step S9).

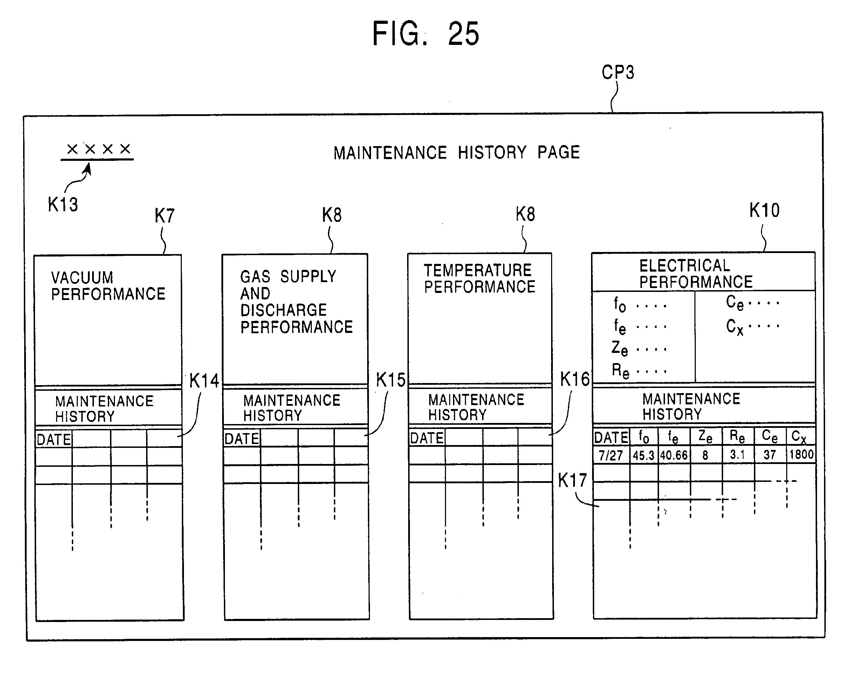

Fig. 25 is an illustration of a maintenance history page (subpage) CP3 containing "operation and maintenance information", which is sent from the server S to the customer's terminal C1. As shown in Fig. 25, the maintenance history page CP3 comprises a lot number section K13 indicating the serial number of the apparatus purchased, the vacuum performance section K7, the gas supply/discharge performance section K8, the temperature performance section K9, the electrical performance section K10, a vacuum performance maintenance section K14, a gas supply/discharge performance maintenance section K15, a temperature performance maintenance section K16, and an electrical property maintenance section K17. These constitute the "standard performance information" and the "operation and maintenance information" of the specific plasma chamber that is purchased.

An example of the description contained in the vacuum performance maintenance section K14 is as follows:
ultimate degree of vacuum: $1.3 \times 10^{-5}$ Pa or less;
operational pressure: 200 Pa.

An example of the description contained in the gas supply/discharge performance maintenance section K15 is as follows:
gas flow rates:

| | |
|---|---|
| $SiH_4$ | 40 SCCM, |
| $NH_3$ | 160 SCCM, |
| $N_2$ | 600 SCCM; and |

discharge property: $6.8 \times 10^{-7}$ Pa·m$^3$/sec.

An example of the description contained in the temperature performance maintenance section K16 is as follows:
heater temperature: $302.3 \pm 4.9$°C; and
chamber temperature: $80.1 \pm 2.1$°C.

In the electrical performance maintenance section K17, the measured value of the first series resonant frequency $f_0$ and the relationship with the power frequency $f_e$ are described. The electrical property maintenance section K17 further includes readings of the resistance $R_e$ and reactance $X_e$ of the plasma chamber CN at a power frequency $f_e$, the plasma capacitance $C_0$ between the plasma excitation electrode 4 and the susceptor electrode 8, the loss capacitance $C_X$ between the plasma excitation electrode 4 and each of the portions which serve as the ground potential of the plasma chamber.

Each of the sections K14 to K17 of the maintenance history keeps the actual readings of these parameters and the date they are measured. The maintenance engineer or the customer regularly and sequentially uploads, to the server S, the "operation and maintenance information" of the individual plasma chambers according to the amount of time elapsed since the delivery of the chamber. Upon receiving the "operation and maintenance information", the server S sequentially registers the data. The day the information is uploaded to the server S is defined as the "registration date".

The server S also retrieves the "performance information" including such data as "vacuum performance", "gas supply/discharge performance", "temperature performance", "electrical performance of the plasma processing chamber", and the like from the database D, and combines the retrieved information with the "operation and maintenance information" so as to make the maintenance history page CP3. In this manner, the customer can browse the "operation and maintenance information" and the "standard performance information" at the same time and compare the "operation standard information" which serves as the reference during use and the "operation and maintenance information" which serves as parameters indicating the actual operational state. In this manner the customer better understands the present state of the plasma process, can readily validate the operation of the plasma chamber CN, and can determine whether maintenance is necessary.

If a log-off request from the customer's terminal C1 is not received by the server S after the completion of the transmission of the above-described subpage CP3 to the customer's terminal C1, the server S sends the customer's terminal C1 a message refusing the connection (Step S8) and prompting the customer to re-enter the "access password" or waits for the next request for display of another subpage (Step S3). If the server S receives a log-off request from the customer's terminal C1, then the server terminates the interaction with the customer's terminal C1.

The performance validation system of the plasma chamber CN according to this embodiment comprises: a customer-side information terminal requesting, via a public line, access to performance information indicating an operational performance state of the previously described plasma chamber CN of the present invention which the customer purchased from a maintenance engineer; an engineer-side information terminal which allows the engineer to upload the performance information; and performance information providing means for providing the performance information uploaded at the engineer-side information terminal to the customer-side information terminal in response to a request from the customer-side information terminal. Because the performance information includes information regarding first series resonant frequency $f_0$, the standard performance information, and the operation and maintenance information of the plasma chamber CN, and is presentable to customers as a catalog or specification when outputted or through public lines and information terminals, it becomes possible to provide the customer with information necessary for making decisions to purchase the plasma chamber CN or to readily present the customer who purchased the plasma chamber CN with the information regarding operational performances and maintenance information of the purchased plasma chamber.

Moreover, because the performance information includes the first series resonant frequency $f_0$ as a performance parameter, the customer can estimate the performance of the plasma chamber CN, thus allowing him/her to make proper decisions at the time of purchase. Furthermore, the performance information can be output as a catalog or a specifications.

EXAMPLES

In the following examples, the first series resonant frequency $f_0$ was varied so as to examine changes in layer characteristics during the deposition process.

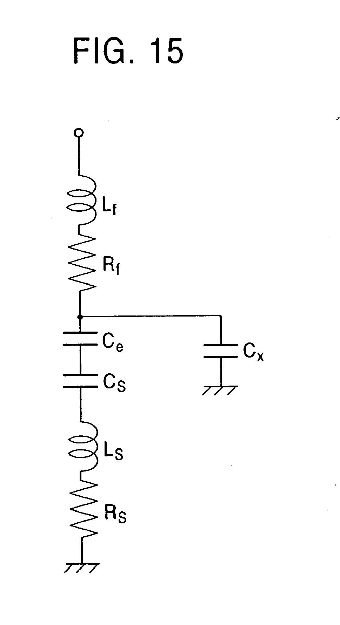

The plasma processing apparatus used was of a dual-frequency excitation type. The plasma processing apparatus had radiofrequency electrical characteristics identical to those of the equivalent circuit shown in Fig. 15. The inductance $L_x$ was a combination of the inductance $L_C$ of the shaft 13, the inductance $L_B$ of the bellows 11, and inductance $L_A$ of the chamber wall 10 shown in Fig. 12. The resistance $R_S$ was a combination of the resistance $R_C$ of the shaft 13, the resistance $R_B$ of the bellows 11, and the resistance $R_A$ of the chamber wall 10 shown in Fig. 12. The capacitance $C_X$ was a combination of the capacitance $C_A$ between the gas feeding tube 17 and the plasma excitation electrode 4 via the insulator 17a, the capacitance $C_B$ between the plasma excitation electrode 4 and the chassis 21, and the capacitance $C_C$ between the plasma excitation electrode 4 and the chamber wall 10 shown in Fig. 12.

Comparative Example 1

In Comparative Example 1, the power frequency $f_e$ was set to 40.68 MHz and the first series resonant frequency $f_0$ was set to 11.63 MHz. Each of the factors constituting the equivalent circuit shown in Fig. 12, namely, the inductance $L_f$ and the resistance $R_f$ of the feed plate 3, the plasma electrode capacitance $C_e$ between the plasma excitation electrode 4 and the susceptor electrode 8, the capacitance $C_s$ between the susceptor electrode 8 and the susceptor shield 12 (earth), the inductance $L_S$ and the resistance $R_S$ of the shaft 13, the bellows 11, and the chamber wall 10, and the capacitance $C_X$ between the plasma excitation electrode 4 and the earth, were actually measured. The results are shown in Table 1.

Example 1

The length of the feed plate 3 of the plasma processing apparatus of Comparative Example 1 was changed so as to set the first series resonant frequency $f_0$ to 13.82 MHz, satisfying the relationship $3f_0 > f_e$.

Example 2

The feed plate 3 was further changed from Example 1, and the overlapping area of the susceptor electrode 8 and the chamber wall 10 is changed so as to set the first series resonant frequency $f_0$ to 30.01 MHz, satisfying the relationship $3f_0 > f_e$.

Example 3

The thickness of the insulator between the susceptor electrode 8 and the chamber wall 10 is increased compared to Example 2 so as to set the first series resonant frequency $f_0$ to 33.57 MHz, satisfying the relationship $1.3f_0 > f_e$.

Example 4

The feed plate 3 was removed from the plasma processing apparatus of Example 3, the tuning capacitor 24 of the matching circuit 2A was directly connected to the susceptor electrode 8, and the shield supporting plate 12A of the susceptor shield 12 and the chamber wall 10 were shortcircuited so as to set the first series resonant frequency $f_0$ to 123.78 MHz, satisfying the relationship $f_0 > 3f_e$.

It is to be noted that in all Examples, the power frequency $f_e$ is set to 40.68 MHz. The results are shown in Table 1.

Table 1

|  | Comparative Example | Example 1 | Example 2 | Example 3 | Example 4 |
|---|---|---|---|---|---|
| First series resonant frequency $f_0$ (MHz) | 11.63 | 13.82 | 30.01 | 33.57 | 123.78 |
| Inductance $L_f$ (nH) of the feed plate 3 | 184 | 130 | 92 | 92 | 2 |
| Resistance $R_f$ ($\Omega$) of the feed plate 3 | 4 | 3 | 3 | 3 | 1 |
| Capacitance $C_e$ (pF) between electrodes | 37 | 37 | 37 | 37 | 37 |
| Capacitance $C_s$ (pF) between the susceptor electrode 8 and earth | 2250 | 2250 | 2250 | 2250 | 2250 |
| Inductance $L_s$ (nH) of the chamber wall, etc. | 268 | 268 | 268 | 268 | 268 |
| Resistance $R_s$ ($\Omega$) of the chamber wall, etc. | 2 | 2 | 2 | 2 | 1 |
| Capacitance $C_s$ (pF) between the plasma excitation electrode 4 and earth | 980 | 980 | 250 | 180 | 180 |

In order to evaluate the results of Examples and Comparative Example, a $SiN_X$ layer was deposited at 800 W and 400 W. The $SiN_X$ layers were evaluated as follows.

(1) Deposition rate and planar uniformity

The process for evaluating deposition rate and planar uniformity included the following:

Step 1: Depositing a $SiN_X$ layer on a glass substrate by plasma-enhanced CVD method;
Step 2: Patterning a resist layer by photolithography;
Step 3: Dry-etching the $SiN_X$ layer using $SF_6$ and $O_2$;
Step 4: Separating the resist layer by ashing using $O_2$;
Step 5: Measuring step differences in the layer thickness using a displacement meter;
Step 6: Calculating deposition rate from the deposition time and the layer thickness; and
Step 7: Measuring the planar uniformity at 16 points on a 6-inch substrate surface.

(2) BHF etching rate

The process for evaluating the etching rates included the following:

Steps 1 and 2: Same as the above
Step 3: Immersing the substrate in a BHF solution (HF:NH$_4$F = 1:10) for one minute;
Step 4: Rinsing the substrate with deionized water, drying the substrate, and separating the resist layer using a mixture of sulfuric acid and hydrogen peroxide (H$_2$SO$_4$ + H$_2$O$_2$);
Step 5: Measuring the step differences as in Step 5 above; and
Step 6: Calculating the etching rate from the immersion time and the step differences.

(3) Isolation voltage

The process for evaluating the isolation voltage included the following:

Step 1: Depositing a chromium layer on a glass substrate by sputtering and patterning the chromium layer to make a lower electrode;
Step 2: Depositing a SiN$_X$ layer by a plasma-enhanced CVD method;
Step 3: Forming an upper electrode by the same process as in Step 1;
Step 4: Forming a contact hole for the lower electrode;
Step 5: Probing the upper and the lower electrodes to measure the current-voltage characteristic (I-V characteristic) by applying a voltage of approximately 200 V or less; and
Step 6: Defining the isolation voltage as the voltage V at 100 pA corresponding 1 μA/cm$^2$ in a 100 μm square electrode.

These results are shown in Table 2.

Table 2

|  | Comparative Example 1 | Example 1 | Example 2 | Example 3 | Example 4 |
|---|---|---|---|---|---|
| Power output | 800 | 800 | 800 | 800 | 400 |
| Deposition rate (nm/min) max-min | 30-100 | 100-450 | 100-450 | 100-550 | 100-550 |
| Planar uniformity (%) | >±10 | ~±10 | ~±10 | ±5 | ±5 |
| BHF etching rate (nm/min) | >200 | ~200 | ~200 | ~50 | ~50 |
| Isolation voltage | ~4 | ~7 | ~7 | ~9 | ~9 |

As is apparent from these results, when the relationship $3f_0 > f_e$ was satisfied, the deposition rate and the isolation voltage were improved. When the relationship $1.3f_0 > f_e$ was satisfied, not only the deposition rate and the isolation voltage but also the planar uniformity and the BHF etching rate were improved. When the relationship $f_0 > 3f_e$ was satisfied, the same layer characteristics were achieved at a power output of 400 W.
It can be concluded from the above that the performance of the plasma processing apparatus was improved by setting the first series resonant frequency $f_0$.

Fourth Embodiment

In accordance with a fourth embodiment of the present invention, a plasma processing apparatus, and a performance validation system and an inspection method thereof will now be described with reference to the drawings.

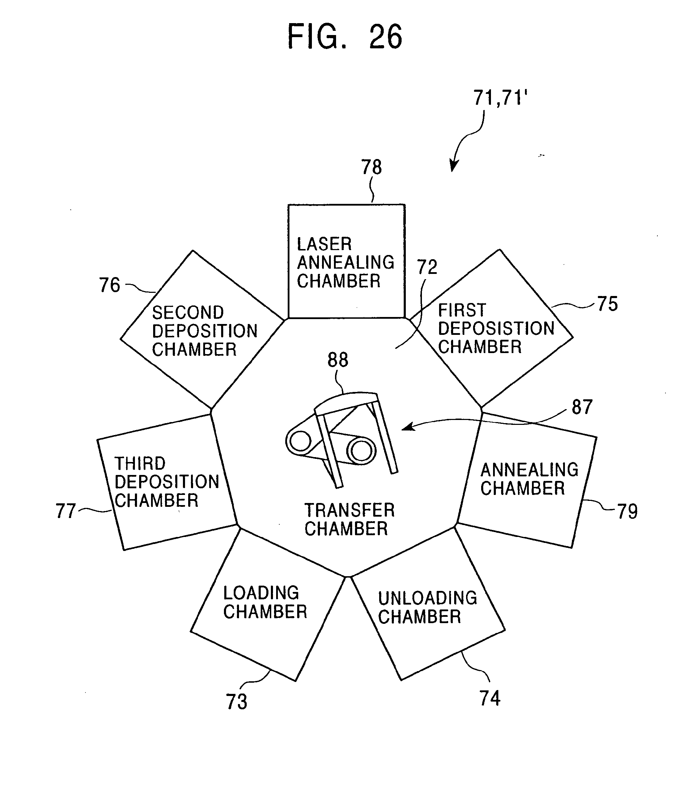

Fig. 26 illustrates an outline configuration of a plasma processing apparatus 71 according to the fourth embodiment which includes a plurality of processing chamber units suitable for consecutive processing, for example, from depositing a polysilicon film as a semiconductor active film to depositing a gate insulating film of top-gate TFTs.
In this plasma processing apparatus 71, five processing chamber units, one loading chamber 73, and one unloading chamber 74 are continuously arranged around a substantially heptagonal transfer chamber 72. The five processing chamber units are plasma processing chamber units (plasma chambers) 75, 76, and 77, i.e., a first deposition chamber 75 for depositing an amorphous silicon film, a second deposition chamber 76 for depositing a silicon oxide film, and a third deposition chamber 77 for depositing a silicon nitride film; a laser annealing chamber 78 for annealing a processed substrate after deposition, and an annealing chamber 79 for performing a heat treatment of the processed substrate.

The first, second, and third deposition chambers 75, 76, and 77 may be used for depositing different films or for performing the same treatment based on the same process recipe. Thus, these deposition chambers have substantially the same configuration. These plasma chambers 75, 76, and 77 employ first series resonant frequencies $f_0$ as radiofrequency characteristics A, and a variation, defined by relationship 10A, between the maximum frequency $A_{max}$ and the minimum frequency $A_{min}$ is set to be less than 0.1:

$$(A_{max} - A_{min})/(A_{max} + A_{min}) \qquad (10A)$$

The plasma processing chamber units (plasma chambers) according to this embodiment have the same cross-sectional configuration as that of the first embodiment shown in Figs. 1 and 2, and the description thereof is, therefore, omitted.

The configuration of the first deposition chamber 75 will be described as an example.

The definition and measuring method (see Figs. 3 to 5) of the first series resonant frequency $f_0$ as a radiofrequency characteristic A of the first deposition chamber 75 are also the same as those in the first embodiment.

In the first deposition chamber 75, a frequency three times the first series resonant frequency $f_0$ is set to be larger than the power frequency $f_e$ which is supplied from a radiofrequency generator 1.

With reference to Fig. 3, examples of methods for setting the first series resonant frequency $f_0$ are as follows:

(1) Adjusting the length of the feed plate 3;
(2) Adjusting the overlap area of the plasma excitation electrode 4 and the chamber wall 10;
(3) Adjusting the insulating material between the plasma excitation electrode 4 and the chamber wall 10; and
(4) Connecting a conductor between the susceptor electrode 8 and the chamber wall 10.

In the first deposition chamber 75 of this embodiment, the power frequency $f_e$ is set to be 40.68 MHz, and the impedance Z (Ω) and the phase θ (deg) are measured for the measurement frequency f (MHz) in the range of 0 to 100 MHz to depict an impedance characteristic curve and a phase curve, as shown in Fig. 6. The first series resonant frequency $f_0$ is then set to be 16.5 MHz so as to satisfy relationship (2):

$$3f_0 > f_e \qquad (2)$$

In the plasma processing apparatus 71 of this embodiment, the second deposition chamber 76 and the third deposition chamber 77 have substantially the same structure as that of the first deposition chamber 75. The first series resonant frequency $f_0$ as a radiofrequency characteristic A is also set for each of the second deposition chamber 76 and the third deposition chamber 77, as in the first deposition chamber 75. More specifically, in each of these deposition chambers 75 to 77, the first series resonant frequency $f_0$ is measured while the power frequency $f_e$ is set to be 40.68 MHz.

It is thought that the first series resonant frequency $f_0$ is a radiofrequency electrical characteristic which is determined by many structural factors and which is different in each apparatus.

Among the first series resonant frequency $f_{075}$ measured for the first deposition chamber 75, the first series resonant frequency $f_{076}$ measured for the second deposition chamber 76, and the first series resonant frequency $f_{077}$ measured for the third deposition chamber 77, a variation, defined by relationship (10), between the maximum frequency $f_{0max}$ and the minimum frequency $f_{0min}$ is set to be less than 0.1:

$$(f_{0max} - f_{0min})/(f_{0max} + f_{0min}) \qquad (10)$$

The variation of the first series resonant frequency $f_0$ may also be determined by methods (1) to (4) described above.

In the deposition of the amorphous silicon film, the silicon oxide film, and the silicon nitride film in the chambers 75, 76, and 77, respectively, as shown in Fig. 1, a substrate 16 to be treated is placed on a susceptor electrode 8. A radiofrequency voltage is applied to both a radiofrequency electrode 4 and the susceptor electrode 8 from a radiofrequency generator 1, while a reactive gas is supplied from a gas inlet pipe 17 into a chamber space 60 through a shower plate 6 to generate a plasma. The target film is thereby formed on the substrate 16.

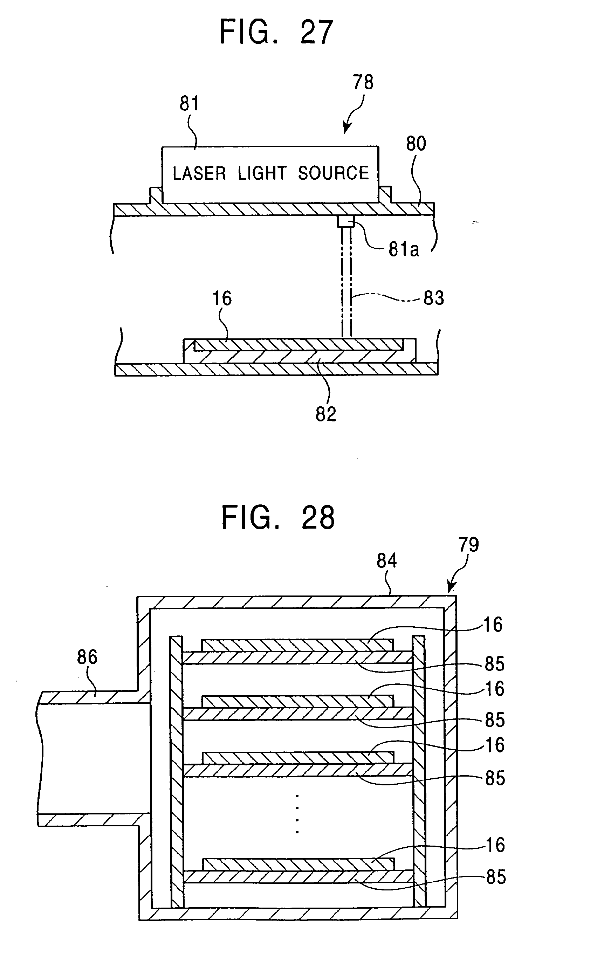

With reference to Fig. 27, the laser annealing chamber 78 is provided with a laser light source 81 on the upper wall 80 and a stage 82 for placing the substrate 16 to be treated on the bottom wall of the chamber. The stage 82 is horizontally movable in the orthogonal X and Y directions. Spot laser light 83 (shown by chain lines) is emitted from an aperture 81a of a laser light source 81, while the stage 82 supporting the substrate 16 horizontally moves in the X and Y directions so that the laser light 83 scans the entire surface of the substrate 16. Examples of the laser light sources 81 are gas lasers using halogen gases, such as XeCl, ArF, ArCl, and XeF.

The laser annealing chamber 78 may have any configuration as long as the spot laser beam from the laser light source can scan the entire surface of the substrate to be treated. Also, in this case, gas lasers using halogen gases, such as XeCl, ArF, ArCl, and XeF can be used as laser light sources. Alternatively, other laser light sources such as a YAG laser may be employed depending on the type of the film to be annealed. Laser annealing may be pulsed laser annealing or continuously oscillating laser annealing. The annealing chamber may have a configuration of, for example, a multistage electrical furnace type.

With reference to Fig. 28, the annealing chamber 79 is of a multistage electrical furnace type. In the annealing chamber 79, a plurality of substrates 16 to be treated is placed on heaters 85 which are vertically arranged in the chamber. These heaters 85 are energized to heat the substrates 16. A gate valve is provided between the annealing chamber 79 and the transfer chamber 72.

With reference to Fig. 26, the loading chamber 73 and the unloading chamber 74 are provided with a loading cassette and a unloading cassette, respectively, which are detachable from these chambers. These cassettes can contain a plurality of substrates 16, that is, the loading cassette contains substrates 16 before a deposition treatment whereas the unloading cassette contains substrates 16 after the deposition treatment. A transfer robot 87 as means for transferring the substrates 16 is placed in the transfer chamber 72 which is surrounded by the processing chamber unit, the loading chamber 73, and the unloading chamber 74. The transfer robot 87 is provided with an arm 88 thereon. The arm 88 has an expandable and shrinkable link mechanism and can rotate and move in the vertical direction. The substrate 16 is supported and transferred by the end of the arm 88.

In this plasma processing apparatus 71, the operations of each component are automatically controlled by a control section, whereas various processing conditions, such as film deposition conditions, annealing conditions, and heating conditions, and process sequences are controlled by an operator. In the operation of the plasma processing apparatus 71, untreated substrates 16 are set on the loading cassette, and are transferred from the loading cassette into each processing chamber by the transfer robot 87 based on the starting operation by the operator. After the substrates 16 are automatically and sequentially processed in each chamber, the substrates 16 are placed onto the unloading cassette by the transfer robot 87.

In the plasma processing apparatus 71 and the inspection method in this embodiment, first series resonant frequencies $f_0$ of the plasma deposition chambers 75, 76, and 77 are measured as radiofrequency characteristics at the output terminals of the matching circuits 2A. A variation between the maximum frequency $f_{0max}$ and the minimum frequency $f_{0min}$ is defined by relationship (10) as described above and is set to be less than 0.1. As a result, there are no differences in radiofrequency electrical characteristics between the deposition chambers 75, 76 and 77. The impedances of these plasma chambers 75, 76, and 77 can thereby be controlled within a predetermined range. The effective electrical power consumed in the plasma space is substantially the same in these plasma chambers 75, 76, and 77.

Accordingly, substantially the same result is achieved from a single process recipe for these different plasma chambers 75, 76, and 77. When films are formed in these plasma chambers 75, 76, and 77, these films can have substantially the same characteristics, e.g., the thickness, the isolation voltage, and the etching rate. When the variation is controlled to be less than 0.1 under the same deposition conditions in the plasma chambers 75, 76, and 77, the variation in film thickness can be controlled to be less than $\pm 5\%$.

Thus, a variation in in-plane uniformity of the substrate 16 on the plasma processing caused by the chambers 75, 76, and 77 themselves can be reduced, resulting in high thickness uniformity of the films.

In the film processing, such as plasma enhanced CVD and sputtering, the properties of the resulting films are also improved; the same insulating voltage, etching resistance against etching solutions, and hardness or density of the film are substantially obtained in the different plasma chambers 75, 76, and 77.

Here, the density of the film can be represented by an etching resistance in a buffered hydrofluoric acid (BHF) solution.

Consequently, overall radiofrequency electrical characteristics of the plasma processing apparatus 71 can be controlled, resulting in generation of a highly stable plasma. In other words, the operations of the individual plasma chambers 75, 76, and 77 of the plasma processing apparatus 71 are uniform and stable.

The above-mentioned process does not require a determination of process conditions by the relationships between enormous amounts of data on these plasma chambers 75, 76, and 77 and the results obtained by evaluation of actually processed substrates.

Thus, in installation of new systems and inspection of installed systems, the time required for obtaining substantially the same results using the same process recipe in these plasma chambers 75, 76, and 77 can be significantly reduced by measuring the first series resonant frequency $f_0$ compared with an inspection method by actual deposition onto the substrate 16 to be processed. Moreover, according to the inspection method of the present invention, the plasma processing apparatus 71 can be directly evaluated in situ in a short period of time, instead of a two-stage evaluation, i.e., processing of the substrate and confirmation and evaluation of the operation of the plasma processing apparatus 71 based on the evaluation of the processed substrate. If an inspection process by film deposition on the substrates 16 is employed in this embodiment, the plurality of plasma chambers 75, 76, and 77 can be simultaneously evaluated. In conventional methods, these plasma chambers must be independently evaluated.

Accordingly, the inspection method of this embodiment does not require a shutdown of the production line for several days to several weeks for operational checking and evaluation of the plasma processing apparatus 71. Thus, the production line has high productivity with reduced expenses for substrates used in the inspection, processing of these substrates, and labor during the inspection operations.

In each of the plasma chambers 75, 76, and 77, a frequency of three times the first series resonant frequency $f_0$ is set to be larger than the power frequency $f_e$. The overall radiofrequency electrical characteristics of these plasma chambers 75, 76, and 77 can thereby be controlled within proper ranges. Since these plasma chambers 75, 76, and 77 exhibit improved operational stability, electrical power from the radiofrequency generator 1 can be effectively introduced into the plasma space between the plasma excitation electrode 4 and the susceptor electrode 8 when the radiofrequency is higher than 13.56 MHz which is used in conventional methods. When the same frequencies as those in the conventional methods are supplied, the electrical power is more efficiently consumed in the plasma space compared with conventional plasma processing apparatuses.

As a result, the processing rate is improved by the higher-frequency plasma excitation. In other words, the deposition rate of the film is improved in the plasma enhanced CVD or the like.

With reference to Fig. 16, the impedance characteristics of the plasma chambers 75, 76, and 77 can be simultaneously measured using a fixture in which ends of a plurality of lead lines 101a to 101h having the same impedance are connected to a probe clamp 104. Since the impedance is measured by the method shown in the first embodiment with reference to Fig. 17, the description therefor is omitted in this embodiment.

In this embodiment, with reference to Fig. 1, the substrate 16 is placed at the susceptor electrode 8 in each of the plasma chambers 75, 76, and 77 to set the power frequency $f_e$ and the first series resonant frequency $f_0$ for the plasma excitation electrode 4. The substrate 16 may be placed at the plasma excitation electrode 4 side.

Fifth Embodiment

In accordance with a fifth embodiment of the present invention, the plasma processing apparatus, the plasma processing system, and the performance validation system and the inspection method thereof will now be described with reference to the drawings.

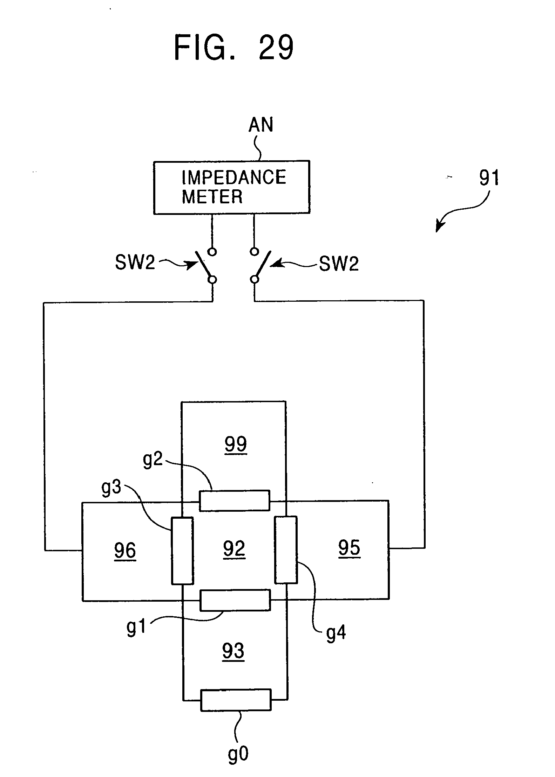

Fig. 29 is a cross-sectional view of an outline configuration of a plasma processing apparatus 91.

The plasma processing apparatus 91 has a load-lock chamber 93, an annealing chamber 99, and processing chambers 95 and 96 which are provided around a substantially square transfer chamber (waiting chamber) 92. The transfer chamber 92 contains a transfer robot for transferring substrates and has gates g1, g2, g3, and g4 at the interfaces to the chambers. The transfer chamber 92, the annealing chamber 99, and the processing chambers 95 and 96 are evacuated to high vacuum by individual high-vacuum pumps. The load-lock chamber 93 is evacuated to low vacuum by a low-vacuum pump.

The components of the plasma processing apparatus 91 of this embodiment correspond to those of the plasma processing apparatus 71 shown in Figs. 1 to 4, and 26 to 28. The transfer chamber 92 corresponds to the transfer chamber 72, the annealing chamber 99 corresponds to the annealing chamber 79, and the load-lock chamber 93 corresponds to the loading chamber 73 and the unloading chamber 74. The components having the same configurations are not described.

The processing chambers (plasma chambers) 95 and 96 have substantially the same configuration as that of the deposition chambers 75 and 76 shown in Figs. 1 to 3 and 26 in the fourth embodiment and may perform different treatments for forming different films or the same treatment using the same recipe.

As shown in Fig. 29, these processing chambers 95 and 96 are connected to an impedance meter (radiofrequency meter) AN via switches SW2. In these processing chambers 95 and 96, a variation between the maximum frequency $f_{0max}$ and the minimum frequency $f_{0min}$ among first series resonant frequencies $f_0$ is defined as follows:

$$(f_{0max} - f_{0min})/(f_{0max} + f_{0min}) \qquad (10)$$

Moreover, this variation is set to be less than 0.03.

An exemplary configuration of the processing chamber 95 will now be described.

The cross-sectional view of the processing chamber 95 corresponds to the cross-sectional view shown in Fig. 11 and is the same as that in the third embodiment. Thus, the configuration will be described with reference to Fig. 11.

The processing chamber 95 shown in Fig. 11 is of a dual-frequency excitation type and is different from the deposition chamber 75 of the fourth embodiment shown in Figs. 1 to 3 in the electrical power supply to the susceptor electrode 8 side, the configurations of a measuring terminal 61 and the vicinity thereof, and the setting of the first series resonant frequency $f_0$. The description of the other corresponding components referred to with the same reference numerals is omitted.

The first series resonant frequency $f_0$ of each of the processing chambers 95 and 96 is larger than three times the power frequency $f_e$ which is supplied from the radiofrequency generator 1 to the corresponding chamber.

With reference to Fig. 11, the processing chamber 95 of this embodiment has a susceptor shield 12 around the susceptor electrode 8. The shaft 13 and the susceptor electrode 8 are electrically isolated from the susceptor shield 12 by a gap between the susceptor shield 12 and the susceptor electrode 8 and by insulators 12C provided around the shaft 13. The insulators 12C also serve to maintain high vacuum in the chamber space 60. A bellows allows the susceptor electrode 8 and the susceptor shield 12 to vertically move so as to adjust the distance between the plasma excitation electrode 4 and the susceptor electrode 8. The susceptor electrode 8 is connected to a second radiofrequency generator 27 via a feed plate 28 coupled with the bottom of the shaft 13 and a matching circuit 25 contained in a matching box 26 at the susceptor electrode side.

The feed plate 28 is covered by a chassis 29 connected to the bottom of a supporting cylinder 12B of the susceptor shield 12 and the chassis 29 is grounded together with the matching box 26 via a shield wire of a coaxial feed line 27A. The susceptor shield 12, the chassis 29, and the matching box 26 are at the same potential.

The matching circuit 25 achieves impedance matching between the second radiofrequency generator 27 and the susceptor electrode 8. As shown in Fig. 11, the matching circuit 25 includes a tuning coil 30 and a tuning capacitor 31 which are connected as passive elements in series between the second radiofrequency generator 27 and the feed plate 28. A load capacitor 32 is connected in parallel with these passive elements. One end of the load capacitor 32 is connected to the matching box 26. The matching circuit 25 thereby has a similar configuration to that of the matching circuit 2A. The matching box 26 is grounded via a shield line of the feed line 27A and one end of the load capacitor 32 is grounded. Another tuning coil may be connected in series with the tuning coil 30, and another load capacitor may be connected in parallel with the load capacitor 32.

As shown in Fig. 11, an impedance measuring terminal 61 is connected to an output terminal position PR which is included in the region for measuring the impedance in the processing chamber 95 of this embodiment and which corresponds to an output terminal of a tuning capacitor 24 which is a passive element at the final output stage among the passive elements of the matching circuit 2A.

In the vicinity of the output terminal position PR of the matching circuit 2A, a switch SW1 is provided between the matching circuit 2A and a feed plate 3 and a switch SW2 is provided between the impedance meter AN and the feed plate 3, in order to switch between the matching circuit 2A and the impedance meter AN.

The impedance characteristic at the output terminal position PR side of the matching circuit 2A when the matching circuit 2A is connected by operation of these switches SW1 and SW2 is set to be equal to the impedance characteristic from the impedance measuring terminal 61 side when the impedance meter AN is connected by operation of these switches. That is, as shown in Fig. 11, the impedance $Z_1$ near the switch SW1 is equal to the impedance $Z_2$ near the switch SW2.

Herein, the impedance $Z_1$ is defined by a portion from the output terminal position PR of the chassis 21 to a branch point B for the switch SW2 when the switch SW1 is closed to connect the matching circuit 2A and when the switch SW2 is opened, and the impedance $Z_2$ is defined by a portion from the impedance measuring terminal 61 to the branch point B for the switch SW1 when the switch SW2 is closed to connect the impedance meter AN and when the switch SW1 is opened.

A detachable probe for the impedance meter AN is connected to the impedance measuring terminal 61.

The impedance from the impedance measuring terminal 61 to the impedance meter AN when the impedance meter AN is connected by operation of the switches SW1 and SW2 is set so that the plasma chamber 95 and the plasma chamber 96 have the same impedance. That is, the length of the coaxial cable from the impedance measuring terminal 61 to the impedance meter AN is the same in these plasma chambers.

In the plasma treatment using the processing chamber 95 of this embodiment, the switch SW1 is closed and the switch SW2 is opened. The substrate 16 is placed onto the susceptor electrode 8. A radiofrequency voltage is applied to both the plasma excitation electrode 4 and the susceptor electrode 8 through the first radiofrequency generator 1 and the second radiofrequency generator 27, respectively, while a reactive gas is fed into the chamber space 60 from the gas inlet pipe 17 through the shower plate 6 to generate a plasma. The plasma treatment such as film deposition on the substrate 16 is thereby achieved. Herein, the first radiofrequency generator 1 supplies a radiofrequency voltage of 13.56 MHz or more, for example, 13.56 MHz, 27.12 MHz, or 40.68 MHz. The second radiofrequency generator 27 supplies a radiofrequency voltage which is substantially the same as or different from that of the first radiofrequency generator 1, for example, of about 1.6 MHz.

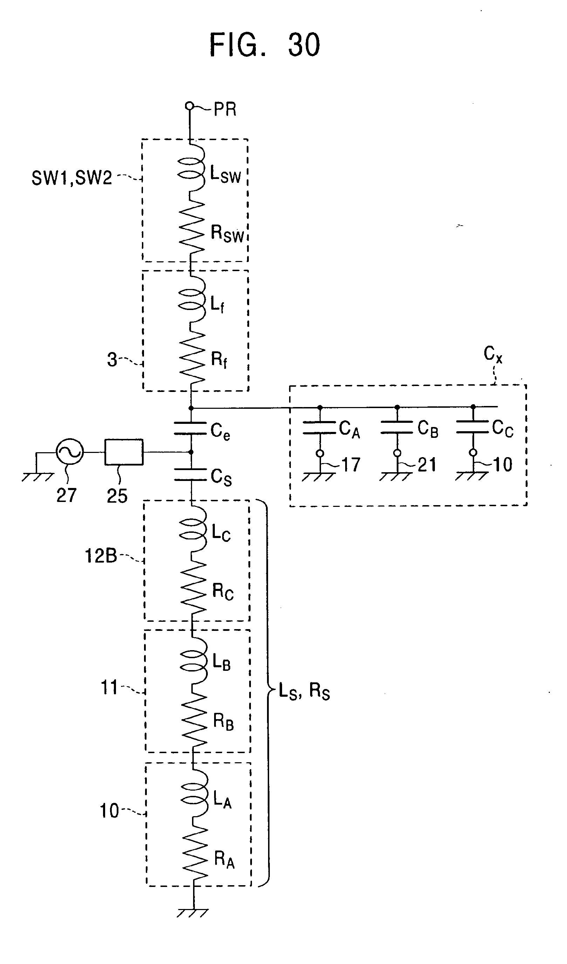

The first series resonant frequency $f_0$ as the radiofrequency characteristic A of the processing chamber 95 in this embodiment is defined by a measurement like that in the fourth embodiment, that is, as shown in Figs. 11 and 30.

Fig. 30 is an equivalent circuit diagram for measuring the impedance characteristics of the plasma processing apparatus shown in Fig. 11. In these drawings, the second radiofrequency generator 27 is depicted. This second radiofrequency generator 27 is not shown in the state in which power is supplied, but is shown in a grounded state of the matching circuit 25, because the impedance characteristics cannot be measured while supplying power.

In this embodiment, the measuring method of the impedance as a radiofrequency characteristic, and the procedure for setting the power frequency $f_e$ and the first series resonant frequency $f_0$ so as to satisfy relationship (1) described above are the same as those in the third embodiment.

In the plasma processing apparatus 91 of this embodiment, the plasma chamber 96 has substantially the same configuration as that of the processing chamber 95. Also, in the plasma chamber 96, the first series resonant frequency $f_0$ is set as in the processing chamber 95. In detail, in these plasma chambers 95 and 96, the power frequency $f_e$ is set to be 40.68 MHz to measure the first series resonant frequency $f_0$. The first series resonant frequency $f_0$, however, is a radiofrequency electrical characteristic which is determined by various factors, such as the mechanical structure. Thus, it is believed that apparatuses in use have different first series resonant frequencies $f_0$.

Between the first series resonant frequency $f_{095}$ measured for the first processing chamber 95 and the first series resonant frequency $f_{096}$ measured for the second plasma chamber 96, a variation, defined by relationship (10), between the maximum frequency $f_{0max}$ and the minimum frequency $f_{0min}$ is set to be less than 0.03:

$$(f_{0max} - f_{0min})/(f_{0max} + f_{0min}) \qquad (10)$$

The variation of the first series resonant frequency $f_0$ may also be determined by methods (1) to (4) described above.

In each of the plasma chambers 95 and 96, a impedance meter AN is connected to and disconnected from the impedance measuring terminal 61 by switching. In a nonmeasuring mode, i.e., in a plasma generation mode, the switches SW1 and SW2 are operated so that the impedance meter AN is disconnected from the impedance measuring terminal 61. The impedance meter AN is thereby not electrically affected during the plasma generation mode. Using one impedance meter AN, radiofrequency characteristics of these plasma chambers 95 and 96 can be measured. The radiofrequency characteristics A and particularly first series resonant frequencies $f_0$ of the processing chambers 95 and 96 can be readily measured by measuring the impedance by operating the switches SW1 and SW2 without disconnecting the impedance meter AN from the processing chamber 95 or 96.

In this embodiment, the processing chambers 95 and 96 have the same radiofrequency characteristic A (impedance Z) between the branch point B in the vicinity of the measuring point and the impedance meter AN. Specifically, the processing chambers 95 and 96 have the same impedance $Z_2$ from the branch point B in the vicinity of the final stage at the output side of the matching circuit 2A to the switch SW2 and the same length of coaxial cable from the switch SW2 to the impedance meter AN.

In the plasma processing apparatus 91, a gate g0 is opened to transfer the substrate 16 into the load-lock chamber 93. The gate g0 is closed to evacuate the load-lock chamber 93 by a low-vacuum pump. Gates g1 and g2 are opened to transfer the substrate 16 from the load-lock chamber 93 to the annealing chamber 99 by a transfer arm of a transfer robot in the transfer chamber 92. The gates g1 and g2 are closed to evacuate the transfer chamber 92 and the annealing chamber 99 using a high-vacuum pump. After the substrate 16 is annealed, the gates g2 and g4 are opened to transfer the annealed substrate 16 to the processing chamber 95 by the transfer arm of the transfer robot. After the substrate 16 is processed in the processing chamber 95, gates g3 and g4 are opened to transfer the substrate 16 to the plasma chamber 96 by the transfer arm of the transfer robot in the transfer chamber 92. After the substrate 16 is processed in the plasma chamber 96, the gates g1 and g3 are opened to transfer the substrate 16 to the load-lock chamber 93 by the transfer arm of the transfer robot in the transfer chamber 92.

Individual sections are automatically operated by a controller section, although the processing conditions such as film deposition conditions in these processing chambers and the processing sequence are set by an operator. In the use of this plasma processing apparatus 91, an untreated substrate 16 is placed onto a loading cassette in the load-lock chamber 93 and the operator pushes a start switch. The substrate 16 is sequentially transferred from the loading cassette to processing chambers by the transfer robot. After a series of processing steps are performed in these processing chambers, the substrate 16 is placed into the unloading (loading) cassette by the transfer robot.

In these plasma chambers 95 and 96, the substrate 16 is placed on the susceptor electrode 8, the radiofrequency generator 1 supplies a radiofrequency voltage to both the plasma excitation electrode 4 and the susceptor electrode 8 while a reactive gas is fed into the chamber space 60 from the gas inlet pipe 17 via the shower plate 6 to generate a plasma for forming an amorphous silicon film, a silicon oxide film, or a silicon nitride film on the substrate 16, as in the fourth embodiment.

The plasma processing apparatus 91 and the inspection method thereof in this embodiment exhibit substantially the same advantages as those in the fourth embodiment. Moreover, the variation of the first series resonant frequency $f_0$ in the plasma chambers 95 and 96 is set to be less than 0.03; hence, there are substantially no differences in radiofrequency electrical characteristics, such as impedance and resonant frequency, between the different plasma chambers 95 and 96. Thus, using the impedance characteristics as references, the operational states of these plasma chambers can be controlled within a predetermined range. As a result, the effective electrical power consumed in the plasma spaces in these plasma chambers 95 and 96 is substantially the same.

Accordingly, substantially the same result is achieved from a single process recipe for these different plasma chambers 95 and 96. When films are formed in these plasma chambers 95 and 96, these films can have substantially the same characteristics, e.g., the thickness, the isolation voltage, and the etching rate. When the variation is controlled to be less than 0.03 under the same deposition conditions in the plasma chambers 95 and 96, the variation in film thickness can be controlled to be less than $\pm 2\%$.

In the plasma processing apparatus 91 of this embodiment, the impedance measuring terminal 61 is provided at the output terminal position PR of the matching circuit 2A in each of the processing chambers 95 and 96, and the impedance meter AN is detachably connected to the impedance measuring terminal 61. Moreover, the matching circuit 2A is disconnected from each of the plasma chambers 95 and 96 by operating the switches SW1 and SW2 when the impedance characteristics of the plasma chambers 95 and 96 are measured, as in the fourth embodiment. Thus, the impedance characteristics of the plasma chambers 95 and 96 can be measured without disconnecting the matching circuit 2A from the power supply line. Accordingly, the impedance characteristics of the plasma chambers 95 and 96 can be readily measured, improving the processing efficiency during measuring the first series resonant frequency $f_0$.

Since the impedance $Z_1$ is equal to the impedance $Z_2$ in these plasma chambers 95 and 96, switching between the measuring mode of the impedance characteristics and the first series resonant frequency $f_0$ and the operational mode of the plasma processing apparatus can be readily performed only by operating the switches SW1 and SW2, without connecting and disconnecting the matching circuit 2A and a probe 105 for measuring the impedance shown in Fig. 16. Thus, the measurements of the first series resonant frequencies $f_0$ of these plasma chambers 95 and 96 can be efficiently performed, by operating the switches SW1 and SW2.

In addition, the radiofrequency characteristic A (impedance Z) between the branch point B near the measuring point and the impedance meter AN (including the impedance measuring terminal 61 and the switch SW2) is the same in the plasma chambers 95 and 96. Since the impedance measured by the impedance meter AN connected to each impedance measuring terminal 61 is regarded as the impedance measured at the output terminal position PR at the final stage at the output side of the matching circuit 2A in these plasma chambers 95 and 96, no correction is required for calculating the first series resonant frequency $f_0$ in each plasma chamber. Thus, the first series resonant frequency $f_0$ can be exactly measured with improved efficiency and without performing correction of the observed value.

Moreover, the first series resonant frequency $f_{0'}$ and the power frequency $f_e$ are set in each of the plasma chambers 95 and 96. Since the frequency characteristics of the electrodes 4 and 8 for generating the plasma are directly defined, electrical power can be more efficiently consumed in the plasma generating space. Accordingly, the plasma processing efficiency is further improved in the overall plasma processing apparatus 91.

In this embodiment, the two switches SW1 and SW2 are provided. Since the essential feature in this embodiment is that the impedance from the branch point B to the output terminal position PR is equal to the impedance from the branch point B to the probe, this requirement may be satisfied using one switch.

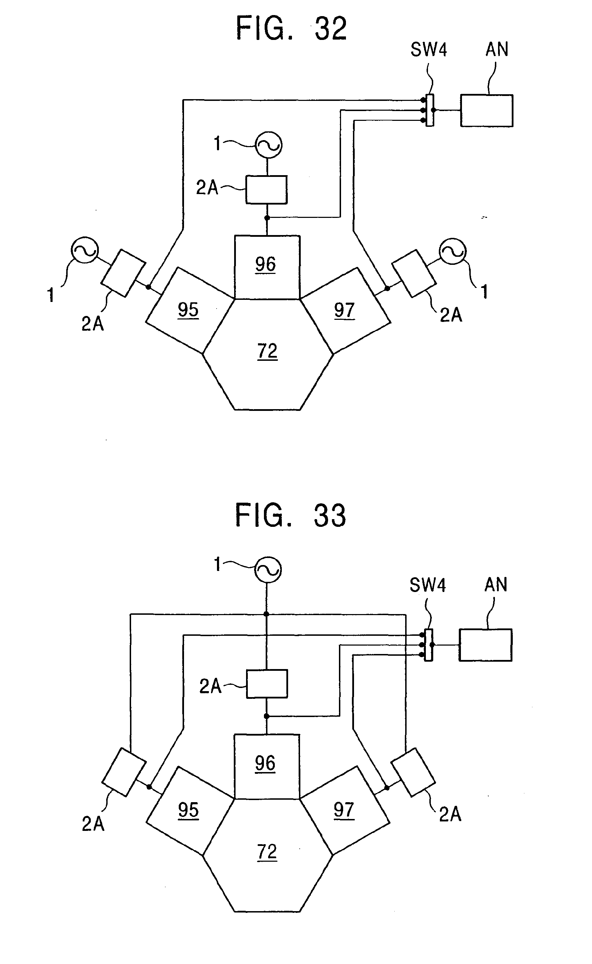

As shown in Fig. 32, instead of the switches SW2 of the plasma chambers 95 and 96, switching between the plasma chambers to be measured may be performed using a common switch SW4.

In this embodiment, the power frequency $f_e$ and the first series resonant frequency $f_0$ are set for the plasma excitation electrode 4. However, the frequencies may be set for the susceptor electrode 8, instead. In such a case, as shown in Fig. 11, an output terminal position PR' of the matching circuit 25 is defined for determining the region for measuring the impedance.

In addition to the apparatus having the parallel plate electrodes 4 and 8, this embodiment is also applicable to plasma processing apparatuses of an inductive coupled plasma (ICP) excitation type and a radial line slot antenna (RLSA) type and processing apparatuses such as a reactive ion etching apparatus and a reactive sputtering etching apparatus.

Plasma sputtering may be achieved by using a target material instead of the electrodes 4 and 8.

Sixth Embodiment

In accordance with a sixth embodiment of the present invention, the plasma processing apparatus, the plasma processing system, and the performance validation system and the inspection method thereof will now be described with reference to the drawings.

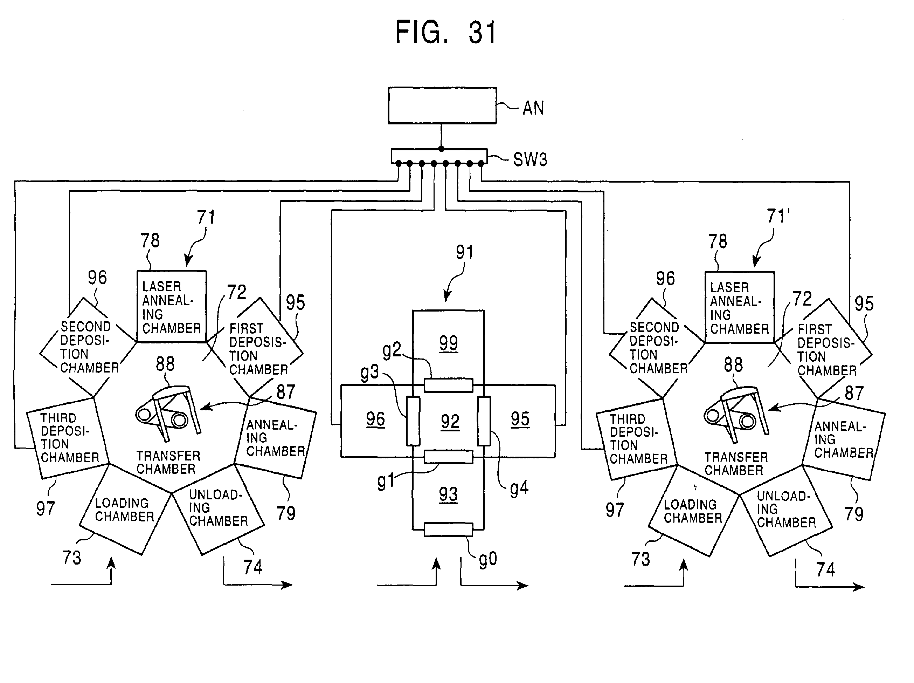

Fig. 31 is a schematic view of an outline configuration of a plasma processing system of this embodiment.

The plasma processing system of this embodiment is substantially a combination of plasma processing apparatuses 71 and 71' corresponding to that shown in Fig. 26 according to the fourth embodiment and a plasma processing apparatus 91 corresponding to that shown in Fig. 29 according to the fifth embodiment. Components having the same functions as in the fourth and fifth embodiments are referred to with the same reference numerals, and a detailed description thereof with reference to drawings has been omitted.

As shown in Fig. 31, the plasma processing system of this embodiment constitutes a part of a production line which includes the plasma processing apparatus 71, the plasma processing apparatus 91, and the plasma processing apparatus 71'. The plasma processing apparatus 71 has three dual-frequency plasma processing chamber units (plasma chambers) 95, 96, and 97 shown in Fig. 29 according to the fifth embodiment, instead of the plasma processing chamber units (plasma chambers) 75, 76, and 77 shown in Fig. 26 according to the fourth embodiment. The plasma processing apparatus 91 has two plasma processing chamber units (plasma chambers) 95 and 96. The plasma processing apparatus 71' has the three dual-frequency plasma processing chamber units (plasma chambers) 95, 96, and 97. These plasma processing chamber units (plasma chambers) 95, 96, and 97 in the plasma processing apparatuses 71, 71', and 91 have substantially the same configuration.

Impedance measuring terminals, which correspond to the impedance measuring terminal 61 shown in Fig. 11, of the plasma chambers 95, 96, and 97 are connected to an impedance meter AN via a switch SW3. In the measurement of the impedance, the switch SW3 connects only one of the plasma chambers 95, 96, and 97 to the impedance meter AN. Coaxial cables have the same length between the impedance measuring terminals of the plasma chambers 95, 96, and 97 and the switch SW3 so that the impedances from these impedance measuring terminals to the switch SW3 are the same. A detachable probe of an impedance meter AN is connected to the impedance measuring terminal, as in the fifth embodiment shown in Fig. 11.

The first series resonant frequency $f_0$ of each of the plasma chambers 95, 96, and 97 is measured as in the fifth embodiment by operating the switch SW3, and is set to be, for example, 123.78 MHz for a power frequency $f_e$ of 40.68 MHz so as to satisfy inequality (4):

$$f_0 \;>\; 3f_e \hspace{4cm} (4)$$

Among the first series resonant frequencies $f_0$ measured for the plasma chambers 95, 96, and 97, a variation, defined by relationship (10), between the maximum frequency $f_{0max}$ and the minimum frequency $f_{0min}$ is set to be less than 0.03, as in the fifth embodiment:

$$(f_{0max} \;-\; f_{0min})/(f_{0max} \;+\; f_{0min}) \hspace{2cm} (10)$$

Furthermore, in this embodiment, the series resonant frequency $f_0'$ defined by a plasma electrode capacitance $C_e$ between the plasma excitation electrode 4 and the susceptor electrode 8 is set to be larger than three times the power frequency $f_e$:

$$f_0' \;>\; 3f_e \hspace{4cm} (5)$$

In addition, the series resonant frequency $f_0'$ may be larger than the square root of the power frequency $f_e$ (= interelectrode distance d / distance $\delta$ of plasma nonemitting portion) so that the series resonant frequency $f_0'$ defined by the plasma electrode capacitance $C_e$ and the power frequency $f_e$ satisfy relationship (1), as described in the fifth embodiment.

In the plasma processing system of the present invention, for example, a substrate 16, which has been preliminarily treated, is subjected to a first film deposition treatment in the plasma chambers 95, 96, and 97 of the plasma processing apparatus 71, is annealed in the annealing chamber 79, and is annealed in the laser annealing chamber 78.

The treated substrate 16 is transferred from the plasma processing apparatus 71 and is subjected to second and third film deposition treatments in plasma processing chambers (not shown in the drawing) which are substantially the same as those of the plasma processing apparatus 71.

The substrate is transferred from this plasma processing apparatus and a photoresist is applied thereto by a photolithographic step using another apparatus (not shown).

The substrate 16 is transferred into the plasma processing apparatus 91 and is plasma-etched in the processing chambers 95 and 96. Next, the substrate 16 is transferred from the plasma processing apparatus 91 and is subjected to a film deposition treatment in a plasma chamber (not shown) which is substantially the same as the plasma processing apparatus 91.

The substrate 16 is transferred from the plasma processing apparatus not shown in the drawing. After the resist is removed, the substrate 16 is subjected to photolithographic patterning in another apparatus not shown in the drawing.

Finally, the substrate 16 is subjected to first, second, and third deposition treatments in the plasma chambers 95, 96, and 97 of the plasma processing apparatus 71', and is transferred to the subsequent step to complete the steps in the plasma processing system according to this embodiment.

The plasma processing system and the inspection method of this embodiment exhibit the same advantages as those in the fourth and fifth embodiments. Moreover, the variation between the maximum frequency $f_{0max}$ and the minimum frequency $f_{0min}$ among the first series resonant frequencies $f_0$ of the plasma chambers 95, 96, and 97 is set to be less than 0.03 so that there are no differences in radiofrequency electrical characteristics between the plasma chambers 95, 96, and 97 of the plasma processing apparatuses 71, 91, and 71'. Since the states of these plasma chambers 95, 96, and 97 can be controlled to be within a predetermined control range defined by the impedance characteristics of the overall plasma processing system. Thus, these plasma chambers 95, 96, and 97 have substantially the same plasma density.

Accordingly, substantially the same result is achieved from a single process recipe for these different plasma chambers 95, 96, and 97 in the overall plasma processing system. When films are formed in these plasma chambers 95, 96, and 97, these films can have substantially the same characteristics, e.g., the thickness, the isolation voltage, and the etching rate. When the variation is controlled to be less than 0.03 under the same deposition conditions in the plasma chambers 95, 96, and 97, the variation in film thickness can be controlled to be less than $\pm 2\%$.

Consequently, overall radiofrequency electrical characteristics of the plasma processing system can be controlled, resulting in generation of a highly stable plasma in each of the plasma chambers 95, 96, and 97. In other words, the operations of the individual plasma chambers 95, 96, and 97 of the plasma processing system are uniform and stable.

The above-mentioned process does not require a determination of the process conditions based on the relationships between enormous amounts of data for these plasma chambers 95, 96, and 97 and the results obtained by evaluation of actually processed substrates.

Thus, in installation of new systems and inspection of installed systems, the time required for obtaining substantially the same results using the same process recipe in these plasma chambers 95, 96, and 97 can be significantly reduced by measuring the first series resonant frequency $f_0$ compared with an inspection process by actual deposition onto the substrates 16 to be processed. Moreover, according to the inspection method of the present invention, the plasma processing system can be directly evaluated in situ in a short period of time, instead of a two-stage evaluation, i.e., processing of the substrate and confirmation and evaluation of the operation of the plasma processing system based on the evaluation of the processed substrate. If an inspection process by film deposition on the substrates 16 is employed in this embodiment, the plurality of plasma chambers 95, 96, and 97 can be simultaneously evaluated. In conventional methods, these plasma chambers must be independently evaluated.

Accordingly, the inspection method of this embodiment does not require a shutdown of the production line for several days to several weeks for operational checking and evaluation of the plasma processing system. Thus, the production line has high productivity and reduces the cost of substrates used in the inspection, processing of these substrates, and labor during the inspection operations.

In each of the plasma chambers 95, 96, and 97, a frequency of three times the first series resonant frequency $f_0$ is set to be larger than the power frequency $f_e$. The overall radiofrequency electrical characteristics of these plasma chambers 95, 96, and 97 can thereby be controlled within proper ranges. Since these plasma chambers 95, 96, and 97 exhibit improved operational stability, electrical power from the radiofrequency generator can be effectively introduced into the plasma space between the plasma excitation electrode 4 and the susceptor electrode 8 even if the radiofrequency is higher than 13.56 MHz, which is used in conventional methods. When the same frequencies as those in the conventional methods are supplied, the electrical power is more efficiently consumed in the plasma space compared with conventional plasma processing apparatuses.

As a result, the processing rate is improved by the higher-frequency plasma excitation. In other words, the deposition rate of the film is improved in the plasma enhanced CVD or the like. Since the generation of the plasma is stabilized in all the plasma chambers 95, 96, and 97, the individual plasma processing apparatuses 71, 91, and 71' also have high operational stability. Accordingly, the plasma processing system has high operational stability.

Thus, variation in in-plane uniformity of the substrate 16 on the plasma processing caused by the chambers 95, 96, and 97 themselves can be reduced, resulting in high thickness uniformity of the films. In the film processing, such as plasma enhanced CVD and sputtering, the properties of the resulting films are also improved; substantially the same insulating voltage, etching resistance against etching solutions, and hardness or density of the film are obtained from the different plasma chambers.

When the applied frequency is the same, the plasma density in this embodiment can be increased compared with a conventional plasma processing system. Thus, a film having a desired thickness can be deposited by reduced input electrical powder at a processing rate which is the same as that of the conventional system. Since this advantage is applicable to the plasma chambers 95, 96, and 97, the overall plasma processing system exhibits reduced electrical loss, reduced operating cost, and enhanced productivity. Since the film can be deposited in a reduced amount of time, the electrical power consumption for plasma processing can be reduced.

In the plasma processing system of this embodiment, the series resonant frequency $f_0$' and the power frequency $f_e$ are set for each plasma chamber 95, 96, or 97. Since the frequency characteristics of the electrodes 4 and 8 for emitting the plasma are directly determined, electrical power can be more efficiently supplied to the plasma space in each plasma chamber 95, 96, or 97. Thus, the plasma processing system exhibits further improved power consumption efficiency and processing efficiency.

In the plasma processing system of this embodiment, the impedance measuring terminal is provided at the output terminal position PR of the matching circuit 2A in each of the processing chambers 95, 96, and 97, and the impedance meter AN is detachably connected to the impedance measuring terminal. Moreover, the matching circuit 2A is disconnected from each of the plasma chambers 95, 96, and 97 by operating the switch SW3 when the impedance characteristics of the plasma chambers 95, 96, and 97 are measured, as in the fourth embodiment. Thus, the impedance characteristics of the plasma chambers 95, 96, and 97 can be measured without disconnecting the matching circuit 2A from the power supply line. Accordingly, the impedance and resonant frequency characteristics of the plasma chambers 95, 96, and 97 can be readily performed.

Thus, a probe can be readily connected to the impedance measuring terminal 61 when the impedance characteristics of the plasma chambers 95, 96, and 97 are measured, improving the measuring efficiency for the first series resonant frequency $f_0$. The impedance characteristics and the first series resonant frequency $f_0$ can be readily performed only by operating the switches SW1 and SW2, without disconnecting the matching circuit 2A from the plasma chambers 95, 96, and 97 and without disconnecting the probe 105 for measuring the impedance.

Moreover, as shown in Fig. 11, the impedance $Z_1$ is equal to the impedance $Z_2$ and the impedance from the impedance measuring terminal 61 to the switch SW3 (shown in Fig. 31) is equal in the plasma chambers 95, 96, and 97 of the plasma processing apparatuses 71, 71', and 91. Thus, by operating the switches SW1, SW2, and SW3, the impedance observed by the impedance meter AN connected to the impedance measuring terminal 61 can be regarded as the same as the impedance observed at the output terminal position PR at the final stage at the output side of the matching circuit 2A.

Since there are no differences in impedance characteristics from the impedance measuring terminal 61 to the switch SW3 among the plasma chambers 95, 96, and 97, no correction is required for calculation of the first series resonant frequency $f_0$ for each plasma chamber 95, 96, or 97 of the plasma processing apparatuses 71, 71', and 91. Since the observed values are not corrected, the resonant frequency characteristics of the plasma processing system can be set with high operation efficiency and the first series resonant frequency $f_0$ can be more precisely measured.

In this embodiment, the switches SW1, SW2, and SW3 may cooperate with switching of the plasma chambers 95, 96, and 97. The two switches SW1 and SW2 may be integrated into one switch in which the impedance from the branch point to the output terminal position PR is equal to the impedance from the branch point to the probe.

In this embodiment, the power frequency $f_e$ and the first series resonant frequency $f_0$ for the plasma excitation electrode 4 are set. However, the frequencies for the susceptor electrode 8 may be set, instead. In such a case, as shown in Fig. 11, an output terminal position PR' of the matching circuit 25 is determined for defining the region for measuring the impedance.

In addition to the apparatus having the parallel plate electrodes 4 and 8, this embodiment is also applicable to plasma processing apparatuses of inductive coupled plasma (ICP) excitation types and radial line slot antenna (RLSA) types and processing apparatuses such as reactive ion etching apparatuses and reactive sputtering etching apparatuses.

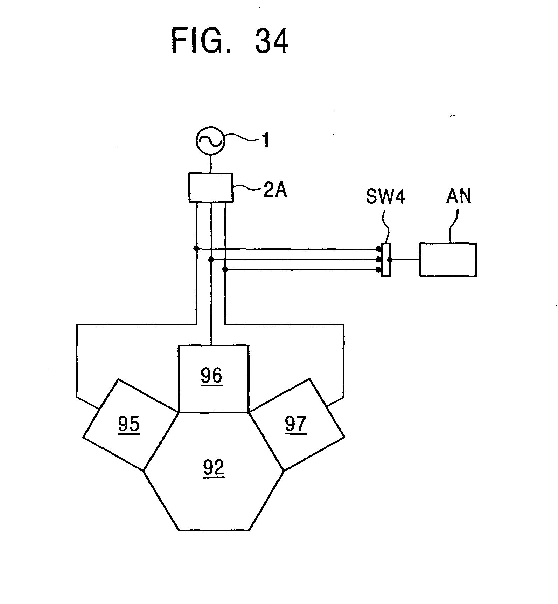

In this embodiment, as shown in Fig. 32, each of the plasma chambers (plasma processing chamber units) 95, 96, and 97 is provided with a matching circuit 2A and a radiofrequency generator, and an impedance meter AN is connected to a coupler of the matching circuit 2A via a switch SW4. As shown in Fig. 33, matching circuits 2A of the plasma chambers 95, 96, and 97 may be connected to the same radiofrequency generator 1 by switching. Alternatively, as shown in Fig. 34, the plasma chambers 95, 96, and 97 may be connected to the same matching circuit 2A by switching. In this case, as shown in Fig. 33, the impedance meter AN is connected to couplers between the plasma chambers 95, 96, and 97 and the matching circuit 2A via the switch SW4.

In this embodiment, the first series resonant frequency $f_0$ as a radiofrequency characteristic A is set according to relationship (10) described above. Alternatively, the radiofrequency characteristic A may be a resonant frequency f; or an impedance $Z_e$, a resistance $R_e$, or a reactance $X_e$ at the frequency of the radiofrequency waves, and the variation thereof may be defined by relationship (10A) described above. Since the above characteristics of these plasma chambers 95, 96, and 97 are controlled to be a predetermined range, there are no differences in radiofrequency electrical characteristics between these plasma chambers 95, 96, and 97. Thus, the effective electrical power consumed in the plasma spaces in the plasma chambers 95, 96, and 97 is substantially the same.

When the impedance $Z_e$ at the plasma excitation frequency is employed as the radiofrequency characteristic A, it is not necessary to find the dependence of the radiofrequency characteristic on the frequency in the plasma chambers 95, 96, and 97. Thus, the impedance $Z_e$ can be readily determined compared with the resonant frequency f which must be determined by the dependence of Z and θ on the frequency. Moreover, the impedance Z can directly reflect the radiofrequency electrical characteristic at the plasma excitation frequency of the plasma chambers 95, 96, and 97.

When the resistance $R_e$ or the reactance $X_e$ is employed, this can more directly reflect the radiofrequency electrical characteristic at the plasma excitation frequency of the plasma chamber compared with the impedance $Z_e$ which corresponds to the vector defined by the resistance $R_e$ and the reactance $X_e$.

Seventh Embodiment

In accordance with a seventh embodiment of the present invention, the plasma processing apparatus, the plasma processing system, and the performance validation system and the inspection method thereof will now be described with reference to the drawings.

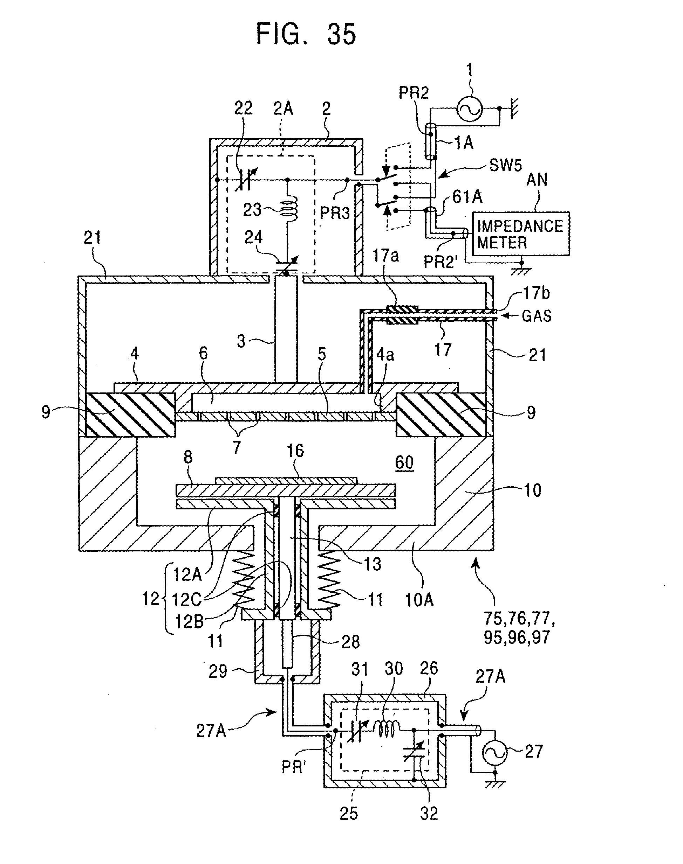

Fig. 35 is a schematic view of an outline configuration of a plasma processing unit (plasma chamber) of this embodiment.

This embodiment differs from the fourth to sixth embodiments in the region for measuring the frequency characteristics, the measuring terminal, the switches, and the plasma processing unit (plasma chamber). The configuration of the plasma processing apparatus and the configuration of the plasma processing system are the same as those according to the fourth to sixth embodiments. Components having the same functions as in the fourth to sixth embodiments are referred to with the same reference numerals, and a detailed description thereof with reference to drawings has been omitted.

In this embodiment, the plasma chamber is of a dual-frequency type, as in the second embodiment. With reference to Fig. 35, a measuring point PR3 defining the region for measuring the radiofrequency characteristic A is set at an input terminal position of a matching circuit 2A which is connected to a radiofrequency generator 1 via a radiofrequency feed line 1A in each plasma chamber 75, 76, 77, 95, 96, or 97. The measuring point PR3 for measuring the radiofrequency characteristic A of the plasma chamber is connected to a switch SW5. The switch SW5 operates the connection and disconnection of the plasma chamber to the radiofrequency generator 1 via the radiofrequency feed line 1A in a plasma generation mode and to the radiofrequency measuring meter (impedance meter AN) via a connecting line 61A in a radiofrequency measuring mode.

Here, the impedance from the measuring point PR3 to the radiofrequency generator 1 via the radiofrequency feed line 1A is equal to the impedance from the measuring point PR3 to the impedance meter AN via the connecting line 61A. In other words, the radiofrequency feed line 1A and the connecting line 61A have the same length. The radiofrequency characteristics A and particularly the first series resonant frequency $f_0$ by measuring the impedance etc., can be readily measured simply by operating the switch SW5, without disconnecting the impedance meter AN from the plasma chamber.

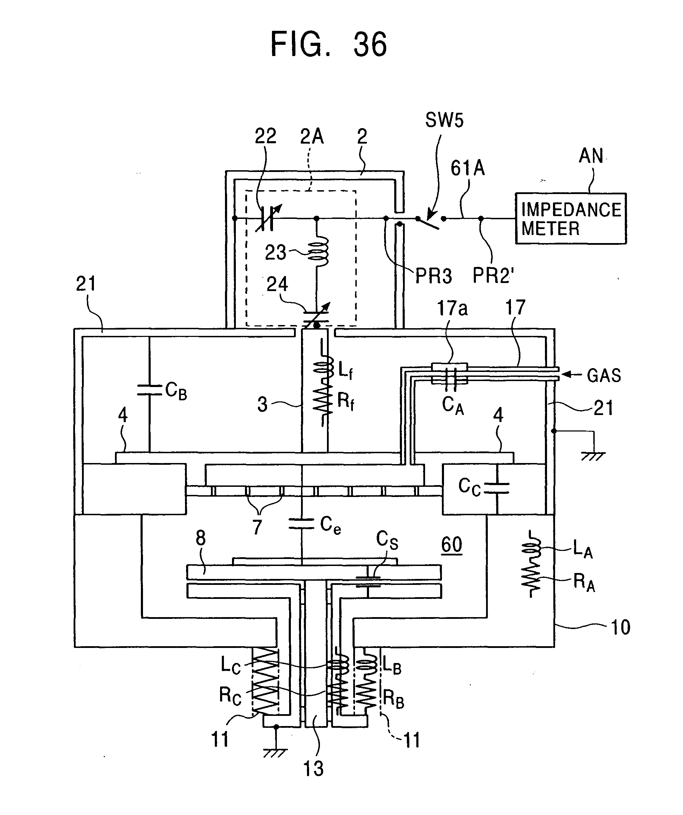

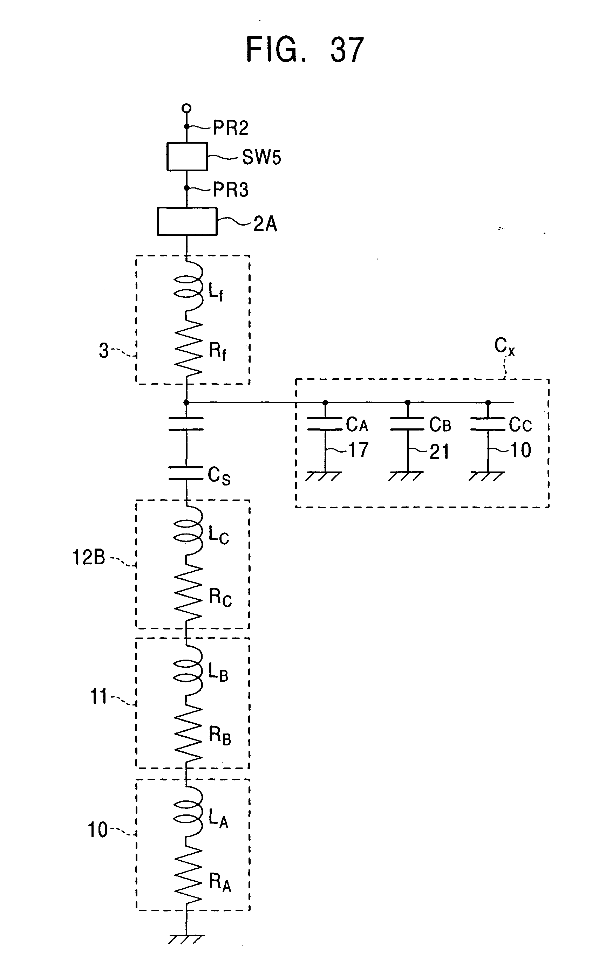

Herein, the first series resonant frequency $f_0$ as the radiofrequency characteristic A in the plasma chamber of this embodiment is defined by a measurement, as in the fourth to sixth embodiments. That is, the first series resonant frequency $f_0$ in this embodiment is defined by a measurement, as shown in Figs. 36 and 37.

Figs. 36 is a schematic view for illustrating the impedance characteristics of the plasma chamber of this embodiment. Fig. 37 is an equivalent circuit diagram of the plasma chamber shown in Fig. 36 for measuring the impedance characteristics.

As shown in Fig. 36, possible radiofrequency electrical factors affecting the first series resonant frequency $f_0$ among radiofrequency characteristics A which are measured within the above-described range are as follows:

Contribution from the connecting line 61A;
Inductance $L_{sw}$ and resistance $R_{sw}$ of the switch SW5;
Contribution from the matching circuit 2A;
Inductance $L_f$ and resistance $R_f$ of the feed plate 3;
Plasma electrode capacitance $C_e$ between the plasma excitation electrode 4 and the susceptor electrode 8;
Capacitance $C_s$ between the susceptor electrode 8 and the susceptor shield 12;
Inductance $L_c$ and resistance $R_c$ of the supporting cylinder 12B of the susceptor shield 12;

Inductance $L_B$ and resistance $R_B$ of a bellows 11;
Inductance $L_A$ and resistance $R_B$ of the chamber wall 10;
Capacitance $C_A$ between the gas inlet pipe 17 and the plasma excitation electrode 4 which sandwich an insulator 17a;
Capacitance $C_B$ between the plasma excitation electrode 4 and the chassis 21; and
Capacitance $C_C$ between the plasma excitation electrode 4 and the chamber wall 10.

It is considered that these radiofrequency electrical factors constitute a circuit which conducts a radiofrequency current supplied in a plasma emitting mode, as shown in Fig. 37. That is, in this equivalent diagram, the contribution from the connecting line 61A, the inductance $L_{sw}$ and resistance $R_{sw}$ of the switch SW5, the contribution from the matching circuit 2A, the inductance $L_f$ and resistance $R_f$ of the feed plate 3, the plasma electrode capacitance $C_e$ between the plasma excitation electrode 4 and the susceptor electrode 8, the capacitance $C_S$ between the susceptor electrode 8 and the susceptor shield 12, the inductance $L_C$ and resistance $R_C$ of the supporting cylinder 12B of the susceptor shield 12, the inductance $L_B$ and resistance $R_B$ of the bellows 11, and the inductance $L_A$ and resistance $R_B$ of the chamber wall 10 are connected in series in that order, the terminal of the resistance $R_A$ being grounded. Moreover, the capacitance $C_A$, the capacitance $C_B$, and the capacitance $C_C$ are connected in parallel between the resistance $R_f$ and the plasma electrode capacitance $C_e$, one end of each capacitance being grounded. The first series resonant frequency $f_0$ can be defined by measuring the impedance of this equivalent circuit.

The first series resonant frequency $f_0$ defined in such a manner is determined in the same way shown in the fourth to sixth embodiments. Among the first series resonant frequencies $f_0$ of the individual plasma chambers, a variation of the first series resonant frequencies $f_0$ of the plasma chambers is defined by relationship (10) using the maximum frequency $f_{0max}$ and the minimum frequency $f_{0min}$ and is set to be less than 0.03. The variation of the first series resonant frequencies $f_0$ can be set by methods (1) to (4) described above, and by the following methods (5) to (7):

(5) Selecting load capacitors 22 substantially having the same characteristics;
(6) Selecting tuning capacitors 24 substantially having the same characteristics; and
(7) Adjusting the shapes (size, number of turns, and length) of tuning coils 23.

The plasma processing apparatus or system and the inspection method of this embodiment exhibit the same advantages as those in the fourth and sixth embodiments. Moreover, by including the matching circuit 2A in the region for the radiofrequency characteristics, there are no differences in radiofrequency electrical characteristics between the plasma chambers 75, 76, 77, 95, 96, and 97, in addition to the chamber space 60. Thus, the effective electrical powers consumed in the plasma spaces in the plasma chambers 75, 76, 77, 95, 96, and 97 can be equalized. By incorporating the matching circuit 2A, the same plasma processing results are obtainable from the same process recipe.

In this embodiment, the length of the radiofrequency feed line 1A is equal to the length of the connecting line 61A. Thus, the radiofrequency characteristic A of the chamber space 60 measured at the output terminal position PR2 of the radiofrequency generator 1 when the switch SW5 electrically disconnects the measuring point PR3 from the radiofrequency measuring meter AN and electrically connects the matching circuit 2A to the radiofrequency generator 1 is equal to the radiofrequency characteristic A of the chamber space 60 measured at an output terminal position PR2' of the impedance meter AN when the switch SW5 electrically connects the measuring point PR3 to the impedance meter AN and electrically disconnects the matching circuit 2A from the radiofrequency generator 1.

Thus, in this embodiment, the measured radiofrequency characteristic is substantially the same as the radiofrequency characteristic A of the plasma chamber which is measured at the output terminal position PR2 of the radiofrequency feed line 1A connected to the radiofrequency generator 1, as shown in Figs. 35, 36, and 37. By such determination of the region for measuring the radiofrequency characteristic A, the different plasma chambers 75, 76, 77, 95, 96, and 97 exhibit substantially the same radiofrequency electrical characteristics of the chamber space 60 including the matching circuit 2A and the radiofrequency feed line 1A, compared with a case in which the region for measuring the radiofrequency characteristic A does not include the matching circuit 2A and the radiofrequency feed line 1A. Thus, these plasma chambers 75, 76, 77, 95, 96, and 97 consume substantially the same effective electrical power in the plasma spaces. Accordingly, substantially the same result is achieved from a single process recipe for these different plasma chambers, compared with a case in which the region for measuring the electric characteristic does not include the matching circuit 2A and the radiofrequency feed line 1A.

With reference to Figs. 1 and 11, the region for measuring the radiofrequency characteristics in the fourth to sixth embodiments may be set at the measuring point PR3 or the measuring point PR2.

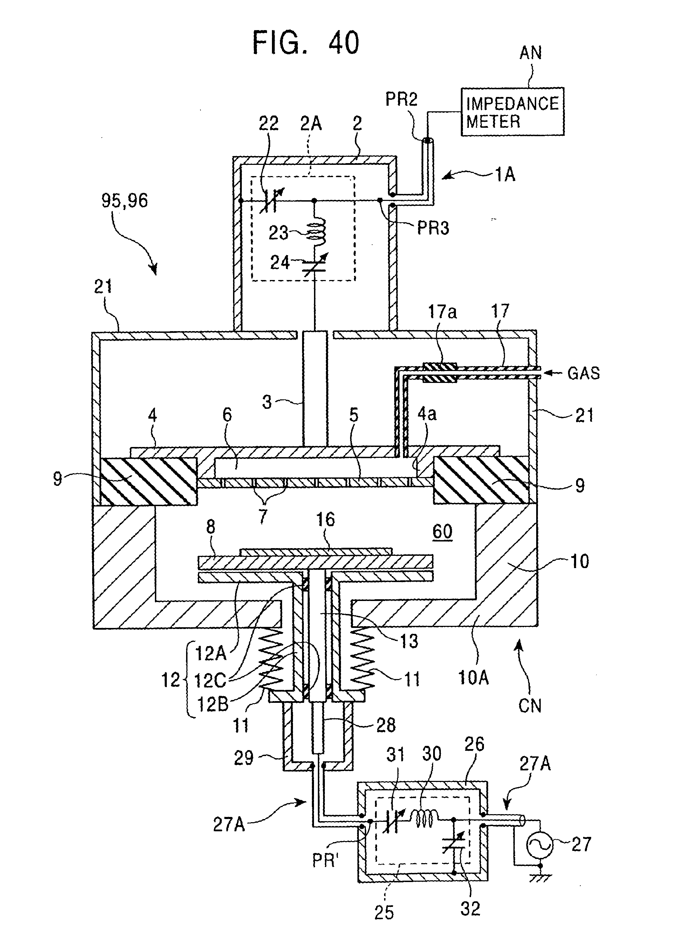

As shown in Fig. 40, the region for measuring the radiofrequency characteristics may be defined by the output terminal position PR2 of the radiofrequency generator 1. That is, the radiofrequency generator 1 is disconnected from the radiofrequency feed line 1A at the output terminal position PR2.

Alternatively, the region may be defined by the measuring point PR3 at the input terminal of the matching circuit 2A. That is, the radiofrequency generator 1 and the radiofrequency feed line 1A are disconnected from the matching circuit 2A at the measuring point PR3.

Another embodiment of the performance validation system of the plasma processing apparatus or the plasma processing system in accordance with the present invention will now be described with reference to the drawings.

The configuration of this system is the same as that shown in Fig. 20, and the method for using this system is the same as that described with reference to Figs. 21 to 24. Thus, the description thereof is omitted.

With reference to Fig. 23, a specifications page includes an apparatus section K6 for displaying a selected apparatus, a vacuum performance section K7, a gas supply and discharge performance section K8, a temperature performance section K9, and an electrical performance section K10 of the plasma processing chamber. These sections correspond to "standard performance information" of the plasma chamber of the selected apparatus.

The following items are described in these sections. In the vacuum performance section K7:

final degree of vacuum: $1 \times 10^{-4}$ Pa or less, and
operational pressure: 30 to 300 Pa.

In the gas supply and discharge performance section K8:
maximum gas flow rates:

$SiH_4$       100 SCCM,
$NH_3$       500 SCCM,
$N_2$     2,000 SCCM, and

discharge property: 20 Pa or less at a flow of 500 SCCM. In the temperature performance section K9:

heater temperature: 200 to 350 $\pm$ 10°C, and
chamber temperature: 60 to 80 $\pm$ 2.0°C.

Herein, SCCM (standard cubic centimeters per minute) represents a gas flow rate which is converted to standard conditions (0°C and 1013 hPa) and the unit thereof corresponds to $cm^3/min$.

For each parameter P, the variation between the maximum $P_{max}$ and the minimum $P_{min}$ in different plasma chambers of a plasma processing apparatus or a plasma processing system is defined by relationship (10B):

$$(P_{max} - P_{min})/(P_{max} + P_{min}) \qquad (10B)$$

This variation is displayed with a standard range (a maximum and a minimum) of each parameter of each plasma processing apparatus or plasma processing system.

The electrical performance section K10 of the plasma processing chamber includes the description of the first series resonant frequency $f_0$ described in the fourth to seventh embodiments and the relationship between this value and the power frequency $f_e$. This section K10 further includes the description of the resistance $R_e$ and the reactance $X_e$ at the power frequency $f_e$ of the plasma chamber, the plasma capacitance $C_0$ between the plasma excitation electrode 4 and the susceptor electrode 8, and the loss capacitance $C_X$ between the plasma excitation electrode 4 and each position lying at the grounded potential of the plasma chamber. The specifications page CP1 includes a description for certifying the performance, that is, "it is certified that these parameters were within the ranges described in this page when the plasma processing apparatus or the plasma processing system was supplied".

Thus, overall radiofrequency electrical characteristics of the plasma processing apparatus or the plasma processing system and variations in electrical characteristics of the plasma chambers can be provided as novel references when it is distributed. A customer's terminal C1 or an engineer's terminal C2 can print out the performance information to make a hard copy which can be used as a catalog or specifications including the performance information. The values of the first series resonant frequency $f_0$, the resistance $R_e$, the reactance $X_e$, and the capacitances $C_0$ and $C_X$, and the certification statements are displayed on the customer's terminal C1 or the engineer's terminal C2 are described in the catalog or specifications so that the customer can purchase from a maintenance engineer based on an estimation of the plasma chamber performance as if the customer had actually examined the electrical components.

With reference to Fig. 20, the server S is ready for waiting the display request for the next subpage (Step S3 in Fig. 21) until the log-off request from the customer's terminal C1 is received (Step S5) after such a subpage is transmitted to the customer's terminal C1, and completes the communication with the customer's terminal C1 when the log-off request is received from the customer's terminal C1.

The customer who purchases a plasma processing apparatus or plasma processing system from the maintenance engineer can access the sever S to browse the contents of the "performance information" of the purchased apparatus or system.

With reference to Fig. 24, when the customer and the maintenance engineer conclude an agreement of sale, the maintenance engineer provides a serial number of the plasma processing apparatus or plasma processing system, a customer ID which corresponds to the serial number, and a customer password (browsing password) which allow the customer to browse the "operation and maintenance information" of the plasma processing apparatus or plasma processing system and individual plasma chambers thereof.

With reference to Fig. 22, when the customer accesses the server, the customer operates a customer button K5 in the catalog page CP to submit the display request for the customer screen to the server S.

When receiving the display request (Step S3-B), the server S submits a subpage for prompting the customer's terminal C1 to input a "customer password" (Step S6). Fig. 24 shows a customer page CP2 including a customer ID input box K11 and a password input box K12.

The customer page CP2 for the input request is displayed on the display of the customer's terminal C1, and the customer's terminal C1 inputs a "customer password" and a "customer ID", which were provided, in order to identify the plasma processing apparatus or plasma processing system and the individual plasma chambers thereof.

As shown in Fig. 24, the customer inputs a customer ID and a password in the customer ID input box K11 and the password input box K12, respectively. When the server S receives the authorized "customer ID" and "customer password" from the customer's terminal C1 (Step S7), the server S transmits the "operation and maintenance information" subpage which relates to the customer password" to the customer's terminal C1 (Step S9).

That is, browsing of the "operation and maintenance information" is permitted by the authorized customer who concludes the agreement of sale on the plasma processing apparatus or plasma processing system and who knows the correct "password". Thus, no third party can obtain the "operation and maintenance information" by accessing the server S. In general, the maintenance engineer concludes agreements of sale with many customers and distributes a plurality of plasma processing apparatuses and plasma processing systems to these customers. A "customer password" is provided for each of the plasma processing apparatuses or plasma processing systems and the plasma chambers thereof to the corresponding customer. Thus, the customer can browse the "operation and maintenance information" which relates to the "customer password" and which corresponds to the purchased plasma processing apparatus or plasma processing system and the plasma chambers thereof.

This system can effectively prevent confidential information from leaking to other customers and can identify a plurality of plasma processing apparatuses or systems and the plasma chambers thereof which are purchased by the same customer. When the authorized "customer password" is not received (Step S7), the server S transmits a reject message to the customer's terminal C1 (Step S8), to prompt the customer to reinput a "customer password". When the customer inputs the authorized "customer password", the customer can browse the "operation and maintenance information".

When the ID and password are authorized (Step S7), the server retrieves a subpage which corresponds to the requested information from a database D and transmits the information to the customer. In detail, the server S retrieves data such as "vacuum performance", "gas supply and discharge performance", "temperature performance", and "electrical performance" from the database D based on the requests to display the "standard performance information" or the "operation and maintenance information" on the plasma processing apparatus or plasma processing system and the plasma chambers thereof which are identified by the customer ID, and transmits a specifications page including these data (Step S9).

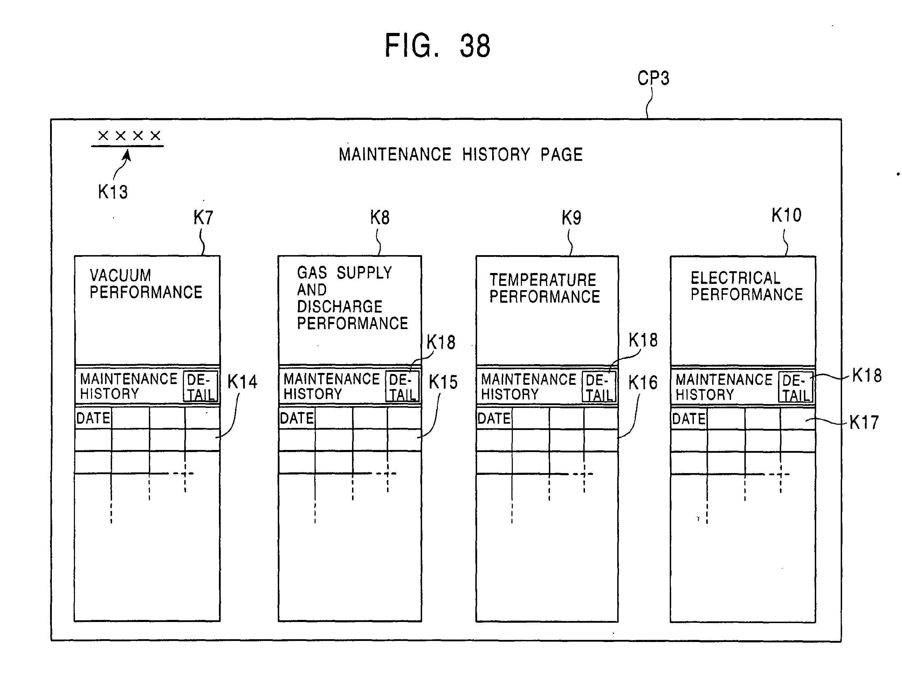

Fig. 38 shows an "operation and maintenance information" subpage CP3 which is transmitted to the customer's terminal C1 from the server S. The maintenance history page CP3 includes a serial number display section K13 for displaying the serial number of the purchased plasma processing apparatus or plasma processing system and the plasma chambers thereof, the vacuum performance section K7, the gas supply and discharge performance section K8, the temperature performance section K9, the electrical performance section K10 of the plasma processing chamber. These sections correspond to the "standard performance information", as shown in Fig. 23. The maintenance history page CP3 further includes a vacuum performance maintenance section K14, a gas supply and discharge performance section K15, a temperature performance section K16, and an electrical performance section K17 of the plasma processing chamber. These sections correspond to the "operation and maintenance information" of the purchased apparatus.

For example, the following items are described in the corresponding sections for the "operation and maintenance information". In the vacuum performance maintenance section K14:

final degree of vacuum: $1.3 \times 10^{-5}$ Pa or less, and
operational pressure: 200 Pa.

In the gas supply and discharge performance section K15:

gas flow rates:

| | |
|---|---|
| $SiH_4$ | 40 SCCM, |
| $NH_3$ | 160 SCCM, |
| $N_2$ | 600 SCCM, and |

discharge property: $6.8 \times 10^{-7}$ Pa·m$^3$/sec. In the temperature performance section K16:

heater temperature: $302.3 \pm 4.9°C$, and
chamber temperature: $80.1 \pm 2.1°C$.

For each parameter P, the variation between the maximum $P_{max}$ and the minimum $P_{min}$ in different plasma chambers of a plasma processing apparatus or a plasma processing system is defined by relationship (10B):

$$(P_{max} - P_{min})/(P_{max} + P_{min}) \qquad\qquad (10B)$$

This variation is displayed with a standard range (a maximum and a minimum) of each parameter of each plasma processing apparatus or plasma processing system.

A "detail" button K18 is provided in each title column for the corresponding sections K14, K15, K16, or K17 so that the customer can browse the corresponding detailed information.

When the customer submits a display request, a detailed maintenance page CP4 including detailed information on the maintenance history is transmitted from the database D to the customer's terminal C1.

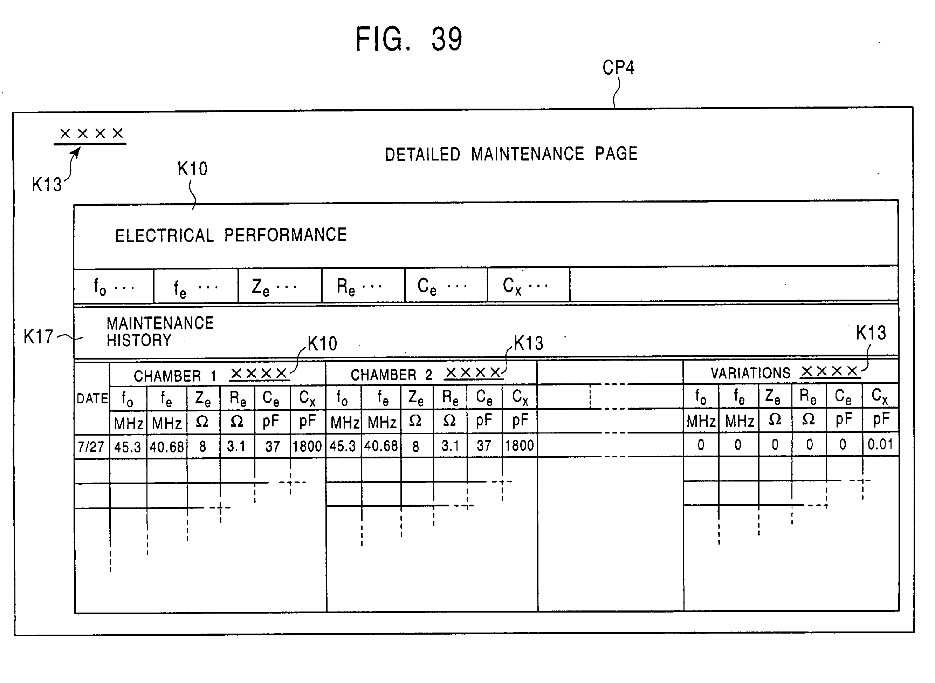

Fig. 39 shows the "detailed maintenance information" subpage submitted from the server S to the customer's terminal C1.

This "detailed maintenance information" subpage includes a serial number display section K13 for displaying the serial number of the purchased plasma processing apparatus or plasma processing system and the plasma chambers thereof, and the selected maintenance history columns. The selected maintenance history columns display values of parameters P in each plasma chamber, and variations of these parameters P at the maintenance date.

The electrical performance section K10 of the plasma processing chamber and the electrical performance section K17 of the plasma processing chamber include the value of the first series resonant frequency $f_0$ and the relationship between the value and the power frequency $f_e$, as described in the first to fourth embodiments. The section K10 and the section K17 also include the resistance $R_e$ and reactance $X_e$ of the plasma chamber at the power frequency $f_e$, the plasma capacitance $C_0$ between the plasma excitation electrode 4 and the susceptor electrode 8, the loss capacitance $C_X$ between the plasma excitation electrode 4 and the grounded potential portion of the plasma chamber, etc.

The server S simultaneously acquires "standard performance information" data such as "vacuum performance", "gas supply and exhaust performance", "temperature performance", and "electrical performance of plasma processing chamber" and provides the maintenance history page CP3 and the detailed maintenance page CP4 together with the "operation and maintenance information". The customer can thereby browse the "operation and maintenance information" with reference to the "standard performance information". Thus, the customer can confirm the "standard performance information" as a reference in use and can consult the "operation and maintenance information" as parameters showing an operational state, in the "performance information" of the purchased plasma processing apparatus or plasma processing system and the plasma chambers thereof. Also, by comparing the "standard performance information" with the "operation and maintenance information", the customer can check the operation of the plasma processing apparatus or plasma processing system and the plasma chambers thereof, can determine when maintenance is necessary, and can determine the plasma processing state.

If the server S does not receive the log-off request from the customer's terminal C1 after transmission of the subpages C3 and C4 to the customer's terminal C1 (Step S5), the server S transmits an invalid connection massage to the customer's terminal C1 (Step S8) to prompt reentry of the "customer password" or to wait for the next display request (Step S3). If the server S receives the log-off request from the customer's terminal C1 (Step S5), the communication with the customer's terminal C1 is completed.

The performance validation system according to this embodiment includes at least one client terminal and performance information providing means for providing performance information to the client terminal, wherein the performance information comprises standard operation information regarding general information of the plasma processing apparatus and operation and maintenance information regarding specific information of the plasma processing apparatus, wherein the client terminal has at least one function of requesting the display of performance information and uploading the operation and maintenance information to the performance information providing means. Preferably, the standard performance information and the operation and maintenance information comprise information regarding a first series resonant frequency $f_0$. Preferably, the standard performance information is used as a catalog or a specification document. Thus, the customer can browse the performance information including the standard performance information and the uploaded operation and maintenance information of the plasma processing apparatus or system and the plasma processing chambers thereof. The customer can obtain standard information when the apparatus or system is installed and the operation and maintenance information when the apparatus or system and the plasma processing chambers are used.

When the performance information includes the first series resonant frequencies $f_0$ and variations thereof as performance parameters of the plasma processing chambers, the customer can determine the performance of the plasma processing apparatus or plasma processing system and the plasma processing chambers thereof before deciding the customer to purchase the apparatus or system. Moreover, the performance information can be output as catalogs and specifications.

EXAMPLES

In these examples, the variation of the first series resonant frequencies $f_0$ of a plurality of plasma chambers was set to be a predetermined value and changes in properties of deposited films were measured.

The plasma processing apparatus used had two plasma chambers, as shown in the fifth embodiment, and these plasma chambers were of a dual-frequency excitation type.

In the plasma processing apparatus, the parallel plate electrodes 4 and 8 were 25 cm squared, the interelectrode distance was 15 mm, the electrical power was 800 W, and the first series resonant frequency $f_0$ was 40.68 MHz.

EXAMPLE 5

The variation defined by the maximum frequency $f_{0max}$ and the minimum frequency $f_{0min}$ of the first series resonant frequencies $f_0$ of this plasma processing apparatus was set to be 0.09 according to relationship (10), and the average of the first series resonant frequencies $f_0$ was set to be 43 MHz.

EXAMPLE 6

The variation defined by the maximum frequency $f_{0max}$ and the minimum frequency $f_{0min}$ of the first series resonant frequencies $f_0$ of this plasma processing apparatus was set to be 0.02 according to relationship (10), and the average of the first series resonant frequencies $f_0$ was set to be 43 MHz.

COMPARATIVE EXAMPLE 2

The variation defined by the maximum frequency $f_{0max}$ and the minimum frequency $f_{0min}$ of the first series resonant frequencies $f_0$ of this plasma processing apparatus was set to be 0.11 according to relationship (10), and the average of the first series resonant frequencies $f_0$ was set to be 43 MHz.

In each of EXAMPLES 5 and 6 and COMPARATIVE EXAMPLE 2, silicon nitride film was deposited according to the following identical process recipe to measure the variation in the film thicknesses:

(1) Depositing a $SiN_x$ film on a 6-inch glass substrate by plasma enhanced CVD;
(2) Patterning a resist film by photolithography;
(3) Dry-etching the $SiN_x$ film with $SF_6$ and $O_2$;
(4) Removing the resist film by $O_2$ ashing;
(5) Measuring the roughness of the $SiN_x$ film using a contact displacement meter;
(6) Calculating the deposition rate using the deposition time and the film thickness; and
(7) Measuring the in-plane uniformity of the film at 16 points on the substrate.

The deposition conditions were as follows:

| | |
|---|---|
| Substrate temperature: | 350°C |
| $SiH_4$ flow rate: | 40 SCCM |
| $NH_3$ flow rate: | 200 SCCM |
| $N_2$ flow rate: | 600 SCCM |

(continued)

Deposition rate: about 200 nm/min

The results are shown in Table 3.

Table 3

| | | Deposition Rate (nm/min) | Variation in Deposition Rate (%) | In-plane Uniformity (%) | Variation of $f_0$* |
|---|---|---|---|---|---|
| COMPARATIVE EXAMPLE 1 | Chamber 1 | 181 | 8.6 | 4.6 | 0.11 |
| | Chamber 2 | 215 | | 6.2 | |
| EXAMPLE 5 | Chamber 1 | 195 | 4.9 | 4.6 | 0.09 |
| | Chamber 2 | 215 | | 5.7 | |
| EXAMPLE 6 | Chamber 1 | 207 | 1.9 | 4.6 | 0.02 |
| | Chamber 2 | 215 | | 5.4 | |
| * $f_0$: first series resonant frequencies | | | | | |

The results shown in Table 3 demonstrate that the difference in the film thickness between the plasma chambers is reduced when the variation of the first series resonant frequencies $f_0$ is set to be in the range specified according to the present invention. In other words, the operational characteristics of the plasma chambers are improved by such specific variation of the first series resonant frequencies $f_0$.

**Claims**

1. A plasma processing apparatus comprising a plurality of plasma processing chamber units,
   each plasma processing chamber unit comprising:

   a plasma processing chamber having a plasma excitation electrode for exciting a plasma;
   a radiofrequency generator for supplying a radiofrequency voltage to the plasma excitation electrode;
   a radiofrequency feeder connected to the plasma excitation electrode; and
   a matching circuit having an input terminal and an output terminal, wherein the input terminal is connected to the radiofrequency generator and the output terminal is connected to the radiofrequency feeder so as to achieve impedance matching between the plasma processing chamber and the radiofrequency generator,

   wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is at the end of the corresponding radiofrequency feeder connected to the output terminal of the corresponding matching circuit.

2. A plasma processing apparatus comprising a plurality of plasma processing chamber units,
   each plasma processing chamber unit comprising:

   a plasma processing chamber having a plasma excitation electrode for exciting a plasma;
   a radiofrequency generator for supplying a radiofrequency voltage to the plasma excitation electrode;
   a radiofrequency feeder connected to the plasma excitation electrode; and
   a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator,

   wherein a variation, defined by $(A_{max} - A_{min})/(A_{max} + A_{min})$, between the maximum frequency $A_{max}$ and the minimum

frequency $A_{min}$ among radiofrequency characteristics A of the plurality of plasma processing chambers has a predetermined value, wherein, in each plasma processing chamber unit, the radiofrequency characteristics A thereof is measured at a measuring point which is the radiofrequency-generator-side end of the radiofrequency feed line connected to the respective radiofrequency generator.

3. A plasma processing apparatus comprising a plurality of plasma processing chamber units,
each plasma processing chamber unit comprising:

a plasma processing chamber having a plasma excitation electrode for exciting a plasma;
a radiofrequency generator for supplying a radiofrequency voltage to the plasma excitation electrode;
a radiofrequency feeder connected to the plasma excitation electrode; and
a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator,

wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber unit, the radiofrequency characteristic A thereof is measured at a measuring point which is the input terminal connected to the corresponding radiofrequency feed line.

4. A plasma processing apparatus according to Claim 1, 2 or 3, wherein the predetermined value is less than 0.1.

5. A plasma processing apparatus according to Claim 1, 2 or 3, wherein each radiofrequency characteristics A is any one of a resonant frequency f, an impedance $Z_e$ at the frequency of the radiofrequency generator, a resistance $R_e$ at the frequency of the radiofrequency generator, and a reactance $X_e$ at the frequency of the radiofrequency generator.

6. A plasma processing apparatus according to Claim 1, 2 or 3, wherein each radiofrequency characteristic A is a first series resonant frequency $f_0$.

7. A plasma processing apparatus according to Claim 1, wherein three times the first series resonant frequency $f_0$ corresponding to each plasma processing chamber is larger than the frequency $f_e$ of the radiofrequency waves.

8. A plasma processing apparatus according to Claim 1, 2 or 3, wherein each plasma processing chamber has a measuring terminal for measuring the radiofrequency characteristics A thereof at the corresponding measuring point.

9. A plasma processing apparatus according to Claim 8, wherein each plasma processing chamber has a switch in the vicinity of the corresponding measuring point in which the switch electrically disconnects the measuring point from the measuring terminal and connects the radiofrequency feeder to the radiofrequency generator in a plasma excitation mode in which the plasma is excited, whereas the switch electrically connects the measuring point to the measuring terminal and disconnects the radiofrequency generator from the measuring point in a measuring mode in which the radiofrequency characteristic A of the corresponding plasma processing chamber is measured.

10. A plasma processing system comprising a plurality of plasma processing apparatuses,
each plasma processing apparatus comprising:

a plasma processing chamber having a plasma excitation electrode for exciting a plasma;
a radiofrequency generator for supplying a radiofrequency voltage to the plasma excitation electrode;
a radiofrequency feeder connected to the plasma excitation electrode; and
a matching circuit having an input terminal and an output terminal, wherein the input terminal is connected to the radiofrequency generator and the output terminal is connected to the radiofrequency feeder so as to achieve impedance matching between the plasma processing chamber and the radiofrequency generator,

wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristic A thereof is measured at a measuring point which is at the end of the corresponding radiofrequency feeder connected to the output terminal of the corresponding matching circuit.

11. A plasma processing system comprising a plurality of plasma processing apparatuses, each plasma processing apparatus comprising:

> a plasma processing chamber having a plasma excitation electrode for exciting a plasma;
> a radiofrequency generator for supplying a radiofrequency voltage to the plasma excitation electrode;
> a radiofrequency feeder connected to the plasma excitation electrode; and
> a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator,

> wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristics A thereof is measured at a measuring point which is the radiofrequency-generator-side end of the radiofrequency feed line connected to the respective radiofrequency generator.

12. A plasma processing system comprising a plurality of plasma processing apparatuses, each plasma processing apparatus comprising:

> a plasma processing chamber having a plasma excitation electrode for exciting a plasma;
> a radiofrequency generator for supplying a radiofrequency voltage to the plasma excitation electrode;
> a radiofrequency feeder connected to the plasma excitation electrode; and
> a matching circuit having an input terminal and an output terminal, wherein the input terminal is connected to the radiofrequency generator via a radiofrequency feed line, whereas the output terminal is connected to the radiofrequency feeder so as to achieve impedance matching between the plasma processing chamber and the radiofrequency generator,

> wherein a variation, defined by $(A_{max} - A_{min})/(A_{max} + A_{min})$, between the maximum frequency $A_{max}$ and the minimum frequency $A_{min}$ among radiofrequency characteristics A of the plurality of plasma processing chambers has a predetermined value, wherein, in each plasma processing chamber, the radiofrequency characteristic A thereof is measured at a measuring point which is the input terminal connected to the corresponding radiofrequency feed line.

13. A plasma processing system according to Claim 10, 11 or 12, wherein the predetermined value is less than 0.1.

14. A plasma processing system according to Claim 10, 11 or 12, wherein each radiofrequency characteristics A is any one of a resonant frequency f, an impedance $Z_e$ at the frequency of the radiofrequency generator, a resistance $R_e$ at the frequency of the radiofrequency generator, and a reactance $X_e$ at the frequency of the radiofrequency generator.

15. A plasma processing system according to Claim 10, 11 or 12, wherein each radiofrequency characteristic A is a first series resonant frequency $f_0$.

16. A plasma processing system according to Claim 10, wherein three times the first series resonant frequency $f_0$ corresponding to each plasma processing chamber is larger than the frequency $f_e$ of the radiofrequency waves.

17. A plasma processing system according to Claim 11, 12 or 13, wherein each plasma processing chamber has a measuring terminal for measuring the radiofrequency characteristic A thereof at the corresponding measuring point.

18. A plasma processing system according to Claim 16 or 17, wherein each plasma processing chamber has a switch in the vicinity of the corresponding measuring point in which the switch electrically disconnects the measuring point from the measuring terminal and connects the radiofrequency feeder to the radiofrequency generator in a plasma excitation mode in which the plasma is excited, whereas the switch electrically connects the measuring point to the measuring terminal and disconnects the radiofrequency generator from the measuring point in a measuring mode in which the radiofrequency characteristic A of the corresponding plasma processing chamber is measured.

19. A performance validation system for a plasma processing apparatus according to Claim 1, 2 or 3, the system comprising:

at least one client terminal; and
performance information providing means for providing performance information to said at least one client terminal,

wherein the performance information comprises standard operation information regarding general information of the plasma processing apparatus and operation and maintenance information regarding specific information of the plasma processing apparatus,
wherein said at least one client terminal has at least one function of requesting the display of performance information and uploading the operation and maintenance information to the performance information providing means.

20. A performance validation system according to Claim 19, wherein the performance information includes the variation of the radiofrequency characteristics A.

21. A performance validation system for a plasma processing system according to Claim 10, 11 or 12, the system comprising:

at least one client terminal; and
performance information providing means for providing performance information to said at least one client terminal,

wherein the performance information comprises standard operation information regarding general information of the plasma processing apparatus and operation and maintenance information regarding specific information of the plasma processing apparatus,
wherein said at least one client terminal has at least one function of requesting the display of performance information and uploading the operation and maintenance information to the performance information providing means.

22. A performance validation system according to Claim 21, wherein the performance information includes the variation of the radiofrequency characteristics A.

# FIG. 1

# FIG. 2

# FIG. 3

# FIG. 4

# FIG. 5

# FIG. 6

# FIG. 7

# FIG. 8

# FIG. 9

# FIG. 10

$1.3f_0 > f_e$

FREQUENCY f (MHz)

# FIG. 11

# FIG. 12

# FIG. 13

$f_o > 3f_e$

# FIG. 14

$\delta_a + \delta_b = \delta$

# FIG. 15

# FIG. 16

EP 1 720 197 A1

# FIG. 17

# FIG. 18

# FIG. 19

# FIG. 20

EP 1 720 197 A1

# FIG. 21

START

S1 DISPLAY REQUEST RECEIVED? — NO

YES

S2 TRANSMITTING CATALOG PAGE

S3 DISPLAY REQUEST RECEIVED? — B

A

B → S6 PROMPTING INPUTTING CUSTOMER ID AND PASSWORD

S7 ID AND PASSWORD AUTHORIZED? — NO → S8 TRANSMITTING REJECT MESSAGE

YES

S4 TRANSMITTING SPECIFICATIONS PAGE

S9 TRANSMITTING OPERATION AND MAINTENANCE INFORMATION

S5 LOG-OFF REQUEST RECEIVED? — NO / NO

YES

END

70

# FIG. 22

EP 1 720 197 A1

CP

CATALOG PAGE

TO CUSTOMER PAGE

K5

K1
APPARATUS 1

K2
APPARATUS 2

K3
APPARATUS 3

K4

# FIG. 23

EP 1 720 197 A1

CP1

SPECIFICATIONS PAGE

×××× 
K6

| K7 | K8 | K9 | K10 |
|---|---|---|---|
| VACUUM PERFORMANCE | GAS SUPPLY AND DISCHARGE PERFORMANCE | TEMPERATURE PERFORMANCE | ELECTRICAL PERFORMANCE |

# FIG. 24

EP 1 720 197 A1

FIG. 25

CP3

MAINTENANCE HISTORY PAGE

× × × × 

K13

K7

**VACUUM PERFORMANCE**

MAINTENANCE HISTORY

| DATE | | | |
|------|--|--|--|
| | | | |
| | | | |

K14

K8

**GAS SUPPLY AND DISCHARGE PERFORMANCE**

MAINTENANCE HISTORY

| DATE | | | |
|------|--|--|--|
| | | | |
| | | | |

K15

K8

**TEMPERATURE PERFORMANCE**

MAINTENANCE HISTORY

| DATE | | | |
|------|--|--|--|
| | | | |

K16

K10

**ELECTRICAL PERFORMANCE**

| $f_o$ .... | $C_e$ .... |
|-----------|-----------|
| $f_e$ .... | $C_x$ .... |
| $Z_e$ .... | |
| $R_e$ .... | |

MAINTENANCE HISTORY

| DATE | $f_o$ | $f_e$ | $Z_e$ | $R_e$ | $C_e$ | $C_x$ |
|------|-------|-------|-------|-------|-------|-------|
| 7/27 | 45.3 | 40.66 | 8 | 3.1 | 37 | 1800 |

K17

EP 1 720 197 A1

# FIG. 26

71,71'

78

LASER
ANNEALING
CHAMBER

72

76

SECOND
DEPOSITION
CHAMBER

FIRST
DEPOSISTION
CHAMBER

75

88

THIRD
DEPOSITION
CHAMBER

87

ANNEALING
CHAMBER

77

TRANSFER
CHAMBER

79

LOADING
CHAMBER

UNLOADING
CHAMBER

73

74

# FIG. 27

LASER LIGHT SOURCE

# FIG. 28

# FIG. 29

# FIG. 30

# FIG. 31

EP 1 720 197 A1

## FIG. 32

## FIG. 33

# FIG. 34

# FIG. 35

# FIG. 36

# FIG. 37

# FIG. 38

CP3

MAINTENANCE HISTORY PAGE

× × × ×

K13

| K7 | K8 | K9 | K10 |

**VACUUM PERFORMANCE** — K7

**GAS SUPPLY AND DISCHARGE PERFORMANCE** — K8

**TEMPERATURE PERFORMANCE** — K9

**ELECTRICAL PERFORMANCE** — K10

| MAINTENANCE HISTORY | DE-TAIL | — K14 (K18) |
| MAINTENANCE HISTORY | DE-TAIL | — K15 (K18) |
| MAINTENANCE HISTORY | DE-TAIL | — K16 (K18) |
| MAINTENANCE HISTORY | DE-TAIL | — K18, K17 |

DATE ... DATE ... DATE ... DATE

EP 1 720 197 A1

# FIG. 39

EP 1 720 197 A1

CP4

×××× (K13)

DETAILED MAINTENANCE PAGE

**ELECTRICAL PERFORMANCE** (K10)

| $f_o$ ⋯ | $f_e$ ⋯ | $Z_e$ ⋯ | $R_e$ ⋯ | $C_e$ ⋯ | $C_x$ ⋯ | |
|---|---|---|---|---|---|---|

MAINTENANCE HISTORY (K17)

| DATE | CHAMBER 1 ×××× (K10) | | | | | | CHAMBER 2 ×××× (K13) | | | | | | | | VARIATIONS ×××× (K13) | | | | | |
|---|---|---|---|---|---|---|---|---|---|---|---|---|---|---|---|---|---|---|---|---|
| | $f_o$ | $f_e$ | $Z_e$ | $R_e$ | $C_e$ | $C_x$ | $f_o$ | $f_e$ | $Z_e$ | $R_e$ | $C_e$ | $C_x$ | | | $f_o$ | $f_e$ | $Z_e$ | $R_e$ | $C_e$ | $C_x$ |
| | MHz | MHz | Ω | Ω | pF | pF | MHz | MHz | Ω | Ω | pF | pF | | | MHz | MHz | Ω | Ω | pF | pF |
| 7/27 | 45.3 | 40.68 | 8 | 3.1 | 37 | 1800 | 45.3 | 40.68 | 8 | 3.1 | 37 | 1800 | | | 0 | 0 | 0 | 0 | 0 | 0.01 |

# FIG. 40

# FIG. 41

**European Patent Office**

**EUROPEAN SEARCH REPORT**

Application Number

EP 06 01 6997

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PATENT ABSTRACTS OF JAPAN vol. 2000, no. 08, 6 October 2000 (2000-10-06) & JP 2000 150389 A (FURONTEKKU:KK), 30 May 2000 (2000-05-30) | 1-3, 10-12 | INV. H01J37/32 C23C16/509 C23C16/52 |
| Y | * abstract; figures 1,2 * ----- | 5,8,14, 19-21 | |
| Y | US 6 051 284 A (BYRNE ET AL) 18 April 2000 (2000-04-18) * column 3, line 40 - column 4, line 35; figure 1 * * column 5, line 44 - column 6, line 17; figures 4,5 * ----- | 5,8,14, 19-21 | |
| A | PATENT ABSTRACTS OF JAPAN vol. 1999, no. 08, 30 June 1999 (1999-06-30) & JP 11 083907 A (MITSUBISHI ELECTRIC CORP; RYODEN SEMICONDUCTOR SYST ENG KK), 26 March 1999 (1999-03-26) * abstract * & US 6 333 634 B1 (HAZE KENJI ET AL) 25 December 2001 (2001-12-25) * column 4, line 13 - line 64 * * column 7, line 44 - line 53 * * column 10, line 47 - column 11, line 10; figures * ----- | 1-21 | TECHNICAL FIELDS SEARCHED (IPC) H01J C23C |
| A | US 5 874 704 A (GATES DUANE CHARLES) 23 February 1999 (1999-02-23) * abstract; figures * ----- | 1-21 | |

The present search report has been drawn up for all claims

| Place of search | Date of completion of the search | Examiner |
|---|---|---|
| The Hague | 14 September 2006 | Hofmann, Kerrin |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

European Patent

Office

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

| | | |
|---|---|---|
| **European Patent**<br>**Office** | **LACK OF UNITY OF INVENTION**<br>**SHEET B** | Application Number<br>EP 06 01 6997 |

The Search Division considers that the present European patent application does not comply with the requirements of unity of invention and relates to several inventions or groups of inventions, namely:

1. claims: 1-12

    RF plasma processor comprising a matching network with an RF power frequency fe at input and a frequency 3*f0 ( f0 being the reactor's resonance frequency) at output of said matching network
    ---

2. claims: 13-62

    Performance evaluation for a plasma processing system comprising plurality of chambers by comparing the variation in frequency among the plurality of chambers
    ---

## ANNEX TO THE EUROPEAN SEARCH REPORT
## ON EUROPEAN PATENT APPLICATION NO.

EP 06 01 6997

This annex lists the patent family members relating to the patent documents cited in the above-mentioned European search report.
The members are as contained in the European Patent Office EDP file on
The European Patent Office is in no way liable for these particulars which are merely given for the purpose of information.

14-09-2006

| Patent document cited in search report | | | Publication date | Patent family member(s) | | | Publication date |
|---|---|---|---|---|---|---|---|
| JP 2000150389 | A | | 30-05-2000 | NONE | | | |
| US 6051284 | A | | 18-04-2000 | NONE | | | |
| JP 11083907 | A | | 26-03-1999 | US | 6333634 | B1 | 25-12-2001 |
| US 6333634 | B1 | | 25-12-2001 | JP | 11083907 | A | 26-03-1999 |
| US 5874704 | A | | 23-02-1999 | AT | 213869 | T | 15-03-2002 |
| | | | | AU | 6289296 | A | 05-02-1997 |
| | | | | CN | 1189240 | A | 29-07-1998 |
| | | | | DE | 69619525 | D1 | 04-04-2002 |
| | | | | DE | 69619525 | T2 | 08-08-2002 |
| | | | | EP | 0835518 | A1 | 15-04-1998 |
| | | | | JP | 11509031 | T | 03-08-1999 |
| | | | | US | 6184488 | B1 | 06-02-2001 |
| | | | | WO | 9702588 | A1 | 23-01-1997 |

EPO FORM P0459

For more details about this annex : see Official Journal of the European Patent Office, No. 12/82